# EUROPEAN PATENT APPLICATION

(11) **EP 4 808 324 A1**
(43) Date of publication of application: **16.09.2026**
(21) Application number: 24953517.0
(22) Date of filing: 25.09.2024
(51) Int. Cl.: H10K 59/131

(54) **DISPLAY PANEL AND DISPLAY DEVICE**

(30) Priority: 09.09.2024 CN 202411258996
(71) Applicant: Wuhan Tianma Microelectronics Co., Ltd., Wuhan, Hubei 430205 (CN)
(72) Inventor: DAI, Hao, Wuhan, Hubei 430205 (CN); ZHANG, Dian, Wuhan, Hubei 430205 (CN); LIN, Yuancheng, Wuhan, Hubei 430205 (CN); MA, Yangzhao, Wuhan, Hubei 430205 (CN); DUN, Dongliang, Wuhan, Hubei 430205 (CN); HUA, Huomei, Wuhan, Hubei 430205 (CN); WU, Huangyao, Wuhan, Hubei 430205 (CN)
(74) Representative: Boult Wade Tennant LLP
(86) International application number: PCT/CN2024/120950
(87) International publication number: WO 2026/051132

(57) **Abstract**

The present application discloses a display panel and a display device. The display panel comprises: first light-emitting elements, second light-emitting elements, and third light-emitting elements that emit light of different colors; each first unit column comprises first light-emitting elements and second light-emitting elements that are alternately arranged in a first direction, each second unit column comprises a plurality of third light-emitting elements that are arranged in the first direction, and the first unit columns and the second unit columns are alternately arranged in a second direction; each first circuit column comprises a plurality of first pixel circuits arranged in the first direction, each second circuit column comprises a plurality of second pixel circuits arranged in the first direction, and each third circuit column comprises a plurality of third pixel circuits arranged in the first direction, the first pixel circuits are electrically connected to a first data line and the first light-emitting elements, the second pixel circuits are electrically connected to a second data line and the second light-emitting elements, and the third pixel circuits are electrically connected to a third data line and the third light-emitting elements. The embodiments of the present application can reduce power consumption of a driving chip.

## Description

### CROSS REFERENCE TO RELATED APPLICATION

The present application claims priority to Chinese Patent Application No. 202411258996.6, entitled "DISPLAY PANEL AND DISPLAY APPARATUS" filed on September 9, 2024, which is incorporated herein by reference in its entirety.

### TECHNICAL FIELD

The present application relates to the field of display technology, specifically to a display panel and a display apparatus.

### BACKGROUND

With the development of display technology, the application of display panels is increasingly common, and users' requirements for the performance of display panels are also increasing. For example, users desire that the power consumption of display products can be increasingly low. Therefore, how to reduce the power consumption is an important issue that puzzles technical personnel in the art.

### SUMMARY

Embodiments of the present application provide a display panel and display apparatus, which can reduce power consumption.

In a first aspect, embodiments of the present application provide a display panel, including: light-emission elements including first light-emission elements, second light-emission elements, and third light-emission elements, wherein the first light-emission elements, the second light-emission elements, and the third light-emission elements have different light-emission colors, a first unit column includes the first light-emission elements and the second light-emission elements alternately arranged in a first direction, a second unit column includes a plurality of the third light-emission elements arranged in the first direction, the first unit column and the second unit column are alternately arranged in a second direction, and the first direction intersects the second direction; and first circuit columns, second circuit columns, and third circuit columns, wherein each of the first circuit columns includes a plurality of first pixel circuits arranged in the first direction, each of the second circuit columns includes a plurality of second pixel circuits arranged in the first direction, each of the third circuit columns includes a plurality of third pixel circuits arranged in the first direction, each of the first pixel circuits is electrically connected to a first data line and the first light-emission element, each of the second pixel circuits is electrically connected to a second data line and the second light-emission element, and each of the third pixel circuits is electrically connected to a third data line and the third light-emission element.

In a second aspect, embodiments of the present application provide a display apparatus, including the display panel as described in embodiments of the first aspect.

### BRIEF DESCRIPTION OF THE DRAWINGS

Other features, objectives, and advantages of the present invention will become more apparent by reading the following detailed descriptions of non-restrictive embodiments with reference to the accompanying drawings, where the same or similar reference numerals indicate the same or similar features, and the accompanying drawings are not drawn to actual scale.
Fig. 1 shows a schematic structural view of a display panel in a comparative example;
Fig. 2 shows a schematic view of a signal time series on a data line in Fig. 1;
Fig. 3 shows a schematic structural view of a display panel provided in an embodiment of the present application;
Fig. 4 shows another schematic structural view of a display panel provided in an embodiment of the present application;
Fig. 5 shows another schematic structural view of a display panel provided in an embodiment of the present application;
Fig. 6 shows a schematic view of a layout structure of the display panel corresponding to Fig. 3;
Fig. 7 shows a schematic view of a layout structure of an anode, a second metal layer, and a third metal layer in Fig. 6;
Fig. 8 shows a schematic view of a layout structure of the anode in Fig. 6;
Fig. 9 shows a schematic view of a layout structure of the third metal layer in Fig. 6;
Fig. 10 shows a schematic view of a layout structure of the second metal layer in Fig. 6;
Fig. 11 shows a schematic view of a layout structure of the first metal layer in Fig. 6;
Fig. 12 shows a schematic view of a layout structure of a second gate layer corresponding to Fig. 6;
Fig. 13 shows a schematic view of a layout structure of a second semiconductor layer corresponding to Fig. 6;
Fig. 14 shows a schematic view of a layout structure of a capacitor metal layer corresponding to Fig. 6;
Fig. 15 shows a schematic view of a layout structure of a first gate layer corresponding to Fig. 6;
Fig. 16 shows a schematic view of a layout structure of a first semiconductor layer corresponding to Fig. 6;
Fig. 17 shows a schematic view of a layout structure of an auxiliary metal layer corresponding to Fig. 6;
Fig. 18 shows a schematic view of a cross-sectional structure of the display panel provided in an embodiment of the present application;
Fig. 19 shows a schematic structural view of a pixel circuit in the display panel provided in an embodiment of the present application;
Fig. 20 shows another schematic view of a layout structure of the display panel corresponding to Fig. 3;
Fig. 21 shows a schematic view of a layout structure of an anode, a second metal layer, and a third metal layer in Fig. 20;
Fig. 22 shows a schematic view of a layout structure of the anode in Fig. 20;
Fig. 23 shows a schematic view of a layout structure of the third metal layer in Fig. 20;
Fig. 24 shows a schematic view of a layout structure of the second metal layer in Fig. 20;
Fig. 25 shows a schematic view of a layout structure of a first metal layer corresponding to Fig. 20;
Fig. 26 shows a schematic view of a layout structure of a capacitor metal layer corresponding to Fig. 20;
Fig. 27 shows a schematic view of a layout structure of a first gate layer corresponding to Fig. 20;
Fig. 28 shows a schematic view of a layout structure of a first semiconductor layer corresponding to Fig. 20;
Fig. 29 shows another schematic view of a cross-sectional structure of the display panel provided in an embodiment of the present application;
Fig. 30 shows another schematic view of a pixel circuit in the display panel provided in an embodiment of the present application;
Fig. 31 shows another schematic view of a layout structure of the display panel corresponding to Fig. 3;
Fig. 32 shows a schematic view of a layout structure of an anode, a second metal layer, and a third metal layer in Fig. 31;
Fig. 33 shows a schematic view of a layout structure of the anode in Fig. 31;
Fig. 34 shows a schematic view of a layout structure of the third metal layer in Fig. 31;
Fig. 35 shows a schematic view of a layout structure of the second metal layer in Fig. 31;
Fig. 36 shows a schematic view of a layout structure of an anode of the display panel corresponding to Fig. 4;
Fig. 37 shows a schematic view of a layout structure of the display panel corresponding to Fig. 5;
Fig. 38 shows a schematic view of a layout structure of the anode in Fig. 37;
Fig. 39 shows a schematic view of a layout structure of the third metal layer in Fig. 37;
Fig. 40 shows a schematic view of a layout structure of the second metal layer in Fig. 37;
Fig. 41 shows another schematic view of a layout structure of the display panel corresponding to Fig. 5;
Fig. 42 shows a schematic view of a layout structure of an anode, a second metal layer, and a third metal layer in Fig. 41;
Fig. 43 shows a schematic view of a layout structure of the anode in Fig. 41;
Fig. 44 shows a schematic view of a layout structure of the third metal layer in Fig. 41;
Fig. 45 shows a schematic view of a layout structure of the second metal layer in Fig. 41;
Fig. 46 shows a schematic view of a layout structure of the display panel corresponding to Fig. 5;
Fig. 47 shows a schematic view of a layout structure of the anode in Fig. 46;
Fig. 48 shows a schematic view of a layout structure of the third metal layer in Fig. 46;
Fig. 49 shows a schematic view of a layout structure of the second metal layer in Fig. 46;
Fig. 50 shows a schematic view of a layout structure of the display panel corresponding to Fig. 5;
Fig. 51 shows a schematic view of a layout structure of the anode in Fig. 50;
Fig. 52 shows a schematic view of a layout structure of the third metal layer in Fig. 50;
Fig. 53 shows a schematic view of a layout structure of the second metal layer in Fig. 50;
Fig. 54 shows a schematic view of a layout structure of the display panel corresponding to Fig. 5;
Fig. 55 shows a schematic view of a layout structure of the anode in Fig. 54;
Fig. 56 shows a schematic view of a layout structure of the third metal layer in Fig. 54;
Fig. 57 shows a schematic view of a layout structure of the second metal layer in Fig. 54;
Fig. 58 shows another schematic structural view of a display panel provided in an embodiment of the present application;
Fig. 59 shows a schematic view of a layout structure of the display panel corresponding to Fig. 58;
Fig. 60 shows a schematic view of a layout structure of an anode and a first metal layer in Fig. 59;
Fig. 61 shows a schematic view of a layout structure of the anode in Fig. 59;
Fig. 62 shows a schematic view of a layout structure of the first metal layer in Fig. 59;
Fig. 63 shows a schematic view of a layout structure of a capacitor metal layer in Fig. 59;
Fig. 64 shows a schematic view of a layout structure of a first gate layer in Fig. 59;
Fig. 65 shows a schematic view of a layout structure of a first semiconductor layer in Fig. 59;
Fig. 66 shows a schematic view of a layout structure of the first semiconductor layer, the first gate layer, and the capacitor metal layer in Fig. 59;
Fig. 67 shows a schematic view of a layout structure of an auxiliary metal layer in Fig. 59;
Fig. 68 shows still another schematic view of a cross-sectional structure of the display panel provided in an embodiment of the present application;
Fig. 69 shows still another schematic structural view of a pixel circuit in the display panel provided in an embodiment of the present application;
Fig. 70 shows still another schematic structural view of a display panel provided in an embodiment of the present application;
Fig. 71 shows still another schematic structural view of a display panel provided in an embodiment of the present application;
Fig. 72 shows a schematic structural view of power branch lines in Fig. 71; and
Fig. 73 shows a schematic structural view of a display apparatus provided in an embodiment of the present application.

### DETAILED DESCRIPTION

Features and exemplary embodiments of various aspects of the present application will be described in detail below. In order to make the objectives, technical solutions, and advantages of the present application clearer, the present application will be further described in detail below with reference to the accompanying drawings and specific embodiments. It should be understood that the specific embodiments described herein are only configured to explain the present application, but not configured to limit the present application. For those skilled in the art, the present application can be implemented without some of these specific details. The following descriptions of the embodiments are merely for providing a better understanding of the present invention by showing examples of the present invention.

It should be noted that the relational terms herein, such as first and second, are merely used for distinguishing one entity or operation from another, and do not necessarily require or imply that any actual relationship or sequence exists between these entities or operations. Moreover, the terms "include", "comprise", and any variants thereof are intended to cover a non-exclusive inclusion, such that a process, method, article, or device including a series of elements not only includes those elements, but further includes other elements not listed explicitly, or includes inherent elements of the process, method, article, or device. In the absence of more limitations, an element defined by "include a..." does not exclude other same elements existing in the process, method, article, or device including the element.

It should be understood that when the structure of a component is described and when one layer or area is referred to as located "on" or "above" other layer or area, the one layer or area may be directly located on the other layer or area, or other layers or areas may be included between the one layer or area and the other layer or area. In addition, if the component is flipped, the one layer or area will be located "below" or "under" the other layer or area.

Understandably, the term "and/or" used below is only an associative relationship for describing associated objects, indicating three relationships. For example, A and/or B may indicate three situations: A exists alone; A and B exist at the same time; and B exists alone. In addition, the character "/" herein generally indicates an "or" relationship between contextually associated objects.

In the embodiments of the present application, the term "electrically connected" may refer to direct electrical connection between two components, or electrical connection between two components by one or more other components. The term "drive" may refer to "control" or "operate". The term "partial" may refer to "local". The term "pattern" may refer to "member". The term "end" may refer to "end segment" or "end edge". A display panel may be a display apparatus or a module/portion of a display apparatus.

It is obvious to those skilled in the art that various modifications and changes can be made in the present application without departing from the gist or scope of the present application. Therefore, the present application is intended to cover the modifications and variations of the present application that fall within the scope of the corresponding claims (technical solutions to be protected) and equivalents thereof. It should be noted that the implementations provided in the embodiments of the present application can be combined with each other without contradiction.

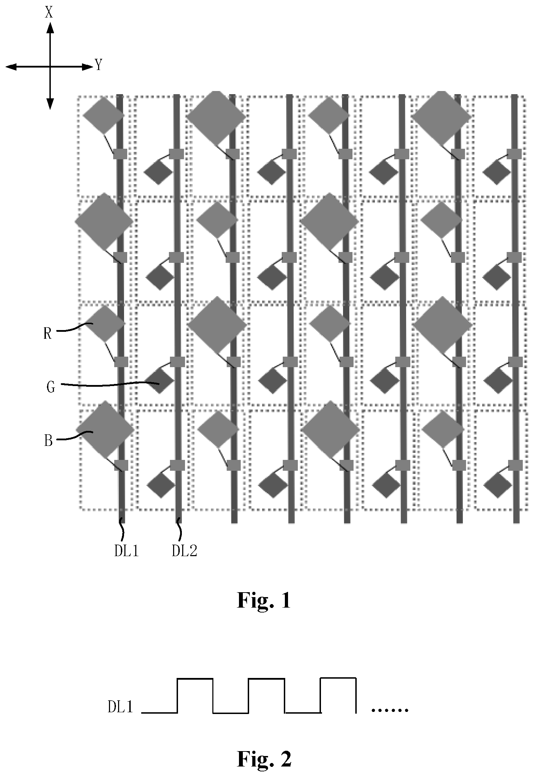

Before elaborating on the technical solutions provided in the embodiments of the present application, in order to facilitate the understanding of the embodiments of the present application, there is first provided a comparative example. Fig. 1 shows a schematic structural view of a display panel in a comparative example. The display panel includes red sub-pixels R, green sub-pixels G, and blue sub-pixels B. A data line DL1 connects the red sub-pixels R and the blue sub-pixels B located in the same column, and a data line DL2 connects the green sub-pixels G located in the same column. The data lines are used for providing data signals to the sub-pixels. The data lines are connected to a driver chip (not shown), and the driver chip is configured to generate the data signals.

For example, the display panel displays a pure color image (such as a pure red image or a pure blue image). As shown in Fig. 2, the voltage on the data line DL1 jumps up and down, resulting in an increase in power consumption of the driver chip connected to the data line.

To solve the above technical problems, the embodiments of the present application provide a display panel and a display apparatus. Hereinafter, embodiments of the present application will be described in conjunction with the accompanying drawings.

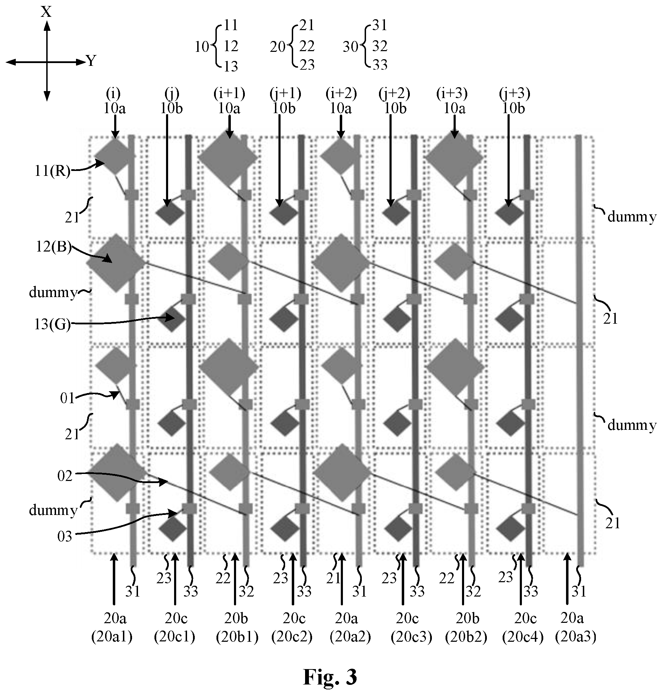

As shown in Figs. 3 to 5, the display panel provided in the embodiments of the present application includes light-emission elements 10, pixel circuits 20, and data lines 30.

For example, the light-emission elements 10 include organic light-emission diodes (OLEDs). The light-emission element 10 includes an anode, a light-emission layer, and a cathode. The position of the light-emission element in the accompanying drawings of the present application may be understood as the position of the anode of the light-emission element.

The data line 30 is electrically connected to the pixel circuit 20, and the data line 30 is used for providing data signals to the pixel circuit 20. The pixel circuit 20 generates certain driving current based on the data signals from the data line 30, where the driving current is used for driving the light-emission element 10.

The data line 30 is electrically connected to a driver chip (not shown), and the driver chip is configured to generate data signals and transmitting the data signals to the data line 30.

The light-emission elements 10 include first light-emission elements 11, second light-emission elements 12, and third light-emission elements 13. The first light-emission elements 11, the second light-emission elements 12, and the third light-emission elements 13 have different light-emission colors.

A first unit column 10a includes the first light-emission elements 11 and the second light-emission elements 12 alternately arranged in a first direction X, a second unit column 10b includes a plurality of the third light-emission elements 13 arranged in the first direction X, the first unit column 10a and the second unit column 10b are alternately arranged in a second direction Y, and the first direction X intersects the second direction Y. For example, the first direction X is a column direction, and the second direction Y is a row direction.

As an example, as shown in Figs. 3 to 5, the first light-emission elements 11 are red light-emission elements, the second light-emission elements 12 are blue light-emission elements, and the third light-emission elements 13 are green light-emission elements. In this example, the red light-emission elements and the blue light-emission elements are alternately arranged in one column, while the green light-emission elements are arranged in another column.

As another example, the first light-emission elements 11 are red light-emission elements, the second light-emission elements 12 are green light-emission elements, and the third light-emission elements 13 are blue light-emission elements, which will be illustrated in the following accompanying drawings. In this example, the red light-emission elements and the green light-emission elements are alternately arranged in one column, while the blue light-emission elements are arranged in another column.

It should be noted that the light-emission colors of the first light-emission elements and the second light-emission elements are interchangeable.

For example, different light-emission elements have the same stacked structure. For example, the light-emission elements of three colors each include an anode, a light-emission layer, and a cathode that are laminated, where the anode of the light-emission element is electrically connected to the pixel circuit by a via (one end of the via extends to a film layer where the anode is located and is connected to the anode by a lap joint or the anode is connected to the via by a trace).

The pixel circuits 20 include first pixel circuits 21, second pixel circuits 22, and third pixel circuits 23. It should be noted that in the accompanying drawings marked with pixel circuits in the present application, dashed boxes indicate approximate positions of the pixel circuits.

A plurality of pixel circuits 20 constitute a first circuit column 20a, a second circuit column 20b, and a third circuit column 20c. The first circuit column 20a includes a plurality of first pixel circuits 21 arranged in the first direction X, the second circuit column 20b includes a plurality of second pixel circuits 22 arranged in the first direction X, and the third circuit column 20c includes a plurality of third pixel circuits 23 arranged in the first direction X.

It can be understood that the first circuit column 20a does not include the second pixel circuits 22 or the third pixel circuits 23, the second circuit column 20b does not include the first pixel circuits 21 or the third pixel circuits 23, and the third circuit column 20c does not include the first pixel circuits 21 or the second pixel circuits 22.

The first pixel circuit 21 is electrically connected to a first data line 31 and the first light-emission element 11, the second pixel circuit 22 is electrically connected to a second data line 32 and the second light-emission element 12, and the third pixel circuit 23 is electrically connected to a third data line 33 and the third light-emission element 13.

From the perspective of transmitting a data signal, the first data line 31 is only used for transmitting a data signal required by the first light-emission element 11, the second data line 32 is only used for transmitting a data signal required by the second light-emission element 12, and the third data line 33 is only used for transmitting a data signal required by the third light-emission element 13.

For example, when a pure color image corresponding to the first light-emission element 11 is displayed, the first data line 31 transmits the data signal required by the first light-emission element 11, but does not transmit the data signal required by the second light-emission element 12, such that the first data line 31 does not need to provide changing data signals. Similarly, when a pure color image corresponding to the second light-emission element 12 is displayed, the second data line 32 transmits the data signal required by the second light-emission element 12, but does not transmit the data signal required by the first light-emission element 11, such that the second data line 32 does not need to provide changing data signals.

According to the display panel provided in the embodiments of the present application, one data line is used for providing a data signal required by the light-emission elements of the same light-emission color, such that during the display of a pure color image, the data signal on the data line does not need to jump, thereby reducing the power consumption of the driver chip connected to the data line.

It should be noted that, in Figs. 3 to 5, the first data line 31 overlaps the first circuit column 20a to indicate that the first data line 31 is electrically connected to each first pixel circuit 21 in the first circuit column 20a, the second data line 32 overlaps the second circuit column 20b to indicate that the second data line 32 is electrically connected to each second pixel circuit 22 in the second circuit column 20b, and the third data line 33 overlaps the third circuit column 20c to indicate that the third data line 33 is electrically connected to each third pixel circuit in the third circuit column 20c. One end of trace 01 points to the first light-emission element 11, and the other end points to the first data line 31, indicating that the first data line 31 is used for providing the data signal required by the first light-emission element 11, rather than defining that the first light-emission element 11 is electrically connected to the first data line 31 by trace 01. The same applies to the trace 02 and the trace 03, and will not be repeated here. Moreover, in order to distinguish between marker lines and the structure of the display panel, the marker line extending within the dashed box is marked with an arrow, such as marker lines corresponding to 11, 12, and 13.

For example, as shown in Fig. 3, (i) to (i+3) and (j) to (j+3) represent eight unit columns and illustrate nine circuit columns, wherein the (i)^{th}, (i+1)^{th}, (i+2)^{th}, and (i+3)^{th} unit columns are four first unit columns 10a, the (j)^{th}, (j+1)^{th}, (j+2)^{th}, and (j+3)^{th} unit columns are four second unit columns 10b. 20a1, 20a2, 20a3 represent three first circuit columns 20a, 20b1 and 20b2 represent two second circuit columns 20b, and 20c1, 20c2, 20c3, and 20c4 represent four third circuit columns 20c.

Compared to the example shown in Fig. 1, the relative positional relationship between the third light-emission element 13 and the pixel circuit connected thereto remains unchanged in Fig. 3, and the following is the differences.

The first pixel circuit 21 in the 1^{st} first circuit column 20a1 is configured to drive the first light-emission element 21 in the (i)^{th} first unit column 10a, the first pixel circuit 21 in the 2^{nd} first circuit column 20a2 is configured to drive the first light-emission elements 21 in the (i+1)^{th} and (i+2)^{th} first unit columns 10a, and the first pixel circuit 21 in the 3^{rd} first circuit column 20a3 is configured to drive the first light-emission element 21 in the (i+3)^{th} first unit column 10a.

The second pixel circuit 22 in the 1^{st} second circuit column 20b1 is configured to drive the second light-emission elements 22 in the (i)^{th} and (i+1)^{th} first unit columns 10a, and the second pixel circuit 22 in the 2^{nd} second circuit column 20b is configured to drive the second light-emission elements 22 in the (i+2)^{th} and (i+3)^{th} first unit columns 10a.

In Fig. 3, the number of columns of the pixel circuits is 1 more than the number of columns of the light-emission elements, where the 1^{st} first circuit column 20a1 and the 3^{rd} first circuit column 20a3 include dummy pixel circuits, and the dummy pixel circuits are not connected to the light-emission elements, that is, the dummy pixel circuits are not configured to drive the light-emission elements.

It should be noted that the number of columns of the pixel circuits indicates that at least one pixel circuit in the pixel circuit column is connected to the light-emission element. For example, the display panel may further include dummy pixel circuit columns, and none of the dummy pixel circuits in the dummy pixel circuit columns are configured to drive the light-emission elements.

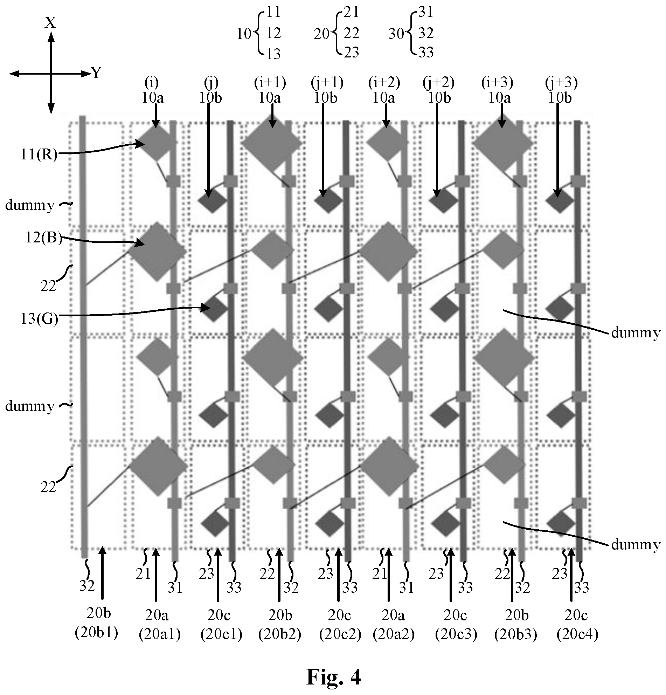

For another example, as shown in Fig. 4, the similarities between Fig. 4 and Fig. 3 will not be repeated, and the following is the differences between Fig. 4 and Fig. 3.

The first pixel circuit 21 in the 1^{st} first circuit column 20a1 is configured to drive the first light-emission elements 11 in the (i)^{th} and (i+1)^{th} first unit columns 10a, and the first pixel circuit 21 in the 2^{nd} first circuit column 20a2 is configured to drive the first light-emission elements 11 in the (i+2)^{th} and (i+3)^{th} first unit columns 10a.

The second pixel circuit 22 in the 1^{st} second circuit column 20b1 is configured to drive the second light-emission element 12 in the (i)^{th} first unit column 10a, the second pixel circuit 22 in the 2^{nd} second circuit column 20b2 is configured to drive the second light-emission elements 12 in the (i+1)^{th} and (i+2)^{th} first unit columns 10a, and the second pixel circuit 22 in the 3^{rd} second circuit column 20b3 is configured to drive the second light-emission element 12 in the (i+3)^{th} first unit column 10a.

In Fig. 4, the number of columns of the pixel circuits is 1 more than the number of columns of the light-emission elements, in which the 1^{st} second circuit column 20b1 and the 3^{rd} second circuit column 20b3 include dummy pixel circuits.

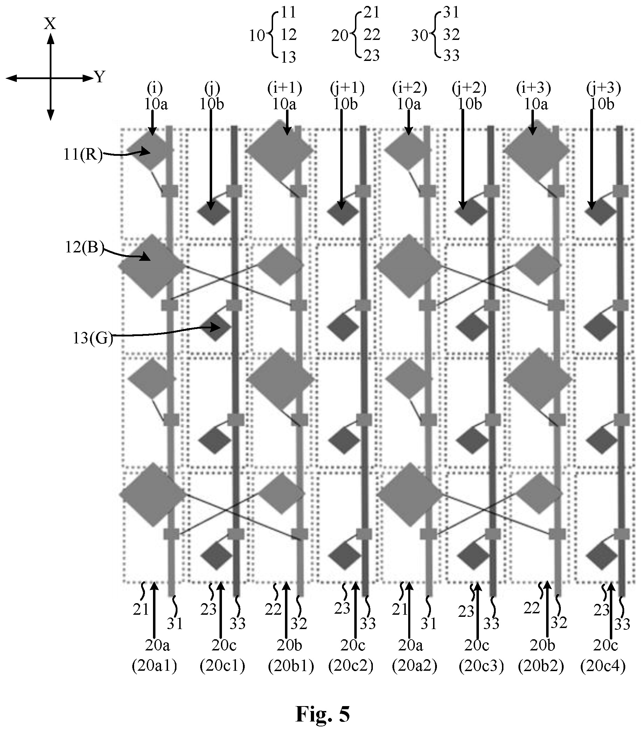

For another example, as shown in Fig. 5, the similarities between Fig. 5 and Fig. 3 or 4 will not be repeated, and the following is the differences therebetween.

The first pixel circuit 21 in the 1^{st} first circuit column 20a1 is configured to drive the first light-emission elements 21 in the (i)^{th} and (i+1)^{th} first unit columns 10a, and the first pixel circuit 21 in the 2^{nd} first circuit column 20a2 is configured to drive the first light-emission elements 21 in the (i+2)^{th} and (i+3)^{th} first unit columns 10a.

The second pixel circuit 22 in the 1^{st} second circuit column 20b1 is configured to drive the second light-emission elements 22 in the (i)^{th} and (i+1)^{th} first unit columns 10a, and the second pixel circuit 22 in the 2^{nd} second circuit column 20b2 is configured to drive the second light-emission elements 22 in the (i+2)^{th} and (i+3)^{th} first unit columns 10a.

In Fig. 5, the number of columns of the pixel circuits is equal to the number of columns of the light-emission elements. Each circuit column in Fig. 5 does not include dummy pixel circuits.

It should be noted that Figs. 3 to 5 are not intended to limit the present application. In other embodiments, the arrangement structure of the light-emission elements of the display panel may be in other ways, or the arrangement structure of the pixel circuits may be in other ways. As long as the same unit column includes light-emission elements of different colors, the light-emission elements of the same color can be connected by the data line to reduce the power consumption of the driver chip.

As shown in Figs. 3 to 5, for the first circuit column that does not include the dummy pixel circuits, the first circuit column needs to be electrically connected to the first light-emission elements located in two unit columns. As such, for at least some first light-emission elements, connection lines are required to connect the first light-emission elements to the first pixel circuits. The longer the connection lines, the greater the voltage drop, which will affect the driving capability of the first pixel circuits to the first light-emission elements. Similarly, the second light-emission element and the second pixel circuits electrically connected thereto also encounter the same situation. Therefore, it is also important to balance the driving capability of the pixel circuits while reducing the power consumption.

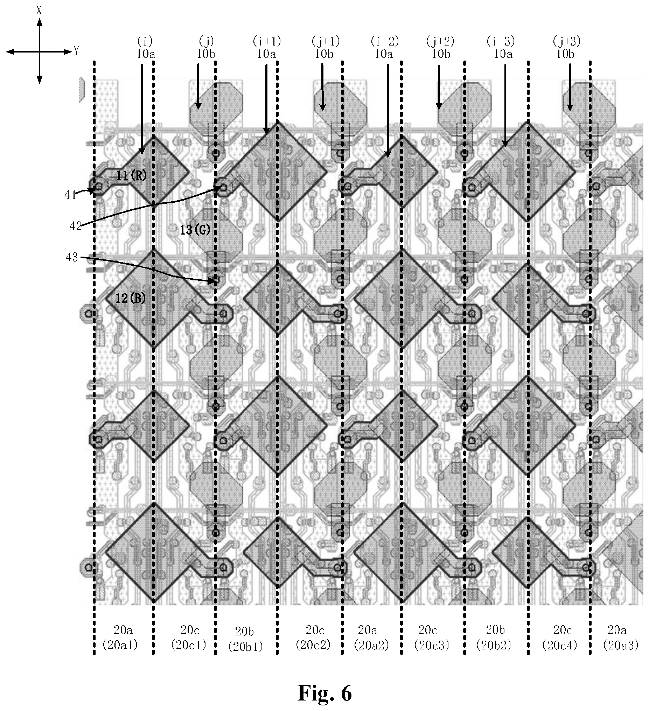

In view of this, in some embodiments, as shown in Fig. 3 or Fig. 4, the number of columns of the pixel circuits in the display panel is greater than the number of columns of the light-emission elements, and some circuit columns include dummy pixel circuits. Figs. 6 to 8 illustrate schematic views of arrangement of connection vias between light-emission elements and pixel circuits. In Figs. 6, 7, 8, and subsequent schematic views, longitudinal dashed lines indicate approximate positions of a plurality of circuit columns. In order to avoid excessive dashed lines, the approximate position of each pixel circuit is not circled with a dashed box. It can be understood that one circuit column between two longitudinal dashed lines includes a plurality of pixel circuits.

With reference to Figs. 3, 6, 7, and 8, the first light-emission element 11 is electrically connected to the first pixel circuit 21 by a first via 41. A first end of the first via 41 extends to the film layer where the anode of the first light-emission element 11 is located, and a second end of the first via 41 is electrically connected to the first pixel circuit 21. A plurality of first vias 41 corresponding to the same first circuit column 20a constitute a first via column 41a. For the first circuit column that does not include the dummy pixel circuits, in the second direction Y, the plurality of first light-emission elements 11 electrically connected to the first pixel circuits by the vias on the same first via column 41a are located on two sides of the first via column 41a respectively. In the figures, the plurality of first vias located in the same column are circled with a dashed box to represent the first via column, and a plurality of second vias located in the same column are circled with another dashed box to represent a second via column.

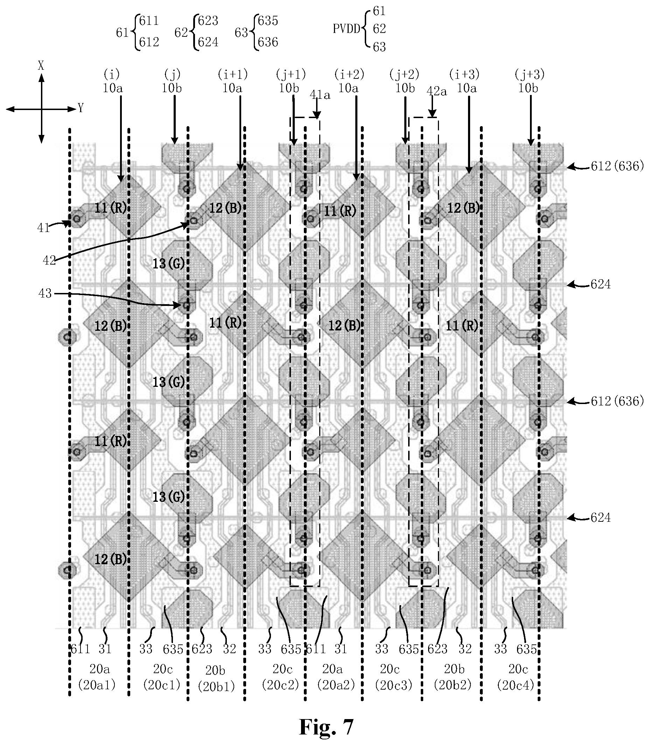

For example, in Fig. 7 there are included totally four first unit columns 10a from i to i+3, four second unit columns 10b from j to j+3, eight pixel circuit columns, and eight circuit columns. The first unit column 10a includes first light-emission elements 11 and second light-emission elements 12 alternately arranged in the first direction X. For example, the first light-emission elements 11 are red light-emission elements, and the second light-emission elements 12 are blue light-emission elements. The second unit column 10b includes third light-emission elements 13 alternately arranged. For example, the third light-emission elements 13 are green light-emission elements.

The first circuit column 20a includes a plurality of first pixel circuits 21 arranged in the first direction, and the first pixel circuits 21 are configured to drive the first light-emission elements 11. The second circuit column 20b includes a plurality of second pixel circuits 22 arranged in the first direction, and the second pixel circuits 22 are configured to drive the second light-emission elements 12. The third circuit column 20c includes a plurality of third pixel circuits 23 arranged in the first direction, and the third pixel circuits 23 are configured to drive the third light-emission elements 13.

Taking the 2^{nd} first circuit column 20a2 in Fig. 6 and Fig. 7 as an example, the 2^{nd} first circuit column 20a2 does not include dummy pixel circuits, the 2^{nd} first circuit column 20a2 is configured to drive the first light-emission elements 11 in the (i+1)^{th} first unit column 10a and the (i+2)^{th} first unit column 10a, the first via 41 of the first light-emission element 11 in the (i+1)^{th} first unit column 10a is on the right side of the first light-emission element, and the first via 41 of the first light-emission element 11 in the (i+2)^{th} first unit column 10a is on the left side of the first light-emission element. That is, the first vias of the first light-emission elements connected to the same first circuit column and located in two first unit columns are all arranged towards a direction close to the first circuit column, which can reduce the lengths of connection lines between the first light-emission elements and the first pixel circuits, thereby avoiding large voltage drop caused by excessively long connection lines, reducing the power consumption, and balancing the driving capability of the first pixel circuits.

For example, with reference to Figs. 6 to 8, for the first circuit column including dummy pixel circuits, taking the 1^{st} first circuit column 20a1 as an example, the 1^{st} first circuit column 20a1 is configured to drive the first light-emission element 11 in the (i)^{th} first unit column 10a, and the plurality of first vias 41 of the (i)^{th} first unit column 10a are located on the same side of the (i)^{th} first unit column 10a.

The second light-emission element 12 is electrically connected to the second pixel circuit 22 by a second via 42, and a plurality of the second vias 42 corresponding to the same second circuit column 20b constitute a second via column 42a. A first end of the second via 42 extends to the film layer where the anode of the second light-emission element 12 is located, and a second end of the second via 42 is electrically connected to the second pixel circuit 22. For the second circuit column that does not include the dummy pixel circuits, in the second direction Y, the plurality of second light-emission elements 12 electrically connected to the second pixel circuits 22 by the vias on the same second via column 42a are located on two sides of the second via column 42a respectively.

For example, the 1^{st} second circuit column 20b1 does not include dummy pixel circuits, the 1^{st} second circuit column 20b1 is configured to drive the second light-emission elements 12 in the (i)^{th} first unit column 10a and the (i+1)^{th} first unit column 10a, the second via 42 of the second light-emission element 12 in the (i)^{th} first unit column 10a is on the right side of the second light-emission element, and the second via 42 of the second light-emission element 12 in the (i+1)^{th} first unit column 10a is on the left side of the second light-emission element. That is, the second vias of the second light-emission elements connected to the same second circuit column and located in two first unit columns are all arranged towards a direction close to the second circuit column, which can reduce the lengths of connection lines between the second light-emission elements and the second pixel circuits, thereby avoiding large voltage drop caused by excessively long connection lines, reducing the power consumption, and balancing the driving capability of the second pixel circuits.

For the first circuit column including dummy pixel circuits, the plurality of first vias are correspondingly on the same side of the first circuit column. For example, in Fig. 6, the 1^{st} first circuit column 20a1 includes dummy pixel circuits, and their corresponding first vias are generally located on the left side.

For the second circuit column including dummy pixel circuits, the plurality of second vias are correspondingly on the same side of the second circuit column.

In some embodiments, as shown in Figs. 6 to 8, for the same first unit column 10a, the first via 41 and the second via 42 are located on two sides of the first unit column 10a respectively in the second direction Y.

For example, in the (i)^{th} first unit column 10a, the plurality of first vias 41 are located on the left side of the (i)^{th} first unit column 10a, and the plurality of second vias 42 are located on the right side of the (i)^{th} first unit column 10a.

For another example, in the (i+1)^{th} first unit column 10a, the plurality of first vias 41 are located on the right side of the (i+1)^{th} first unit column 10a, and the plurality of second vias 42 are located on the left side of the (i+1)^{th} first unit column 10a.

Because the first light-emission elements 11 and the second light-emission elements 12 in the first unit column 10a are alternately distributed in the second direction Y, the first vias 41 and the second vias 42 are alternately distributed on two sides of the first unit column 10a, which avoids excessively dense vias corresponding to the first unit column 10a on the same side. The excessively dense vias need to occupy more layout space, which is not conducive to increasing pixel density. Therefore, the embodiment of the present application is conducive to increasing pixel density and can eliminate signal interference between different vias.

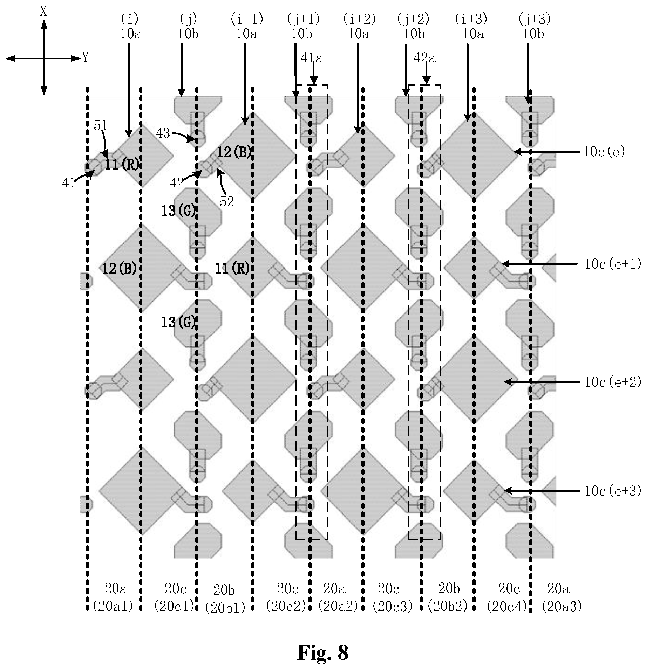

In some embodiments, with reference to Fig. 8, the first light-emission elements 11 and the second light-emission elements 12 are alternately arranged in the second direction Y to constitute a first unit row 10c. In Fig. 8, (e) to (e+3) are marked next to marker 10c, where (e) represents the (e)^{th} first unit row 10c, (e+1) represents the (e+1)^{th} first unit row 10c, (e+2) represents the (e+2)^{th} first unit row 10c, and (e+3) represents the (e+3)^{th} first unit row 10c.

The plurality of third light-emission elements 13 are arranged in the second direction Y to constitute a second unit row, and the first unit row and the second unit row are alternately arranged in the first direction.

For the same first unit row 10c, in the second direction Y, the relative positional relationship between the first via 41 and the first light-emission element 11 is the same as the relative positional relationship between the second via 42 and the second light-emission element 12. That is, for the same unit row, the first via and the second via are both located on the same side of the first or second light-emission element electrically connected thereto.

For example, in the (e)^{th} and (e+2)^{th} first unit rows 10c, the first vias 41 are all on the left side of the first light-emission elements 11 connected thereto. For another example, in the (e+1)^{th} and (e+3)^{th} first unit rows 10c, the first vias 41 are all on the right side of the first light-emission elements 11 connected thereto.

In this example, in the same first unit row 10c, the first vias 41 and the first light-emission elements 11 electrically connected thereto are configured according to the same positional rule, which can ensure that the driving capability of each first light-emission element 11 in the same row is equivalent, thereby improving display uniformity.

For example, in the (e)^{th} and (e+2)^{th} first unit rows 10c, the second vias 42 are on the left side of the second light-emission elements 12 connected thereto. For another example, in the (e+1)^{th} and (e+3)^{th} first unit rows 10c, the second vias 42 are on the right side of the second light-emission elements 12 connected thereto.

Similarly, in the same first unit row 10c, the second vias 42 and the second light-emission elements 12 electrically connected thereto are arranged according to the same positional rule, which can ensure that the driving capability of each second light-emission element 12 in the same row is equivalent, thereby improving display uniformity.

It should be noted that "left side" and "right side" herein represent different sides and are not used to absolutely limit the left or right side.

Further, the relative positional relationship between the first via 41 and the first light-emission element 11 is the same as the relative positional relationship between the second via 42 and the second light-emission element 12, which can prevent, for the same first unit row, the first via and the second via that are adjacent from being excessively dense. For the adjacent first unit rows, the first via and the second via are located on different sides of the first light-emission element and the second light-emission element in the different first unit rows. For example, in Fig. 8, in the (e)^{th} first unit row 10c, the first via 41 and the second via 42 are both located on first sides of the first light-emission element 11 and the second light-emission element 12 electrically connected thereto. In the (e+2)^{th} first unit row 10c adjacent to the (e)^{th} first unit row 10c, the first via 41 and the second via 42 are both located on second sides of the first light-emission element 11 and the second light-emission element 12 electrically connected thereto. Such arrangement is conducive to connecting the first light-emission elements in the adjacent first unit columns to the same circuit column.

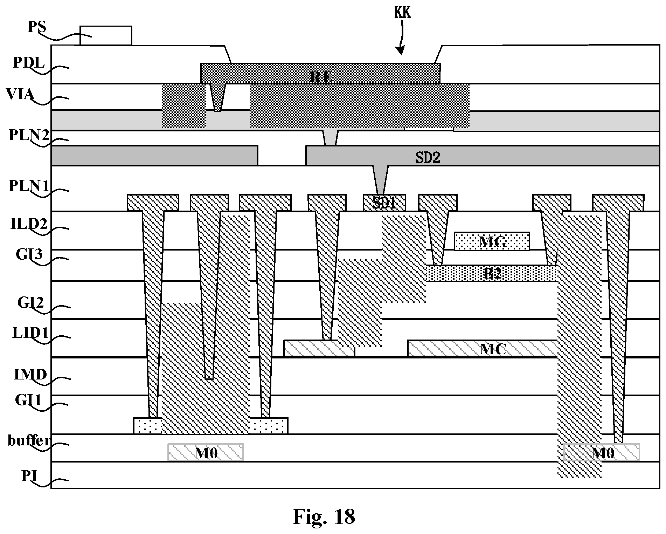

In some embodiments, as shown in Figs. 6 to 18, the display panel may include at least two semiconductor layers. For example, with reference to Fig. 18, the display panel includes a first semiconductor layer B1 and a second semiconductor layer B2. As an example, the material of the first semiconductor layer B1 includes low temperature poly-silicon (LTPS), the material of the second semiconductor layer B2 includes indium gallium zinc oxide (IGZO), and the display panel is of a low temperature polycrystalline oxide (LTPO) type. LTPS type transistors have higher carrier movement speed, while IGZO type transistors have lower leakage current.

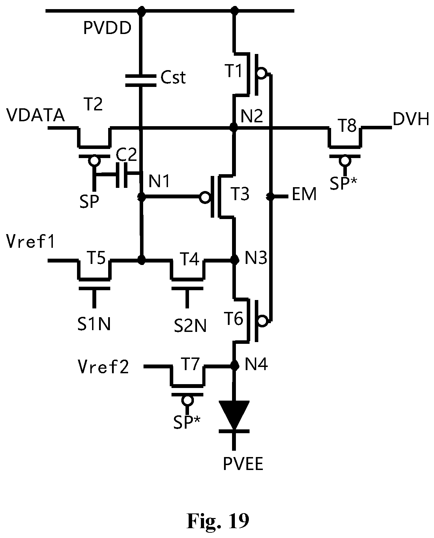

For example, the structure of the pixel circuit may be shown in Fig. 19, where drive transistor T3 may be an LTPS type transistor, and threshold compensation transistor T4 and reset transistor T5 may be IGZO type transistors. It should be noted that the structure of the pixel circuit illustrated in Fig. 19 and subsequent figures show only some examples and is not intended to limit the scope of the present application.

As shown in Fig. 18, the display panel may further include an auxiliary metal layer M0, a first gate layer GAT, a capacitor metal layer MC, a second gate layer MG, a first metal layer SD1, a second metal layer SD2, a third metal layer SD3, and an anode layer RE. Fig. 18 is referred to for the relative positional relationships between the film layers, which will not be further elaborated here. It should be noted that the auxiliary metal layer M0 may be configured according to requirements. In some examples, the auxiliary metal layer M0 may not be configured. Similarly, the second metal layer SD2 and the third metal layer SD3 may be configured according to requirements. In some examples, the second metal layer SD2 or the third metal layer SD3 may not be configured. It can be understood that the first gate layer GAT, the capacitor metal layer MC, and the second gate layer MG are also metal layers. The first metal layer, the second metal layer, and the third metal layer herein are only names of different metal layers and are not intended to limit the order of the metal layers.

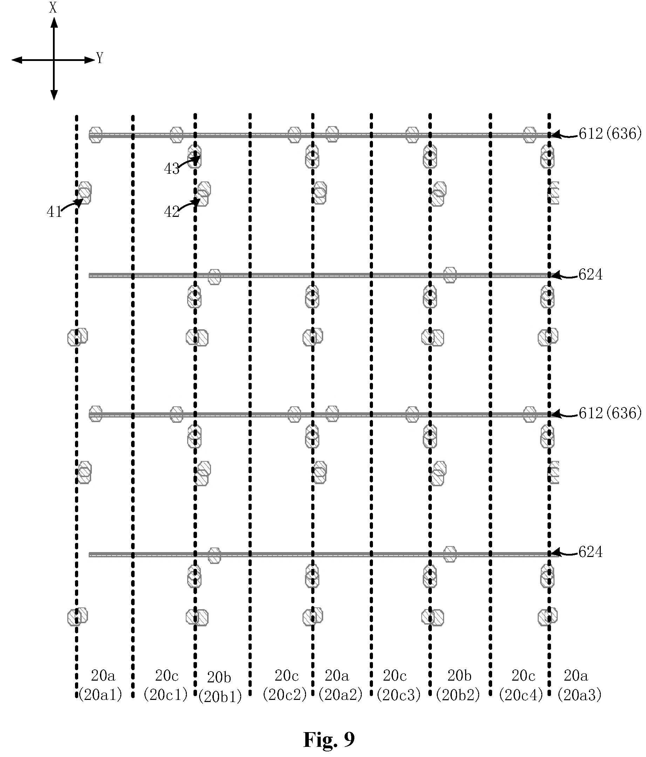

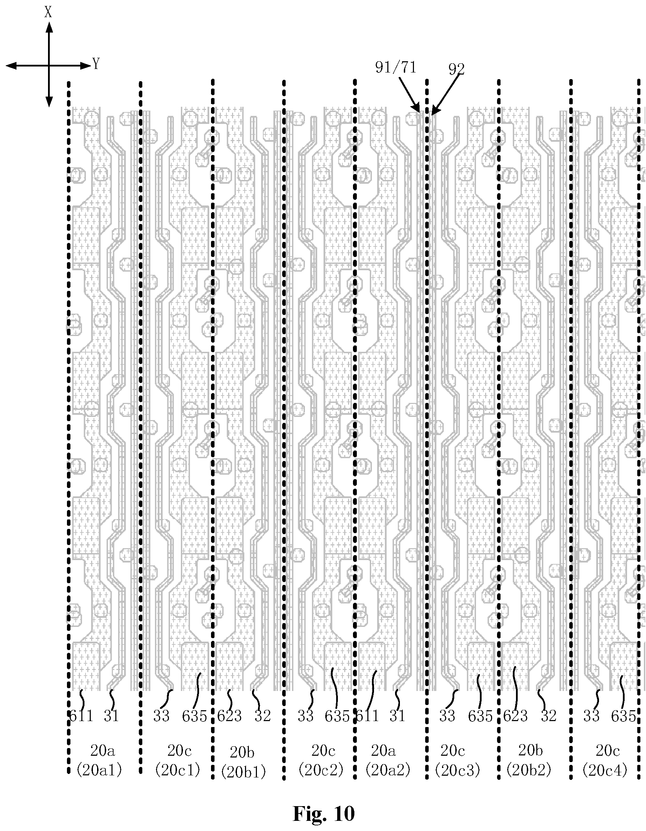

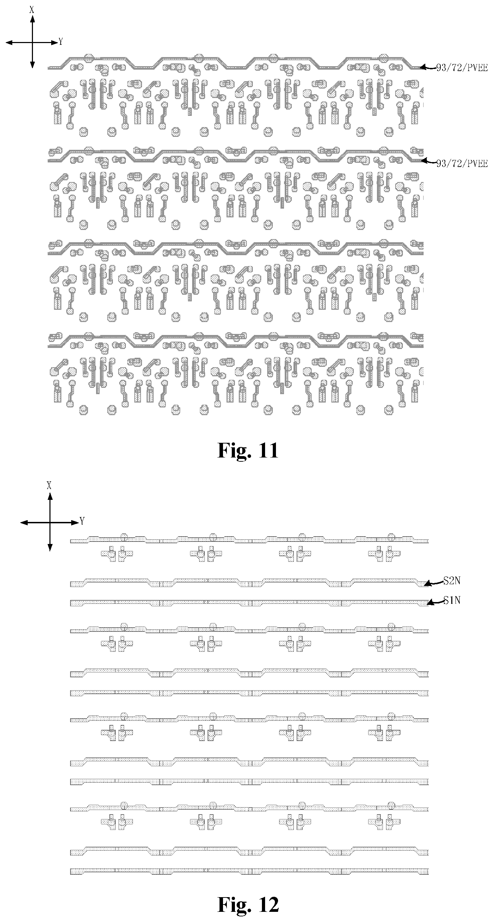

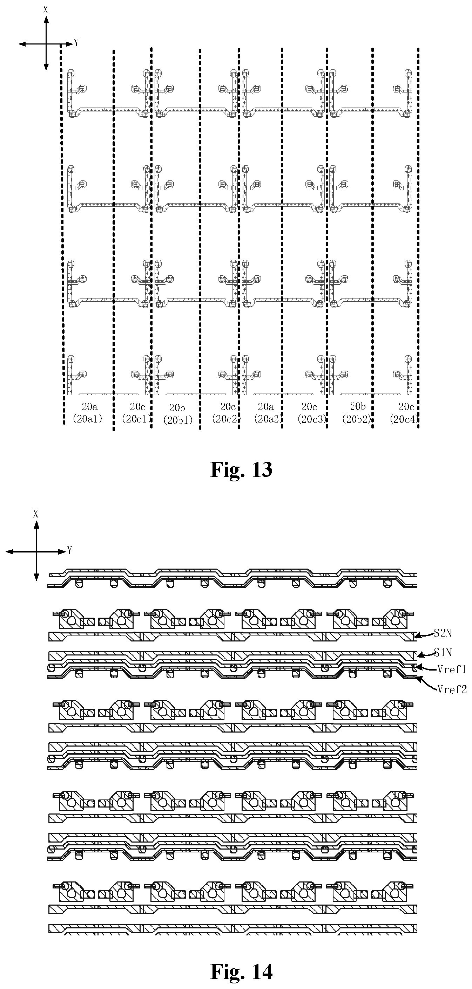

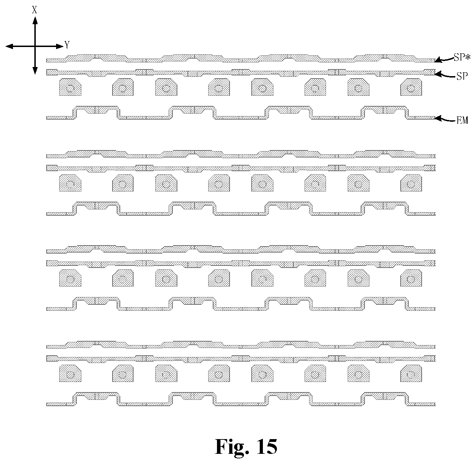

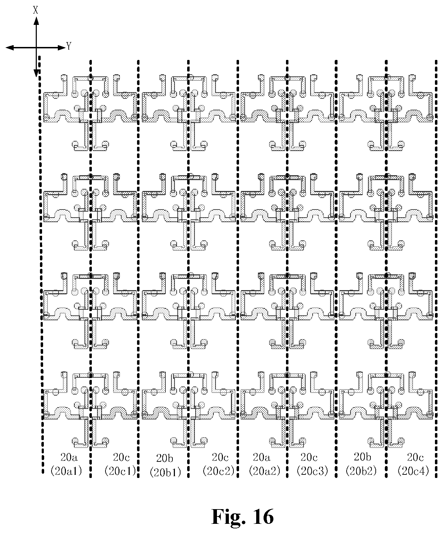

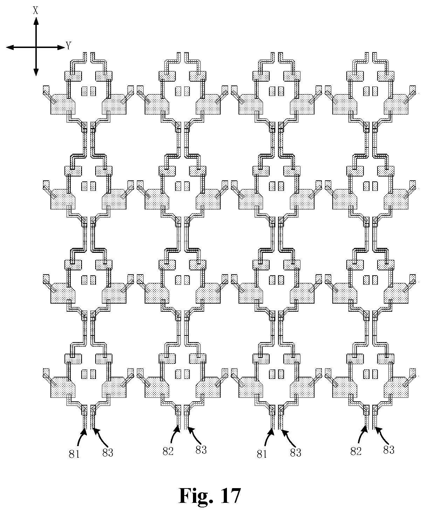

Corresponding to the film layer structure shown in Fig. 18 and the circuit structure shown in Fig. 19, Figs. 8 to 17 illustrate layout structures of film layers in order from top to bottom. Fig. 8 shows a layout structure of the anode layer RE, where the anodes of the light-emission elements are arranged in the anode layer RE, and the connection lines between the light-emission elements and the pixel circuits may also be arranged at least partially in the anode layer RE. Fig. 9 shows a layout structure of the third metal layer SD3, where the third metal layer SD3 may include traces extending in the second direction Y, such as power branch lines 612 and 624. Fig. 10 shows a layout structure of the second metal layer SD2, where the second metal layer SD2 may include traces extending in the first direction X, such as data lines 31 to 33, power branch lines 611, 623, and 635, and traces 91 and 92. Fig. 11 shows a layout structure of the first metal layer SD1, where the first metal layer SD1 may include traces extending in the second direction, such as second line segments 72 used for connecting data lines. Fig. 12 shows a layout of the second gate layer MG, where the second gate layer MG may include scan lines S1N and S2N extending in the second direction. Fig. 13 shows a layout structure of the second semiconductor layer B2, where the second semiconductor layer B2 may include active layers of transistors, for example, in Fig. 19, the active layers of transistors T4 and T5 are arranged in the second semiconductor layer B2. Fig. 14 shows a layout structure of the capacitor metal layer MC, where the capacitor metal layer MC includes scan lines S1N and S2N extending in the second direction, reset signal lines Vref1 and Vref2, and electrode plates of storage capacitors on one side. Fig. 15 shows a layout structure of the first gate layer GAT, where the first gate layer GAT includes scan lines SP and SP* extending in the second direction and light-emission control signal lines EM. Fig. 16 shows a layout structure of the first semiconductor layer B1, where the first semiconductor layer B1 may include active layers of transistors, for example, in Fig. 19, the active layers of transistors T1 to T3 and T6 to T8 are arranged in the first semiconductor layer B1. Fig. 17 shows a layout structure of the auxiliary metal layer M0, where the trace structures in the auxiliary metal layer M0 can shield active layers of transistors to stabilize the characteristics of the transistors.

The anode of each light-emission element is arranged in the anode layer RE, the pixel definition layer PDL includes a pixel opening KK, the light-emission layer (not shown in Fig. 18) of the light-emission element is correspondingly arranged in the opening KK, and the cathode (not shown in Fig. 18) of the light-emission element covers its light-emission layer.

As shown in Fig. 8 and Fig. 9, the anode of the first light-emission element 11 is electrically connected to the first end of the first via 41 by a first connection line 51, the second end of the first via 41 is electrically connected to the first pixel circuit, and the first connection line 51 and the anode of the first light-emission element 11 are located in the same film layer. The first connection line 51 and the anode of the first light-emission element 11 are both located in the anode layer RE shown in Fig. 18. The anode of the first light-emission element 11 is a light-emission area of the first light-emission element, and the first connection line 51 may be a non-light-emission area. Alternatively, in a thickness direction of the display panel, the anode of the first light-emission element 11 overlaps the opening KK, while the first connection line 51 does not overlap the opening KK.

The anode of the second light-emission element 12 is electrically connected to the first end of the second via 42 by a second connection line 52, the second end of the second via 42 is electrically connected to the second pixel circuit, and the second connection line 52 and the anode of the second light-emission element 12 are located in the same film layer. The second connection line 52 and the anode of the second light-emission element 12 are both located in the anode layer RE shown in Fig. 18. The anode of the second light-emission element 12 is a light-emission area of the second light-emission element, and the second connection line 52 may be a non-light-emission area. Alternatively, in the thickness direction of the display panel, the anode of the second light-emission element 12 overlaps the opening KK, while the second connection line 52 does not overlap the opening KK.

As described above, the plurality of first light-emission elements connected to the first circuit column are alternately distributed on two sides, so that the first light-emission element is relatively close to the first pixel circuit connected to the first light-emission element. In the LTPO pixel circuit, two pixel circuits adjacent in the second direction are designed in a mirror manner. Such design ensures that the first connection line between the first light-emission element and the first pixel circuit is not too long, so there is space in the film layer where the light-emission element is located to arrange the first connection line without changing the line, which can avoid increasing process difficulty. The same applies to the second connection line, and will not be repeated here.

In some embodiments, with reference to Fig. 8, the length of the first connection line 51 is less than a maximum width of the first light-emission element 11 in the second direction Y, and the length of the second connection line 50 is less than a maximum width of the second light-emission element 12 in the second direction Y. That is, no winding around the anode is required in the module where the anode of the light-emission element is located. The short connection line can reduce the impact of voltage drop, and the line does not need to be wound from one end of the light-emission element to the other, which can avoid problems such as short circuits caused by excessively long connection lines on the anode layer.

In some embodiments, as shown in Fig. 8, for the same unit column, the extension directions of the first connection line 51 and the second connection line 52 intersect. For example, the extension directions of the first connection line 51 and the second connection line 52 corresponding to the (i)^{th} first unit column 10a intersect. The intersection of two connection lines facilitates the setting of short connection lines.

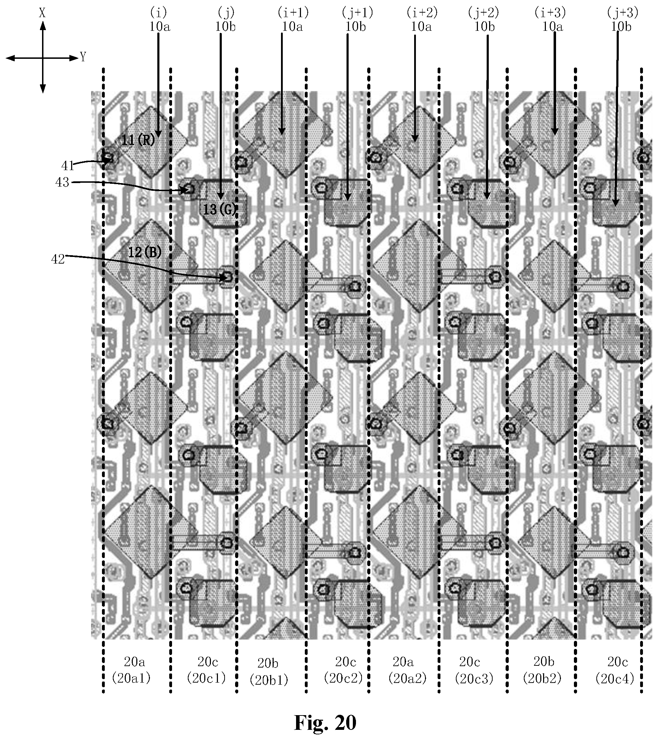

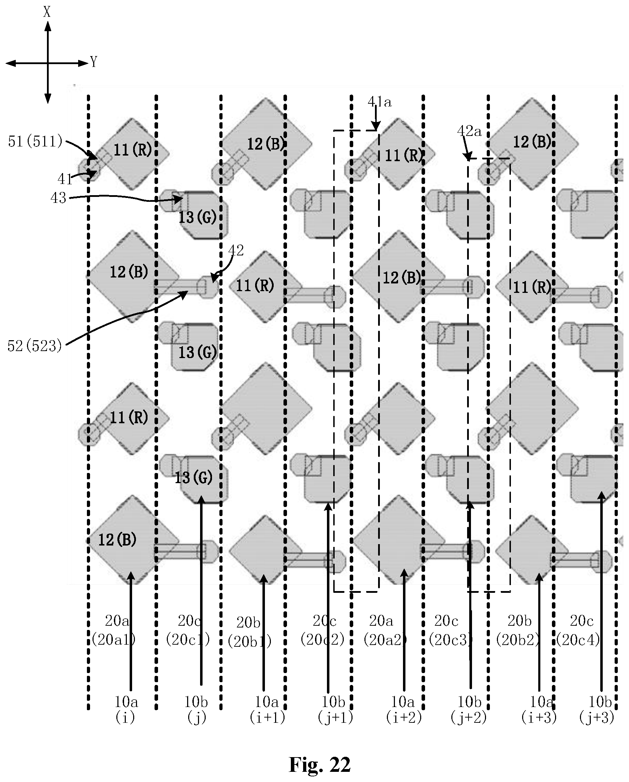

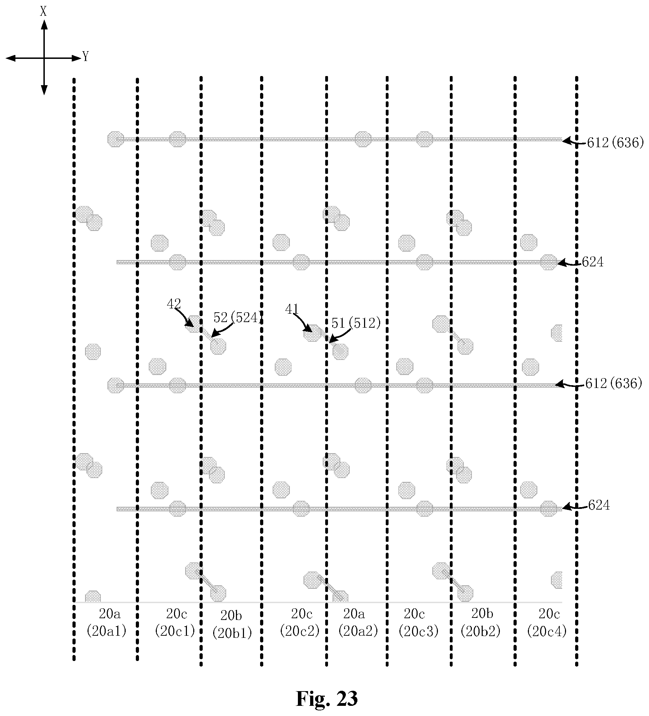

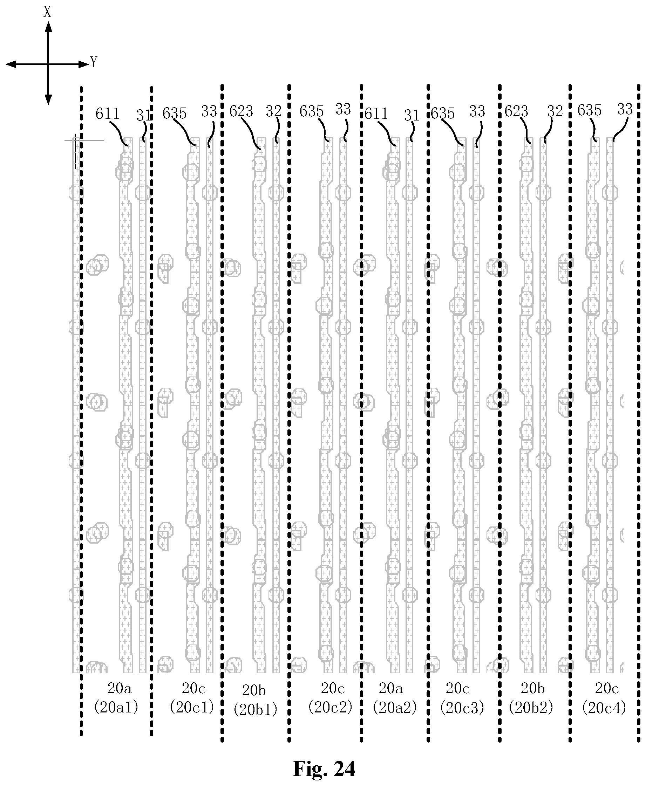

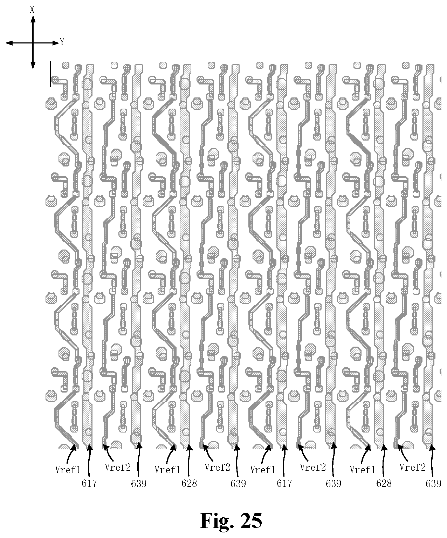

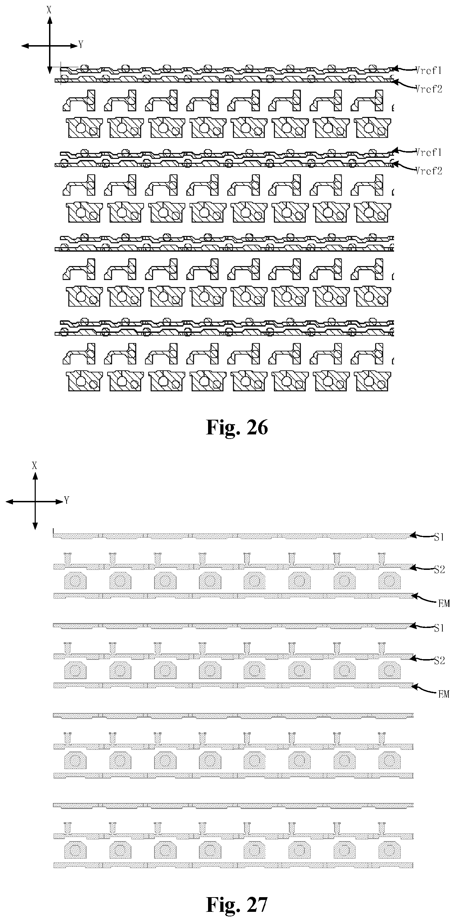

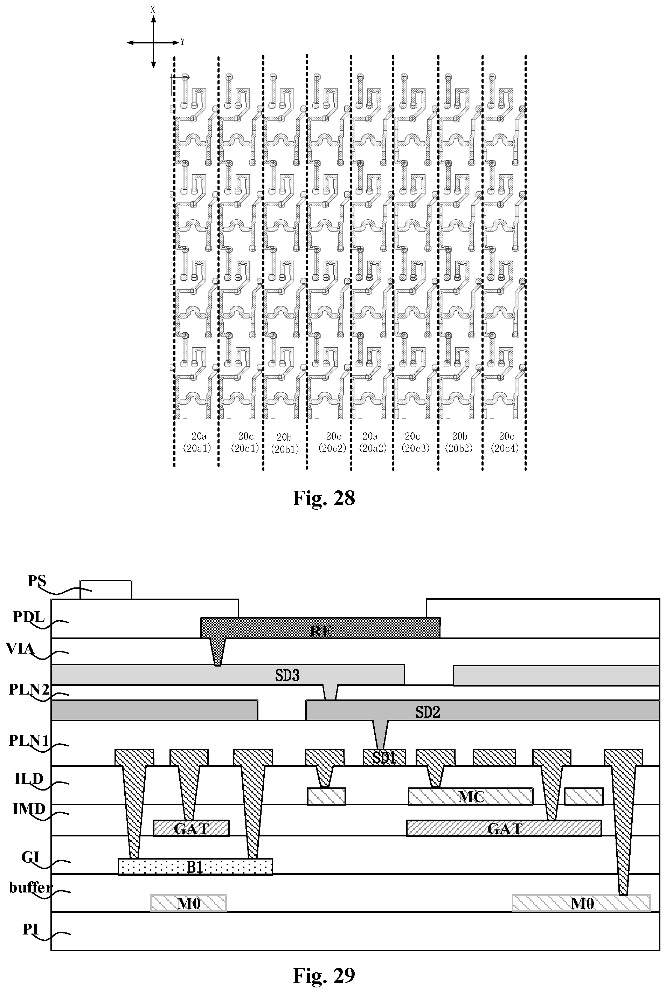

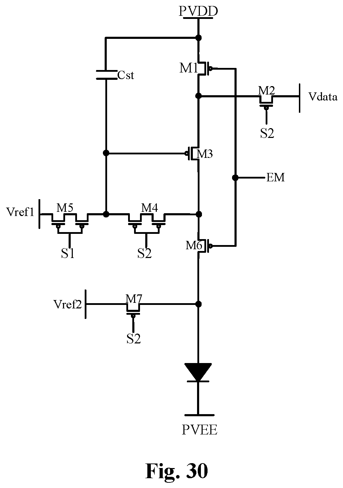

The architecture shown in Fig. 3 may further be implemented by the specific structures shown in Figs. 20 to 30. According to the structures shown in Figs. 20 to 30, the display panel includes one semiconductor layer. For example, as shown in Fig. 29, the display panel includes a first semiconductor layer B1. For example, the material of the first semiconductor layer B1 includes LTPS. As shown in Fig. 30, all transistors of the pixel circuit are LTPS type transistors. In addition, by comparing Fig. 29 and Fig. 18, the film structure shown in Fig. 29 does not include the second semiconductor layer B2 or the second gate layer MG. Corresponding to the film layer structure shown in Fig. 29 and the circuit structure shown in Fig. 30, Figs. 22 to 27 illustrate layout structures of film layers from top to bottom in order. Fig. 22 shows a layout structure of the anode layer RE, where the anodes of the light-emission elements are arranged in the anode layer RE, and the connection lines between the light-emission elements and the pixel circuits may also be arranged at least partially in the anode layer RE. Fig. 23 shows a layout structure of the third metal layer SD3, where the third metal layer SD3 may include traces extending in the second direction Y, such as power branch lines 612 and 624. Fig. 24 shows a layout structure of the second metal layer SD2, where the second metal layer SD2 may include traces extending in the first direction X, such as data lines 31 to 33 and power branch lines 611, 623, and 635. Fig. 25 shows a layout structure of the first metal layer SD1, where the first metal layer SD1 may include traces extending in the first direction, such as reset signal lines Vref1 and Vref2 and power branch lines 617, 628, and 639. Fig. 26 shows a layout structure of the capacitor metal layer MC, where the capacitor metal layer MC includes reset signal lines Vref1 and Vref2 extending in the second direction and one electrode plates of storage capacitors. Fig. 27 shows a layout structure of the first gate layer GAT, where the first gate layer GAT includes scan lines S1 and S2 extending in the second direction and light-emission control signal lines EM. Fig. 28 shows a layout structure of the first semiconductor layer B1, where the first semiconductor layer B1 may include active layers of transistors, for example, in Fig. 28, the active layers of transistors M1 to M7 are arranged in the first semiconductor layer B1. It can be understood that trace structures may alternatively be arranged in the auxiliary metal layer M0 shown in Fig. 29, where the trace structures in the auxiliary metal layer M0 shield the active layers of transistors to stabilize the characteristics of the transistors.

For an LTPS type display panel, a non-mirror design is adopted. Even if the plurality of first light-emission elements connected to the first circuit column are alternately distributed on two sides, the first light-emission elements are relatively close to the first pixel circuits connected thereto. However, in the non-mirror design, some first light-emission elements are still relatively far from the first pixel circuits connected thereto. If a connection line is still completely arranged on the anode film layer, the connection line needs to bypass the anodes of the light-emission elements of other colors, such that the connection line is longer to increase its voltage drop, which will weaken the driving capability of the first pixel circuit for the first light-emission element. In addition, if the connection line is completely arranged on the anode, the connection line approaches the anodes of other light-emission elements, which will increase the risk of short circuits between different light-emission elements. The second light-emission element follows the same way, and will not be repeated here.

In view of this, the first connection line and the second connection line can be designed by spanning (the traces are arranged in at least two film layers).

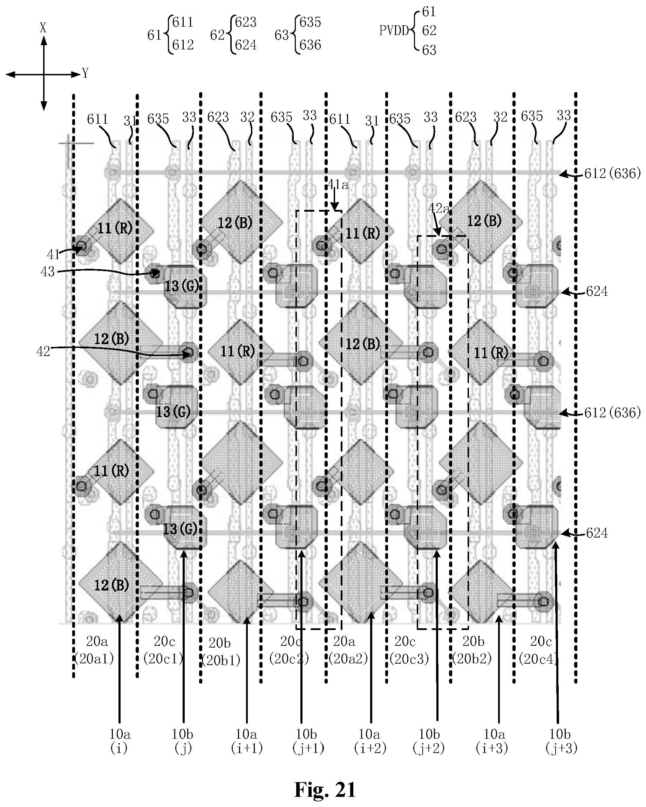

For example, in Fig. 21, the first light-emission element 11 is correspondingly provided with a first connection line 51, and the first connection line 51 is used for connecting the first light-emission element 11 and the first pixel circuit. The second light-emission element 12 is correspondingly provided with a second connection line 52, and the second connection line 52 is used for connecting the second light-emission element 12 and the second pixel circuit.

The first connection line 51 includes a first segment 511 and a second segment 512, the first segment 511 is connected between the anode of the first light-emission element 11 and the first end of the first via 41, and the second segment 512 is connected between the second end of the first via 41 and the first pixel circuit.

The second connection line 52 includes a third segment 523 and a fourth segment 524, the third segment 523 is connected between the anode of the second light-emission element 12 and the first end of the second via 42, and the fourth segment 524 is connected between the second end of the second via 42 and the second pixel circuit.

The lengths of the first connection lines 51 corresponding to the (i)^{th} and (i+2)^{th} first unit columns 10a are less than the lengths of the first connection lines 51 corresponding to the (i+1)^{th} and (i+3)^{th} first unit columns 10a.

The lengths of the second connection lines 52 corresponding to the (i)^{th} and (i+2)^{th} first unit columns 10a are greater than the lengths of the second connection lines 52 corresponding to the (i+1)^{th} and (i+3)^{th} first unit columns 10a.

Specifically, with reference to Figs. 21, 22, and 23, the display panel includes a first connection line 51 and a second connection line 52, the first connection line 51 includes a first segment 511 and a second segment 512, the first segment 511 is connected between the anode of the first light-emission element 11 and the first end of the first via 41, the second segment 512 is connected between the second end of the first via 41 and the first pixel circuit, the first segment 511 and the anode of the first light-emission element 11 are located in the same film layer, and the second segment 512 is located in the metal layer on the side where the anode of the first light-emission element 11 faces a substrate.

The second connection line 52 includes a third segment 523 and a fourth segment 524, the third segment 523 is connected between the anode of the second light-emission element 12 and the first end of the second via 42, the fourth segment 524 is connected between the second end of the second via 42 and the second pixel circuit, the third segment 523 and the anode of the second light-emission element 12 are located in the same film layer, and the fourth segment 524 is located in the metal layer on the side where the anode of the second light-emission element 12 faces the substrate.

In the embodiment of the present application, because the second segment 512 and the fourth segment 524 are located in the metal layers below the anodes, the lengths of the connection lines in the anode film layer can be reduced, and the connection lines in the metal layer are less constrained by the anodes. The routing form of the connection lines can be set according to proximity-based connection. The second segment 512 and the fourth segment 524 are straight and do not need to meander due to the constraint of the anodes, which can reduce the total length of the first connection line and the total length of the second connection line.

In some embodiments, with reference to Figs. 22, 23, 24, and 29, the display panel includes data lines, including first data lines 31, second data lines 32, and third data lines 33, all of which are located in the same film layer. In the thickness direction of the display panel, the film layer where the second segment 512 and the fourth segment 524 are located is located between the film layer where the data line is located and the anode of the light-emission element.

For example, with reference to Fig. 24 and Fig. 29, the data lines 31, 32, and 33 are located in the second metal layer SD2. With reference to Fig. 23 and Fig. 29, the second segment 512 and the fourth segment 524 are located in the third metal layer SD3. The anodes of various light-emission elements are located in the anode layer RE shown in Fig. 29, and the third metal layer SD3 is located between the second metal layer SD2 and the anode layer RE. That is, in the thickness direction of the display panel, the second segment 512 and the fourth segment 524 are closer to the anodes of the light-emission elements, which facilitates the connection of the second segment 512 and the fourth segment 524 to the anodes of the corresponding light-emission elements.

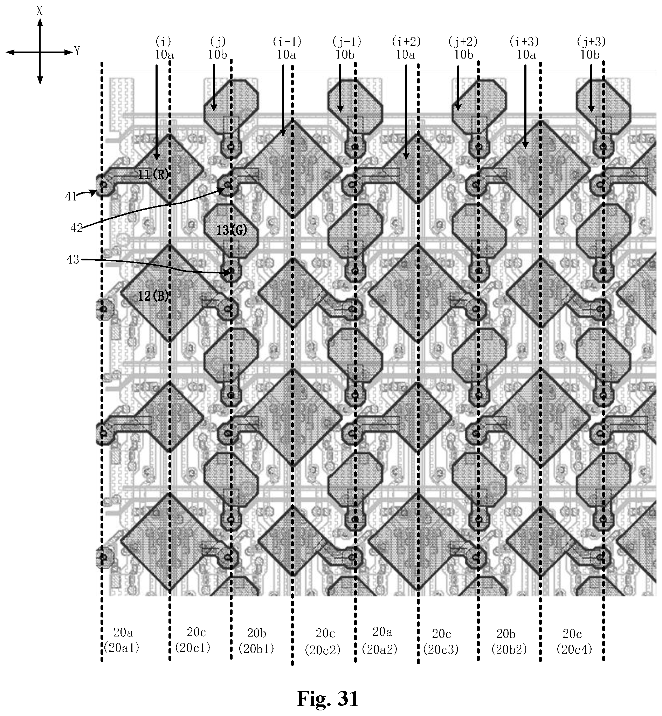

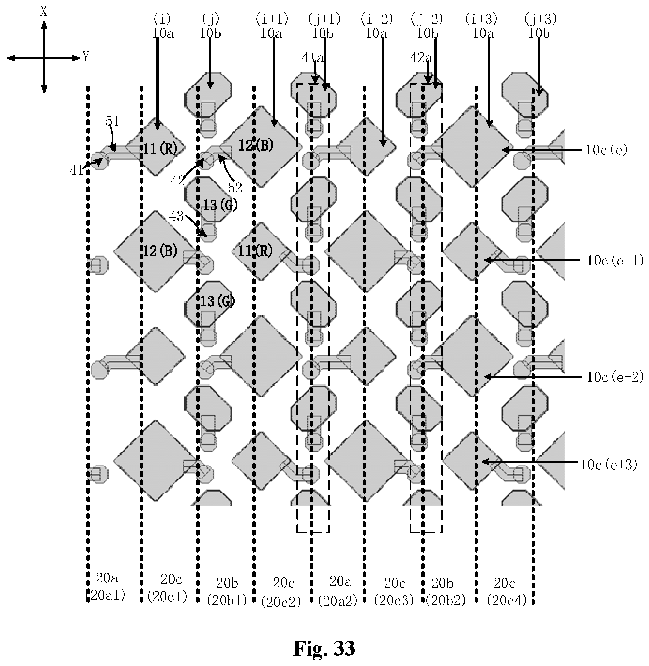

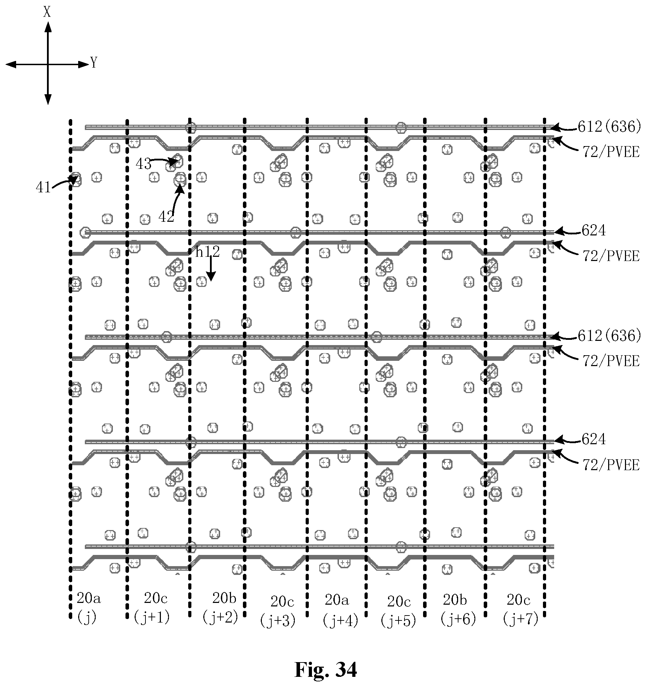

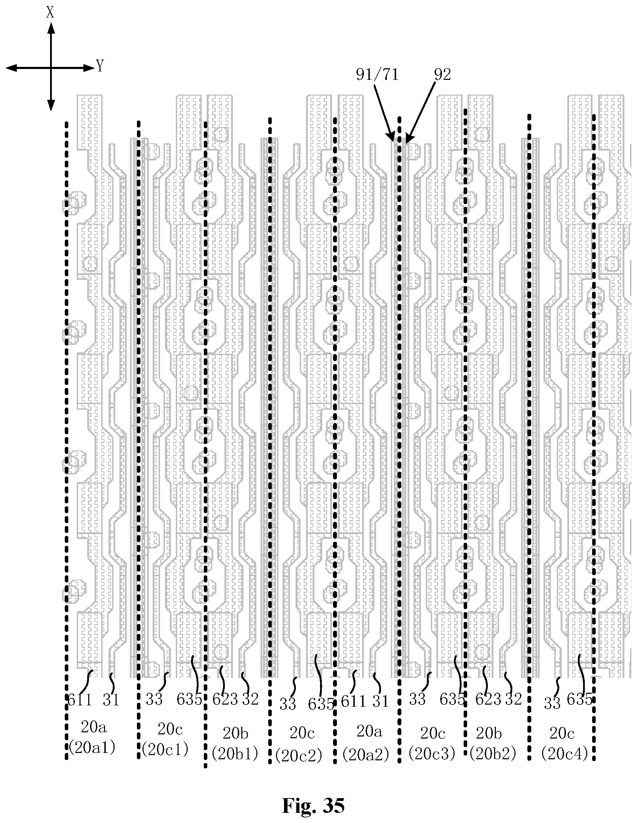

It should be noted that the implementation of Fig. 3 is not limited to the examples shown in Figs. 6 to 30. In other examples, the architecture shown in Fig. 3 may also be implemented by the specific structures shown in Figs. 31 to 35. For example, the cross-sectional structure of the display panel corresponding to the structures shown in Figs. 31 to 35 may also be as shown in Fig. 18. The structure in the layout shown in Fig. 34 is located in the third metal layer SD3 shown in Fig. 18, and the structure in the layout shown in Fig. 35 is located in the second metal layer SD2 shown in Fig. 18.

The similarities between the structures shown in Figs. 31 to 35 and those shown in Figs. 6 to 19 will not be repeated, but the differences include: the traces of the second metal layer and the third metal layer are interchanged. For example, in the structures shown in Figs. 6 to 19, the traces extending in the first direction X are arranged in the second metal layer SD2, and the traces extending in the second direction Y are arranged in the third metal layer SD3. In the structures shown in Figs. 31 to 35, the traces extending in the first direction X are arranged in the third metal layer SD3, and the traces extending in the second direction Y are arranged in the second metal layer SD2.

For example, as shown in Figs. 8, 22, and 33, the layouts of the anode layers may be roughly similar. Fig. 34 shows a layout structure of the third metal layer SD3, where the third metal layer SD3 may include traces extending in the first direction X, such as data lines 31 to 33, power branch lines 611, 623, and 635, and traces 91 and 92. Fig. 35 shows a layout structure of the second metal layer SD2, where the second metal layer SD2 may include traces extending in the second direction Y, such as power branch lines 612 and 624.

In some embodiments, with reference to Fig. 6, Fig. 20, or Fig. 31, in the thickness direction of the display panel, the first circuit column 20a overlaps at least some of the plurality of first light-emission elements 11 connected thereto, and the second circuit column 20b overlaps at least some of the plurality of second light-emission elements 12 connected thereto.

For example, for the first circuit column 20a that does not include the dummy pixel circuits, the plurality of first light-emission elements 11 connected to the first circuit column 20a are roughly alternately distributed on two sides, and the first circuit column 20a at least partially overlaps the first light-emission elements 11 on the second side.

For another example, the plurality of second light-emission elements 12 connected to the second circuit column 20b are roughly alternately distributed on two sides, and the second circuit column 20b at least partially overlaps the second light-emission elements 12 on the second side.

When the light-emission element overlaps the pixel circuit electrically connected thereto, the distance between the light-emission element and the pixel circuit is not too long, which can avoid an excessively long connection line between the light-emission element and the pixel circuit, so as to ensure the driving capability of the pixel circuit to the light-emission element.

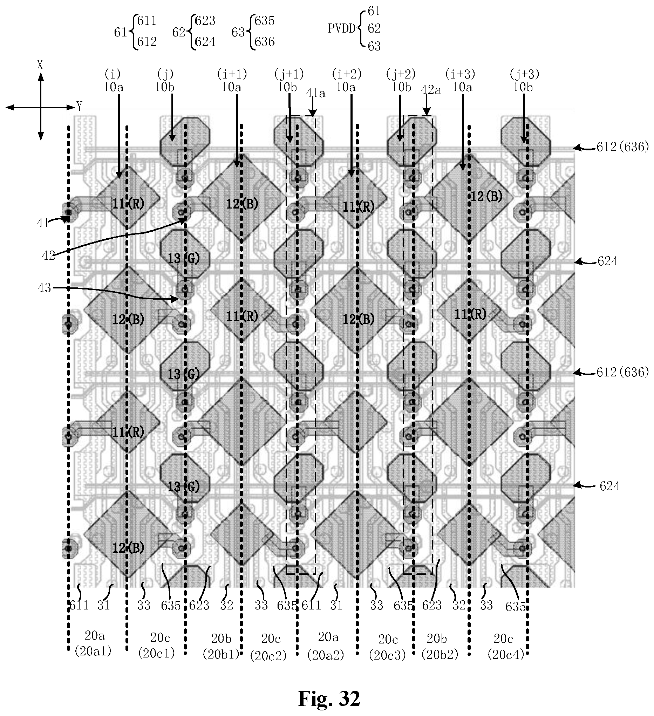

In some embodiments, with reference to Fig. 7 or Fig. 32, in the thickness direction of the display panel, a portion of the first unit column 10a at least partially overlaps the first data line 31 and the third data line 33, the other portion of the first unit column 10a at least partially overlaps the second data line 32 and the third data line 33, and the second unit column 10b does not overlap the data lines.

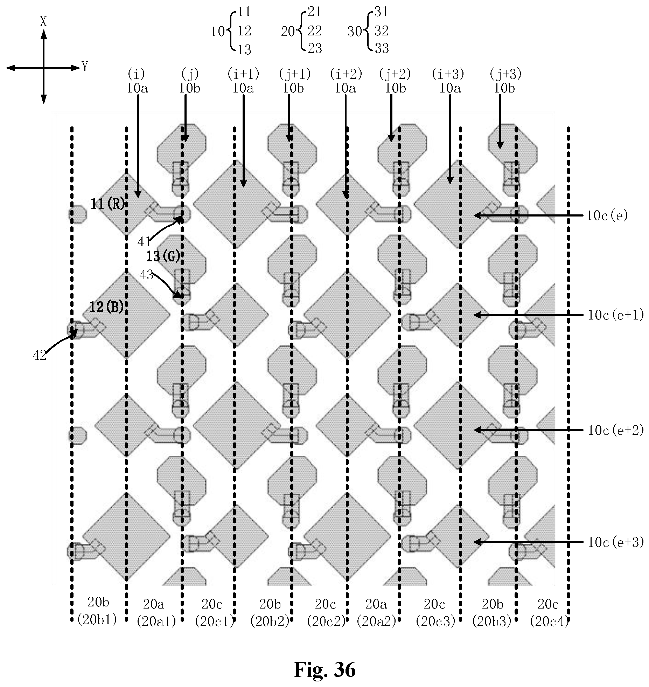

In some embodiments, the anode layout structure corresponding to the driving architecture shown in Fig. 4 may be as shown in Fig. 36, and the layout structures of other film layers corresponding to the driving architecture shown in Fig. 4 may be as shown in Figs. 6 to 17, or as shown in Figs. 20 to 28, or as shown in Figs. 31 to 35, which will not be repeated here.

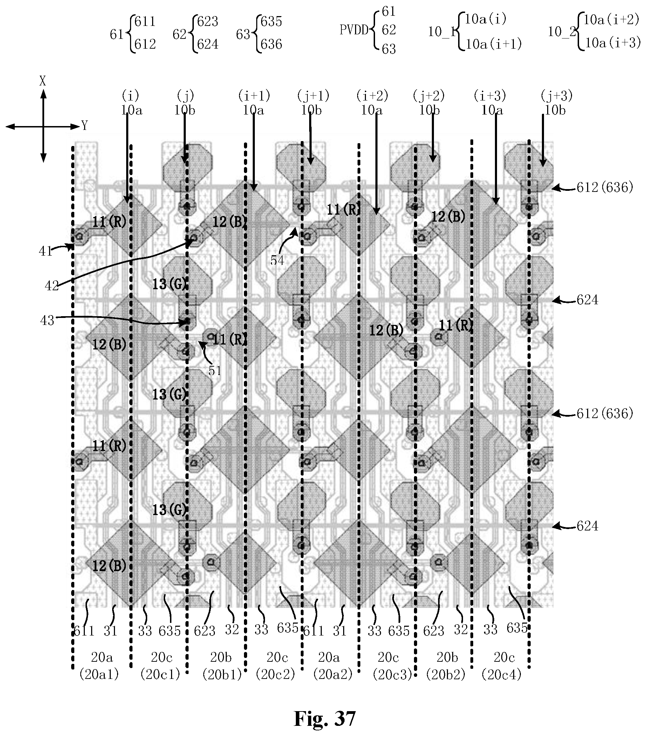

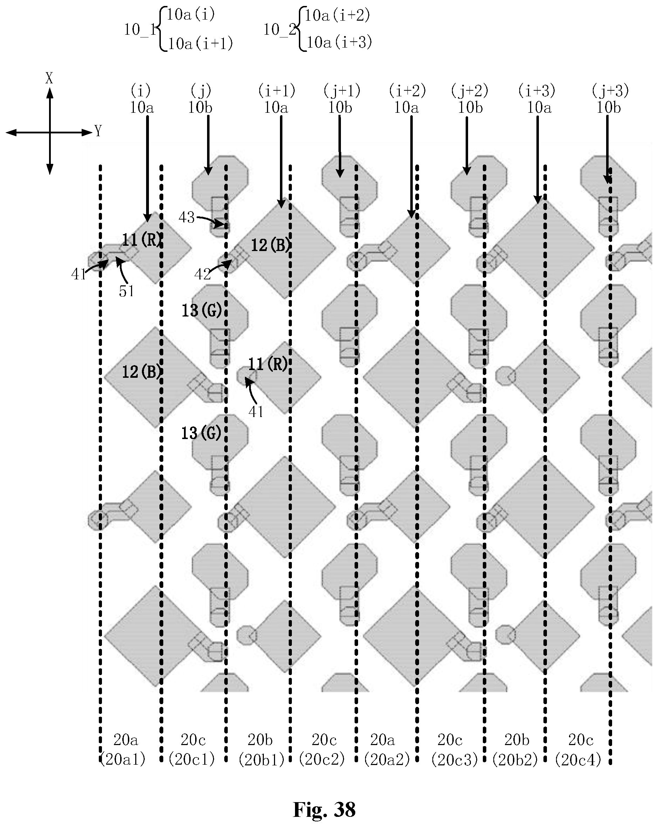

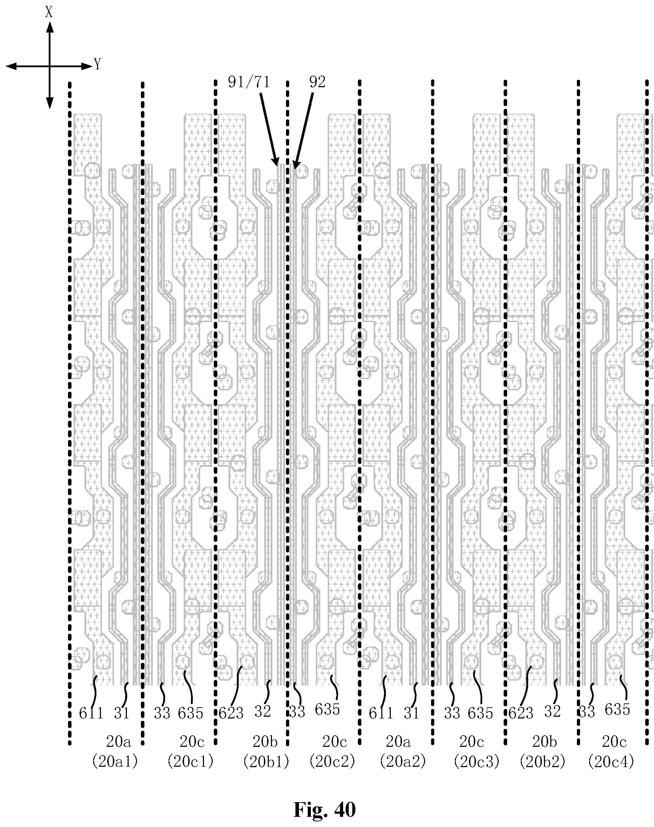

As shown in Fig. 5, the number of columns of the pixel circuits in the display panel is equal to the number of columns of the light-emission elements. In some embodiments, the driving architecture shown in Fig. 5 may be implemented by the design shown in Figs. 37 to 40.

Specifically, with reference to Figs. 37 to 40, two adjacent first unit columns 10a constitute a first unit column group, and the display panel includes a plurality of first unit column groups. For example, the (i)^{th} first unit column 10a and the (i+1)^{th} first unit column 10a constitute one first unit column group 10_1, and the (i+2)^{th} first unit column 10a and the (i+3)^{th} first unit column 10a constitute another first unit column group 10_2.

Each first circuit column 20a is electrically connected to the plurality of first light-emission elements 11 in the first unit column group, and each second circuit column 20b is electrically connected to the plurality of second light-emission elements 12 in the first unit column group.

That is, one first unit column group is correspondingly provided with one first circuit column 20a and one second circuit column 20b, each first circuit column 20a is configured to be connected to the first light-emission elements 11 in two unit columns, and each second circuit column 20b is configured to be connected to the second light-emission elements 12 in two unit columns, such that the number of columns of the pixel circuits in the display panel is equal to the number of columns of the light-emission elements. In such design, an additional column of pixel circuits and dummy pixel circuits are not required, which is beneficial to achieving narrow borders.

When the number of columns of the pixel circuits is equal to the number of columns of the light-emission elements, each first circuit column needs to be electrically connected to the first light-emission elements in two unit columns. As such, for at least some first light-emission elements, connection lines are required to connect the first light-emission elements to the first pixel circuits. The longer the connection lines, the greater the voltage drop, which will affect the driving capability of the first pixel circuits to the first light-emission elements. Similarly, the second light-emission element and the second pixel circuits electrically connected thereto also encounter the same situation. Therefore, for the design shown in Fig. 5, it is also important to balance the driving capability of the pixel circuits while reducing the power consumption.

In view of this, in some embodiments, with reference to Figs. 5, 37, and 38, the first light-emission element 11 is electrically connected to the first pixel circuit 21 by a first via 41. A first end of the first via 41 extends to the film layer where the anode of the first light-emission element 11 is located, and a second end of the first via 41 is electrically connected to the first pixel circuit 21. The second light-emission element 12 is electrically connected to the second pixel circuit 22 by a second via 42, and a plurality of the second vias 42 corresponding to the same second circuit column 20b constitute a second via column 42a. A first end of the second via 42 extends to the film layer where the anode of the second light-emission element 12 is located, and a second end of the second via 42 is electrically connected to the second pixel circuit 22.

In the first unit column group, in the second direction Y, the first via 41 of one of the first unit columns 10a is on a first side of the first unit column 10a, the second via 42 is on a second side of the first unit column, and the first via 41 and the second via 42 of the other first unit column 10a are distributed on the same side of the first unit column.

For example, the (i)^{th} first unit column 10a and the (i+1)^{th} first unit column 10a constitute one first unit column group 10_1, where in the (i)^{th} first unit column 10a, the first vias 41 are on the left side and the second vias 42 are on the right side; in the (i+1)^{th} first unit column 10a, the first vias 41 and the second vias 42 are both on the left side.

The (i+2)^{th} first unit column 10a and the (i+3)^{th} first unit column 10a constitute another first unit column group 10_2, where in the (i+2)^{th} first unit column 10a, the first vias 41 are on the left side and the second vias 42 are on the right side; in the (i+3)^{th} first unit column 10a, the first vias 41 and the second vias 42 are both on the left side.

Understandably, in this embodiment, the first vias of the first light-emission elements connected to the same first circuit column and located in two first unit columns are all arranged towards a direction close to the first circuit column, which can reduce the lengths of connection lines between the first light-emission elements and the first pixel circuits, thereby avoiding large voltage drop caused by excessively long connection lines, reducing the power consumption, and balancing the driving capability of the first pixel circuits. The second light-emission element follows the same way, and will not be repeated here.

In some embodiments, with reference to Figs. 37, 38, and 39, the first light-emission element 11 is electrically connected to the first pixel circuit by the first connection line 51, and the first connection line 51 and the data line of the display panel are located in different film layers.

For example, for the first light-emission element 11 in the (i+1)^{th} and (i+3)^{th} first unit columns 10a, the first connection line 51 needs to be arranged in the metal layer below the anode, where the first connection line 51 is used for connecting the first light-emission element 11 with the first pixel circuit. Specifically, the first end of the first connection line 51 is connected to the first via 41, the other end is connected to the first pixel circuit, and the other end of the first via 41 is connected to the anode of the first light-emission element 11.

In some embodiments, in the thickness direction of the display panel, the first connection line 51 at least partially overlaps the second light-emission element 12. Such design can avoid winding the first connection line and reduce the length of the first connection line, thereby reducing voltage drop.

For example, the film layer structures corresponding to Figs. 37 to 40 may be as shown in Fig. 18. In Figs. 37 to 40, the data lines include first data lines 31, second data lines 32, and third data lines 33. The first data lines 31, the second data lines 32, and the third data lines 33 are located in the second metal layer SD2 as shown in Fig. 18, and first connection lines 51 are provided in the third metal layer SD3, so that the first connection lines 51 and the data lines are located in different film layers.

In some embodiments, with reference to Figs. 5, 37, and 18, in the thickness direction of the display panel, at least some of the second light-emission elements 12 at least partially overlap the second pixel circuits 22 electrically connected thereto, and the display panel includes at least two semiconductor layers, namely, a first semiconductor layer B1 and a second semiconductor layer B2. Here, "overlap" indicates that at least portions overlap in the thickness direction of the display panel.

For example, the second light-emission element 12 in the (i+1)^{th} first unit column 10a at least partially overlaps the second pixel circuit in the 1^{st} second circuit column 20b1. The 1^{st} second circuit column 20b1 is also configured to drive the second light-emission element 12 in the (i)^{th} first unit column 10a. For the (i)^{th} first unit column 10a, the second via 42 is located on the side close to the 1^{st} second circuit column 20b1, so that there is no need for an excessively long connection line to connect each second light-emission element to the second pixel circuit.

The connection line arranged in the metal layer below the anode is referred to as a "lead-out line" of the light-emission element. In this embodiment, only the first light-emission elements 11 in the (i+1)^{th} and (i+3)^{th} first unit columns 10a need the design of a "lead-out line", while the second light-emission element 12 or the third light-emission element 13 does not need the design of a "lead-out line". From this perspective, it is equivalent to that the embodiment of the present application reduces the lengths of connection lines required for the second light-emission element 12 and the third light-emission element 13. The anodes of some of the second light-emission elements 12 or the third light-emission elements 13 are connected to the pixel circuits without the need of connection lines but directly by the vias.

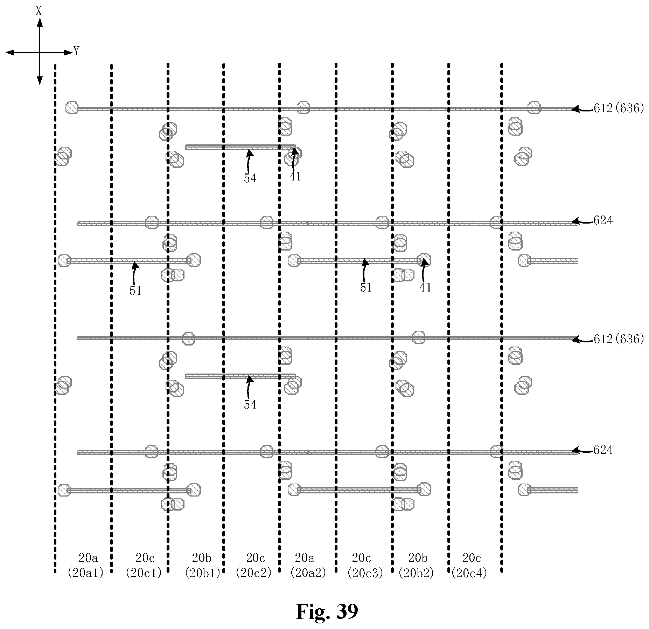

In addition, as introduced above, the first light-emission element 11 in the (i+1)^{th} and (i+3)^{th} first unit columns 10a need the design of a "lead-out line", which refers to the first connection line 51 shown in Fig. 37 and Fig. 39. If the first light-emission element 11 in the (i)^{th} and (i+2)^{th} first unit columns 10a does not need the design of a "lead-out line", the voltage drops (or loading) corresponding to different first light-emission elements 11 are different, which affects display uniformity. In view of this, a compensation line 54 may be configured for the first light-emission element 11 in the (i)^{th} and (i+2)^{th} first unit columns 10a, and the compensation line 54 is connected to the first via of the first light-emission element 11 in the (i)^{th} and (i+2)^{th} first unit columns 10a. For example, the other end of the compensation line 54 is suspended. The compensation line 54 is arranged on the same layer as the first connection line 51 located in the metal layer.

For example, the first connection lines 51 and the compensation lines 54 corresponding to the first light-emission elements connected to the same first circuit column are alternately arranged in the first direction.

It should be noted that the structure shown in Fig. 18 is introduced above and will not be repeated here. In addition, in the design corresponding to Figs. 37 to 40, the structures of other film layers may be as shown in Figs. 11 to 17, respectively.

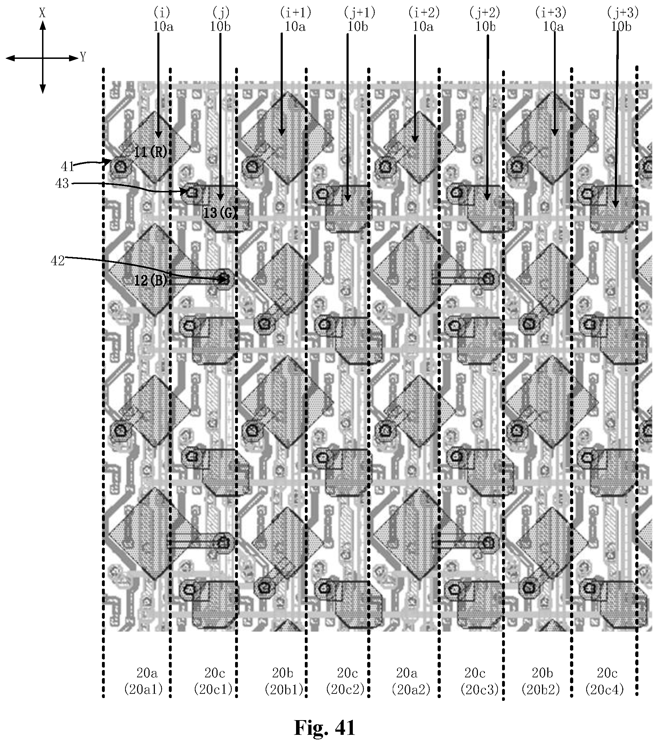

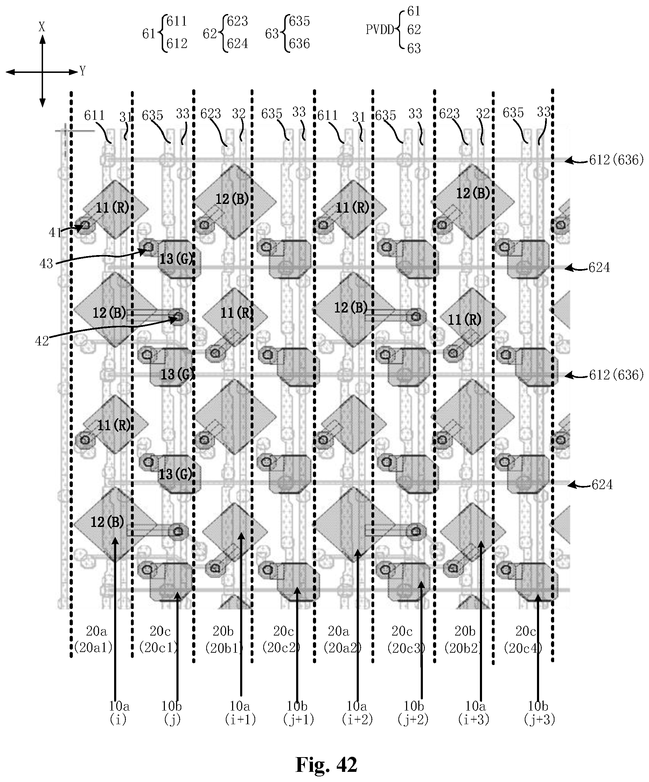

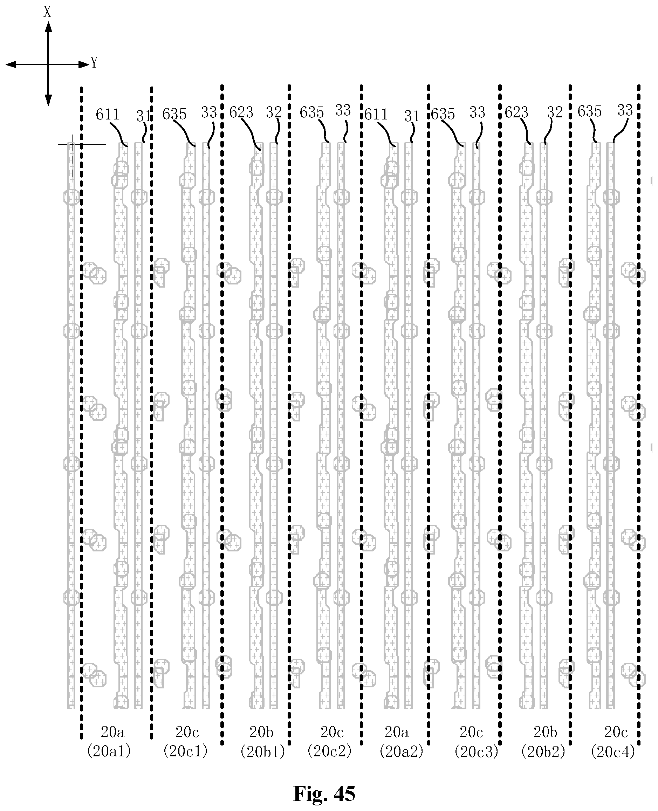

In other embodiments, the driving architecture shown in Fig. 5 may be implemented by the design shown in Figs. 41 to 45.

With reference to Fig. 5 and Figs. 41 to 45, the first light-emission element 11 is electrically connected to the first pixel circuit 21 by the first connection line 51, the second light-emission element 12 is electrically connected to the second pixel circuit 22 by the second connection line 52, at least some line segments of the first connection lines 51 and at least some line segments of the second connection lines 52 are located in different film layers from the data lines of the display panel, and the display panel includes one semiconductor layer.

For example, the film layer structures corresponding to Figs. 41 to 45 may be as shown in Fig. 29. In Figs. 41 to 45, the data lines include first data lines 31, second data lines 32, and third data lines 33. The first data lines 31, the second data lines 32, and the third data lines 33 are located in the second metal layer SD2 as shown in Fig. 29, and at least some line segments of the first connection lines 51 and at least some line segments of the second connection lines 52 are provided in the third metal layer SD3, so that at least some line segments of the first connection lines 51 and at least some line segments of the second connection lines 52 are located in a film layer different from that where the data lines are located, thereby avoiding crosstalk between the connection lines and the data lines.

For the LTPS type display panel, a non-mirror design is adopted. Even if the vias of the light-emission elements are all located on the sides of the light-emission elements facing the pixel circuits connected thereto, the light-emission elements are designed as close as possible to the pixel circuits connected thereto. However, in the non-mirror design, some light-emission elements are still relatively far from the pixel circuits connected thereto. If a connection line is still completely arranged on the anode film layer, the connection line needs to bypass the anodes of the light-emission elements of other colors, such that the connection line is longer to increase its voltage drop, which will weaken the driving capability of the first pixel circuit for the first light-emission element. The second light-emission element follows the same way, and will not be repeated here.

In view of this, at least some first connection lines and at least some second connection lines can be designed by spanning (the traces are arranged in at least two film layers).

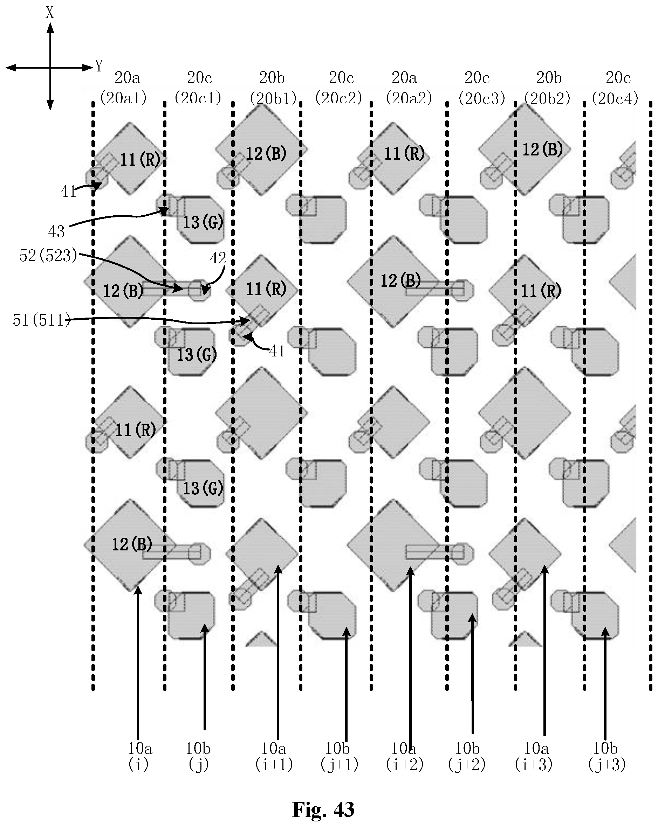

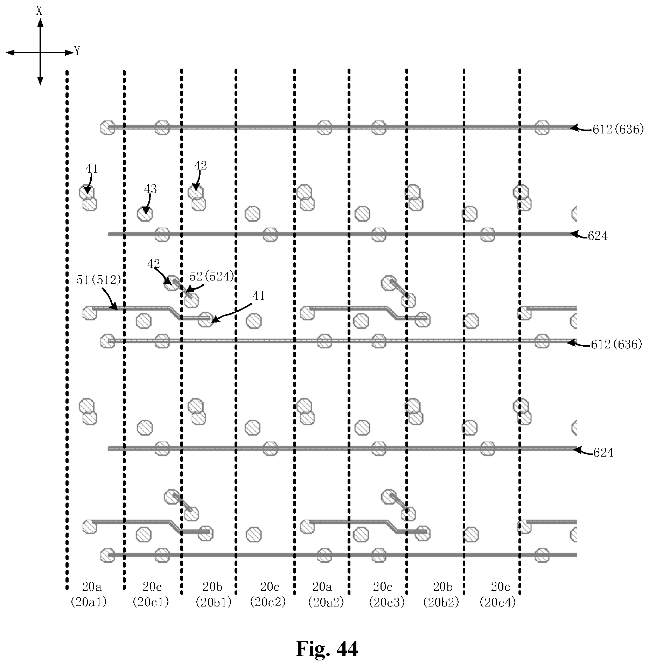

Specifically, with reference to Fig. 43 and Fig. 44, for the (i+1)^{th} first unit column 10a and the (i+3)^{th} first unit column 10a, the first connection line 51 includes a first segment 511 and a second segment 512, the first segment 511 is connected between the anode of the first light-emission element 11 and the first end of the first via 41, the second segment 512 is connected between the second end of the first via 41 and the first pixel circuit, the first segment 511 and the anode of the first light-emission element 11 are located in the same film layer, and the second segment 512 is located in the metal layer on the side where the anode of the first light-emission element 11 faces the substrate.

For the (i)^{th} first unit column 10a and the (i+2)^{th} first unit column 10a, the second connection line 52 includes a third segment 523 and a fourth segment 524, the third segment 523 is connected between the anode of the second light-emission element 12 and the first end of the second via 42, the fourth segment 524 is connected between the second end of the second via 42 and the second pixel circuit, the third segment 523 and the anode of the second light-emission element 12 are located in the same film layer, and the fourth segment 524 is located in the metal layer on the side where the anode of the second light-emission element 12 faces the substrate.

In the embodiment of the present application, because the second segment 512 and the fourth segment 524 are located in the metal layers below the anodes, the lengths of the connection lines in the anode film layer can be reduced, and the connection lines in the metal layer are less constrained by the anodes. The routing form of the connection lines can be set according to proximity-based connection. The second segment 512 and the fourth segment 524 do not need to meander due to the constraint of the anodes, which can reduce the total length of the first connection line and the total length of the second connection line. In addition, the problem of possible short circuits caused by direct pull lines at the anodes can be avoided.

For example, with reference to Fig. 43 and Fig. 44, for the (i+1)^{th} first unit column 10a and the (i+3)^{th} first unit column 10a, connection lines only for connecting the second light-emission elements 12 and the second pixel circuits can be arranged in the anode film layer. For the (i)^{th} first unit column 10a and the (i+2)^{th} first unit column 10a, connection lines only for connecting the first light-emission elements 11 and the first pixel circuits can be arranged in the anode film layer.

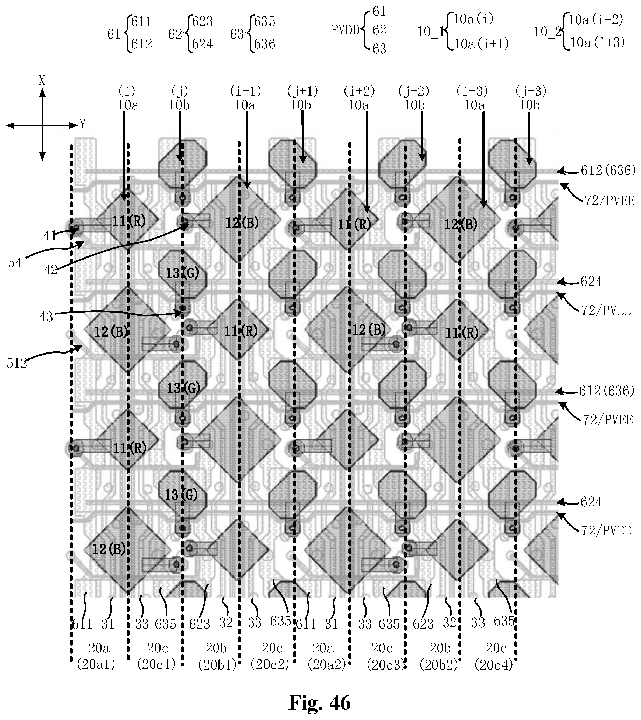

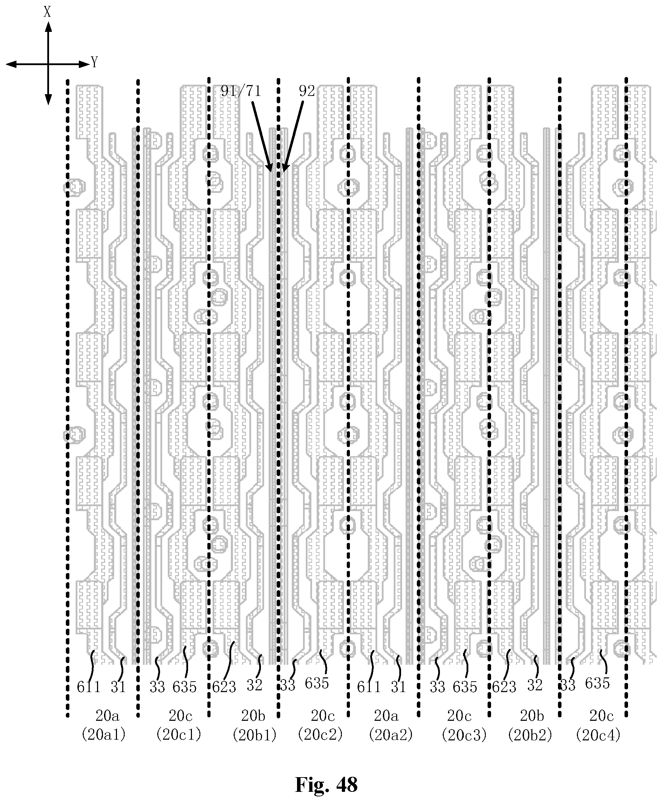

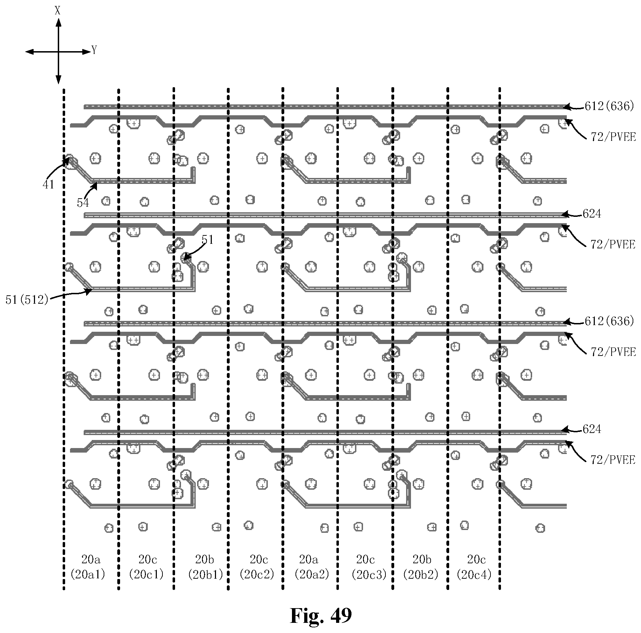

In other embodiments, the driving architecture shown in Fig. 5 may also be implemented by the design shown in Figs. 46 to 49. For example, the cross-sectional structure of the display panel corresponding to the structures shown in Figs. 46 to 49 may also be as shown in Fig. 18. The structure in the layout shown in Fig. 48 is located in the second metal layer SD2 shown in Fig. 18, and the structure in the layout shown in Fig. 49 is located in the third metal layer SD3 shown in Fig. 18.

The similarities between the structures shown in Fig. 46 to Fig. 49 and those shown in Figs. 37 to 40 will not be repeated, but the differences include: the traces of the second metal layer and the third metal layer are interchanged. For example, in the structures shown in Figs. 37 to 40, the traces extending in the first direction X are arranged in the second metal layer SD2, and the traces extending in the second direction Y are arranged in the third metal layer SD3. In the structures shown in Figs. 46 to 49, the traces extending in the first direction X are arranged in the third metal layer SD3, and the traces extending in the second direction Y are arranged in the second metal layer SD2.

For example, Fig. 48 shows a layout structure of the third metal layer SD3, where the third metal layer SD3 includes data lines 31 to 33, power branch lines 611, 623, and 635, and traces 91 and 92, which each extend in the first direction X. Fig. 49 shows a layout structure of the second metal layer SD2, where the second metal layer SD2 includes power branch lines 612 and 624, traces 72, etc., which each extend in the second direction.

Moreover, in Figs. 46 to 49, the first light-emission element 11 in the (i+1)^{th} and (i+3)^{th} first unit columns 10a need the design of a "lead-out line", which refers to the second segment 512 shown in Fig. 46 and Fig. 49. If the first light-emission element 11 in the (i)^{th} and (i+2)^{th} first unit columns 10a does not need the design of a "lead-out line", the voltage drops (or loading) corresponding to different first light-emission elements 11 are different, which affects display uniformity. In view of this, a compensation line 54 may be configured for the first light-emission element 11 in the (i)^{th} and (i+2)^{th} first unit columns 10a, and the compensation line 54 is connected to the first via of the first light-emission element 11 in the (i)^{th} and (i+2)^{th} first unit columns 10a. For example, the other end of the compensation line 54 is suspended. The compensation line 54 is arranged on the same layer as the second segment 512 located in the metal layer.

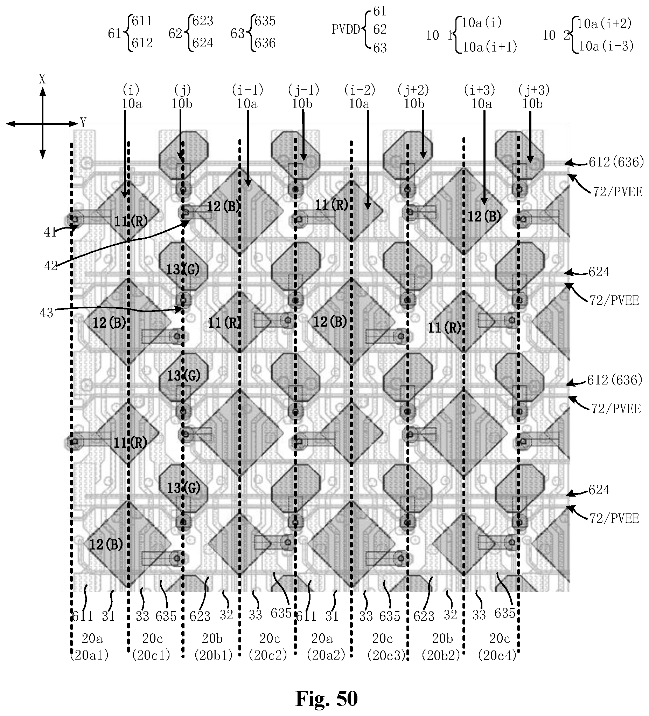

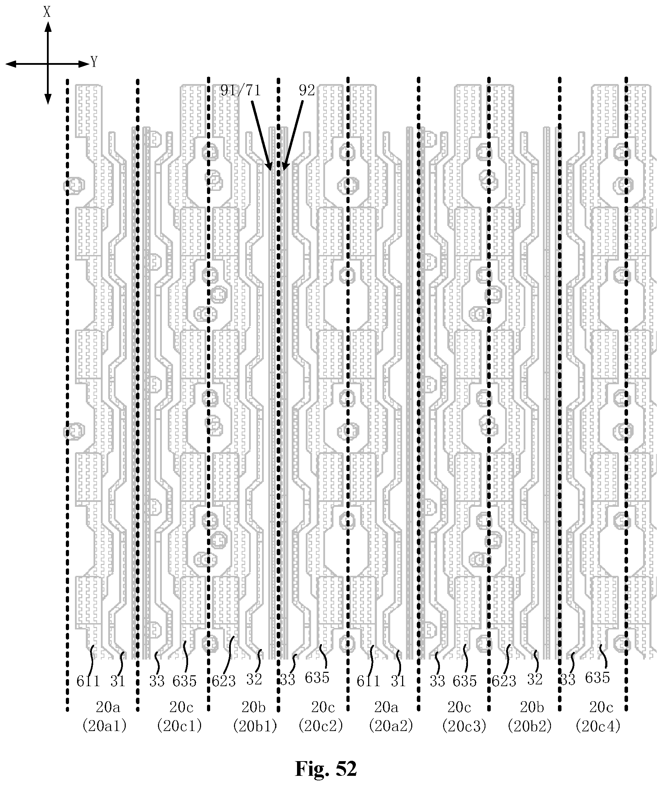

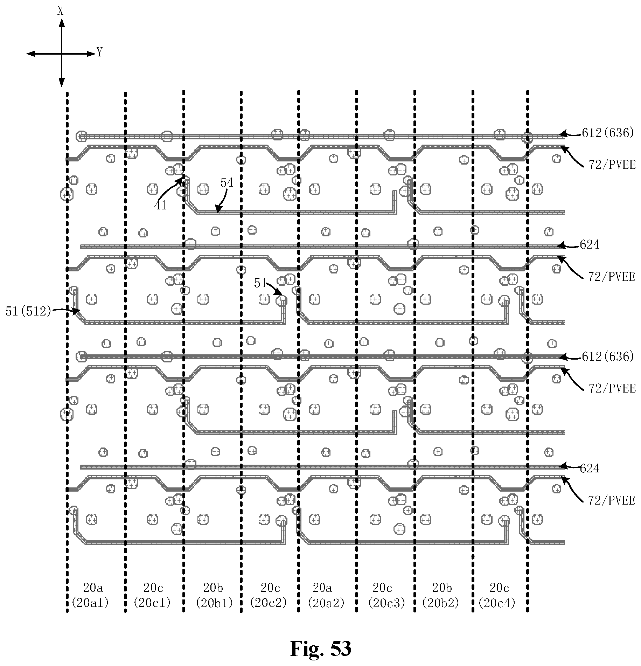

In other embodiments, the driving architecture shown in Fig. 5 may also be implemented by the design shown in Figs. 50 to 53. For example, the cross-sectional structure of the display panel corresponding to the structures shown in Figs. 50 to 53 may also be as shown in Fig. 18. The structure in the layout shown in Fig. 52 is located in the second metal layer SD2 shown in Fig. 18, and the structure in the layout shown in Fig. 53 is located in the third metal layer SD3 shown in Fig. 18.

The similarities between the structures shown in Figs. 50 to 53 and those shown in Figs. 37 to 40 will not be repeated, but the differences include: the traces of the second metal layer and the third metal layer are interchanged. For example, in the structures shown in Figs. 37 to 40, the traces extending in the first direction X are arranged in the second metal layer SD2, and the traces extending in the second direction Y are arranged in the third metal layer SD3. In the structures shown in Figs. 50 to 53, the traces extending in the first direction X are arranged in the third metal layer SD3, and the traces extending in the second direction Y are arranged in the second metal layer SD2.

For example, Fig. 52 shows a layout structure of the third metal layer SD3, where the third metal layer SD3 includes data lines 31 to 33, power branch lines 611, 623, and 635, and traces 91 and 92, which each extend in the first direction X. Fig. 53 shows a layout structure of the second metal layer SD2, where the second metal layer SD2 includes power branch lines 612, 624, traces 72, etc. which each extend along the second direction.

In some embodiments, with reference to Fig. 5 and Figs. 50 to 53, the first light-emission element 11 is electrically connected to the first pixel circuit 21 by the first via 41, and the second light-emission element 12 is electrically connected to the second pixel circuit 22 by the second via 42. In addition, the third light-emission element 13 is electrically connected to the third pixel circuit 23 by a third via 43.

In the second direction Y, the first via 41 of any first unit column 10a is on the first side of the first unit column 10a, and the second via 42 is on the second side of the first unit column 10a.

For example, for the (i)^{th} and (i+2)^{th} first unit columns 10a, the first vias 41 are on the left side, and the second vias 42 are on the right side. For the (i+1)^{th} and (i+3)^{th} first unit columns 10a, the first vias 41 are on the right side, and the second vias 42 are on the left side.

For example, in the first direction X, the third vias 43 are on the same side of the third light-emission elements 13 connected thereto.

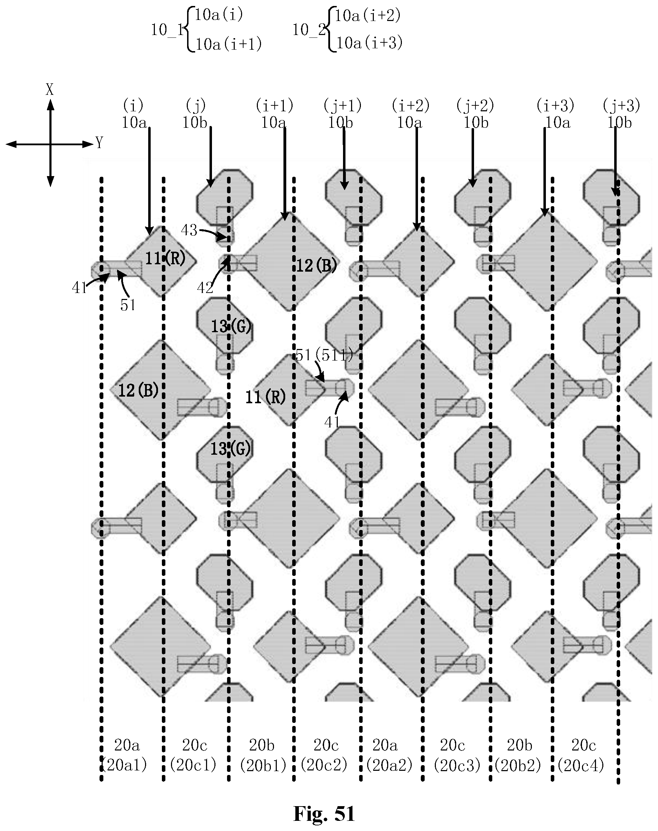

With reference to Fig. 51, in this embodiment, excessively dense vias corresponding to the first unit column 10a on the same side can be avoided. The excessively dense vias need to occupy more layout space, which is not conducive to increasing pixel density. Therefore, the embodiment of the present application is conducive to increasing pixel density and can eliminate signal interference between different vias.

From the accompanying drawings, in the structures shown in Figs. 50 to 53 and Figs. 46 to 49, the distribution rules of the second vias and the third vias are the same, but the distribution rules of the first vias 41 in the (i)^{th} and (i+2)^{h} first unit columns 10a are different. In the structures shown in Figs. 46 to 49, the first vias 41 of the (i)^{th} and (i+2)^{th} first unit columns 10a are all on the left sides of the first light-emission elements connected thereto. In the structures shown in Figs. 50 to 53, the first vias 41 of the (i)^{th} and (i+2)^{th} first unit columns 10a are all on the right sides of the first light-emission elements connected thereto.

When the first pixel circuits connected to the first light-emission elements of the (i)^{th} and (i+2)^{th} first unit columns 10a are on the left side, and the first vias 41 of the (i)^{th} and (i+2)^{h} first unit columns 10a are shifted to the right sides of the first light-emission elements connected thereto, the distance between the first via 41 and the first pixel circuit electrically connected thereto increases, which can increase the length of the connection line between the first via 41 and the first pixel circuit.

In some embodiments, with reference to Fig. 51 and Fig. 53, the first light-emission element 11 is electrically connected to the first pixel circuit via the first connection line 51, the length of the first connection line 51 connected between the first via 41 and the first pixel circuit in the second direction Y is L1, the width of the pixel circuit of the display panel in the second direction Y is L2, and 3*L2 ≤ L1 ≤ 4*L2. The widths of the first pixel circuit, the second pixel circuit, and the third pixel circuit in the second direction are the same, and the widths of the first circuit column, the second circuit column, and the third circuit column in the second direction Y are approximately L2.

In this embodiment, the first connection line 51 may also include a first segment 511 and a second segment 512, the first segment 511 is connected between the anode of the first light-emission element 11 and the first end of the first via 41, the second segment 512 is connected between the second end of the first via 41 and the first pixel circuit, the first segment 511 and the anode of the first light-emission element 11 are located in the same film layer, and the second segment 512 is located in the metal layer on the side where the anode of the first light-emission element 11 faces the substrate. In this embodiment, the second segment 512 is located in the second metal layer.

The length of the second segment 512 in the second direction Y is L1. As shown in Fig. 52, in the second direction Y, the second segment 512 needs to span approximately 3 to 4 circuit columns.

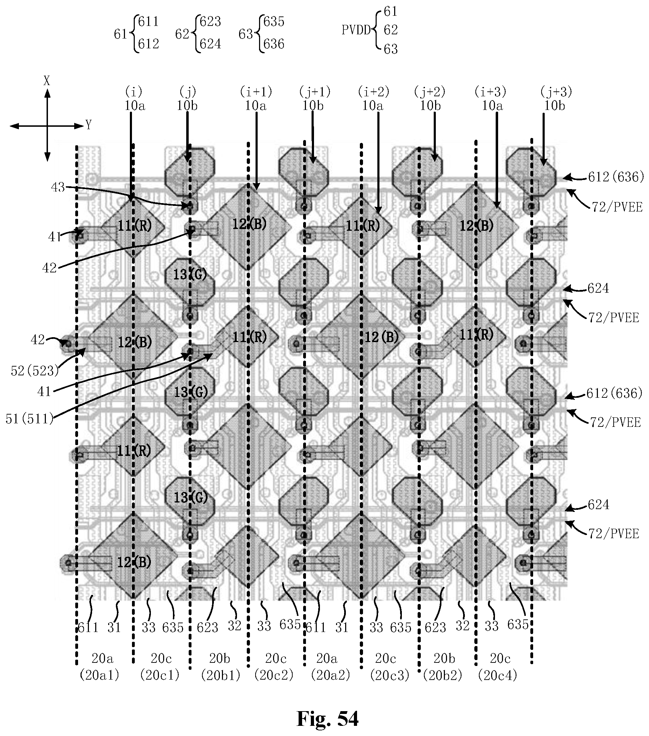

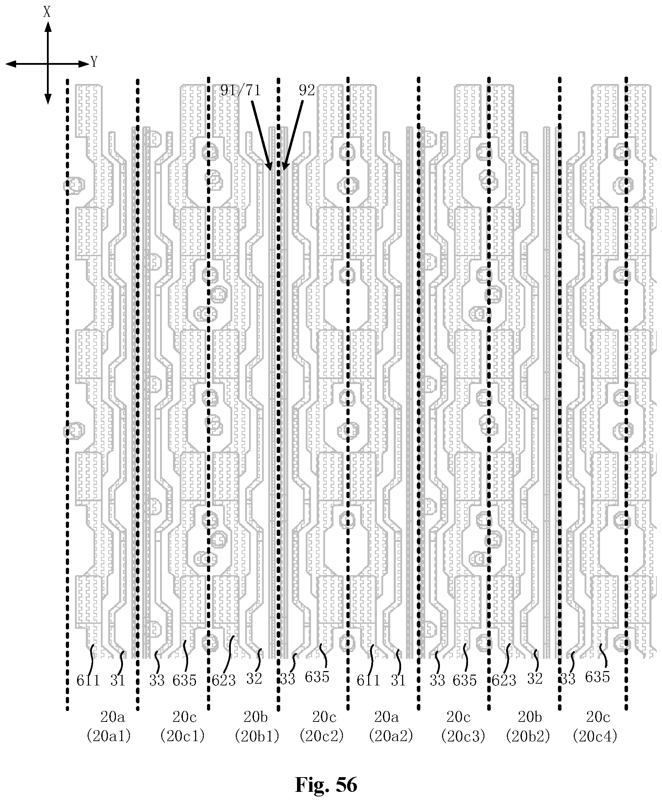

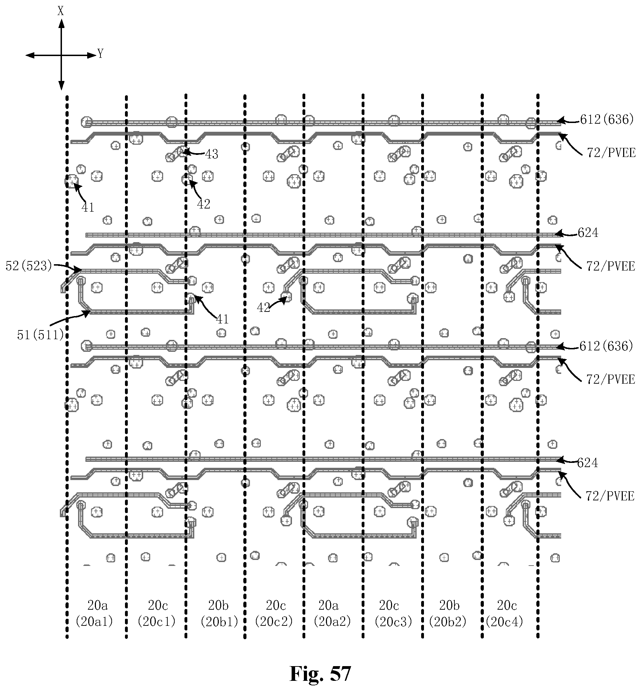

In other embodiments, the driving architecture shown in Fig. 5 may also be implemented by the design shown in Figs. 54 to 57. For example, the cross-sectional structure of the display panel corresponding to the structures shown in Figs. 54 to 57 may also be as shown in Fig. 18. The structure in the layout shown in Fig. 56 is located in the second metal layer SD2 shown in Fig. 18, and the structure in the layout shown in Fig. 57 is located in the third metal layer SD3 shown in Fig. 18.

The similarities between the structures shown in Figs. 54 to 57 and those shown in Figs. 37 to 40 will not be repeated, but the differences include: the traces of the second metal layer and the third metal layer are interchanged. For example, in the structures shown in Figs. 37 to 40, the traces extending in the first direction X are arranged in the second metal layer SD2, and the traces extending in the second direction Y are arranged in the third metal layer SD3. In the structures shown in Figs. 54 to 57, the traces extending in the first direction X are arranged in the third metal layer SD3, and the traces extending in the second direction Y are arranged in the second metal layer SD2.

For example, Fig. 56 shows a layout structure of the third metal layer SD3, where the third metal layer SD3 includes data lines 31 to 33, power branch lines 611, 623, and 635, and traces 91 and 92, which each extend in the first direction X. Fig. 57 shows a layout structure of the second metal layer SD2, where the second metal layer SD2 includes power branch lines 612, 624, traces 72, etc., which each extend along the second direction.

In some embodiments, with reference to Fig. 5 and Figs. 54 to 57, the first light-emission element 11 is electrically connected to the first pixel circuit 21 by the first via 41, and the second light-emission element 12 is electrically connected to the second pixel circuit 22 by the second via 42. In addition, the third light-emission element 13 is electrically connected to the third pixel circuit 23 by a third via 43.

In the second direction Y, the first via 41 and the second via 42 of any first unit column 10a are distributed on the same side of the first unit column 10a.

For example, for the (i)^{th}, (i+1)^{th}, (i+2)^{th}, and (i+3)^{th} first unit columns 10a, the first vias 41 and the second vias 42 are all on the left side.

For example, in the first direction X, the third vias 43 are on the same side of the third light-emission elements 13 connected thereto.

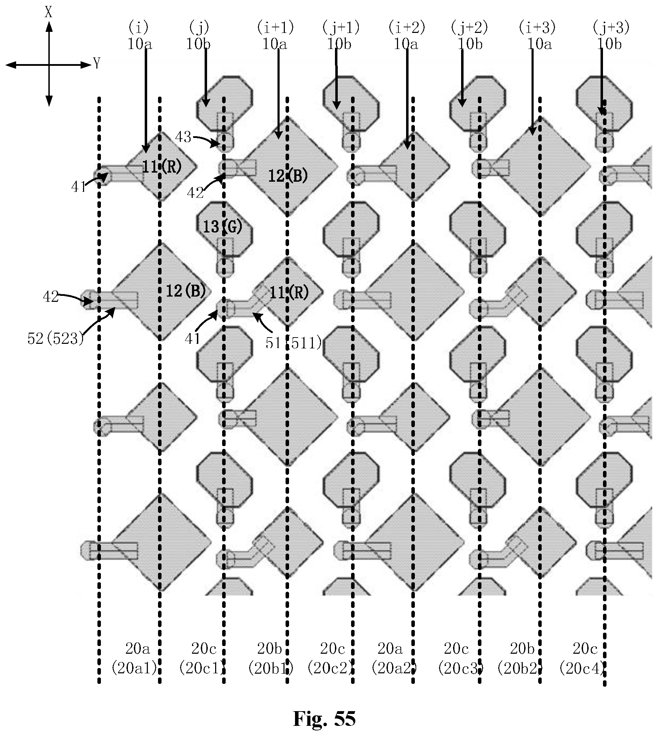

With reference to Fig. 55, in this embodiment, excessively dense vias corresponding to the first unit column 10a on the same side can also be avoided. The excessively dense vias need to occupy more layout space, which is not conducive to increasing pixel density. Therefore, the embodiment of the present application is conducive to increasing pixel density and can eliminate signal interference between different vias.

From the accompanying drawings, in the structures shown Figs. 54 to 57 and Figs. 46 to 49, the distribution rules of the first vias and the third vias are the same, but the distribution rules of the second vias 42 are different. For example, in the structures shown in Figs. 46 to 49, the second vias 42 of the (i)^{th} and (i+2)^{th} first unit columns 10a are all on the right sides of the second light-emission elements connected thereto, and the second vias 42 of the (i+1)^{th} and (i+3)^{th} first unit columns 10a are all on the left sides of the second light-emission elements connected thereto. In the structures shown in Figs. 50 to 53, the second via 42 of each first unit column 10a is on the left side of the first light-emission element connected thereto.

When the second pixel circuits connected to the second light-emission elements of the (i)^{th} and (i+2)^{th} first unit columns 10a are on the right side, and the second vias 42 of the (i)^{th} and (i+2)^{th} first unit columns 10a are shifted to the left sides of the second light-emission elements connected thereto, the distance between the second via 42 and the second pixel circuit electrically connected thereto increases, which can increase the length of the connection line between the second via 42 and the second pixel circuit. In addition, connection lines are also required to connect the first light-emission elements of the (i+1)^{th} and (i+3)^{th} first unit columns 10a and the first pixel circuits connected thereto.

In some embodiments, with reference to Fig. 55 and Fig. 57, the first light-emission element 11 is electrically connected to the first pixel circuit by the first connection line 51, the second light-emission element 12 is electrically connected to the second pixel circuit by the second connection line 52, and the first connection line 51 and the second connection line 52 do not overlap.

In this embodiment, the first connection line 51 may include a first segment 511 and a second segment 512, the first segment 511 is connected between the anode of the first light-emission element 11 and the first end of the first via 41, the second segment 512 is connected between the second end of the first via 41 and the first pixel circuit, the first segment 511 and the anode of the first light-emission element 11 are located in the same film layer, and the second segment 512 is located in the metal layer on the side where the anode of the first light-emission element 11 faces the substrate.

The second connection line 52 includes a third segment 523 and a fourth segment 524, the third segment 523 is connected between the anode of the second light-emission element 12 and the first end of the second via 42, the fourth segment 524 is connected between the second end of the second via 42 and the second pixel circuit, the third segment 523 and the anode of the second light-emission element 12 are located in the same film layer, and the fourth segment 524 is located in the metal layer on the side where the anode of the second light-emission element 12 faces the substrate.

In this embodiment, the second segment 512 and the fourth segment 524 are located in the second metal layer.

The first segment 511 does not overlap the third segment 523, and the second segment 512 does not overlap the fourth segment 524.

In this embodiment, the lengths of the second segment 512 and the fourth segment 524 in the second direction Y are approximately equal. The lengths of the second segment 512 and the fourth segment 524 in the second direction Y are approximately twice the width L2 of the pixel circuit.

In some embodiments, as shown in Fig. 54, the third light-emission element 13 is electrically connected to the third pixel circuit by the third via 43, and any third via 43 is on the same side as the third light-emission element 13 connected thereto. That is, the distribution rule of the plurality of third vias in the entire display panel is the same.

For example, as shown in Figs. 6, 31, 37, 46, 50, and 54, in the first direction X, any third via 43 is on a lower side of the third light-emission element 13 connected thereto.

For another example, as shown in Fig. 20 and Fig. 41, in the second direction Y, any third via 43 is located on the left side of the third light-emission element 13 connected thereto.

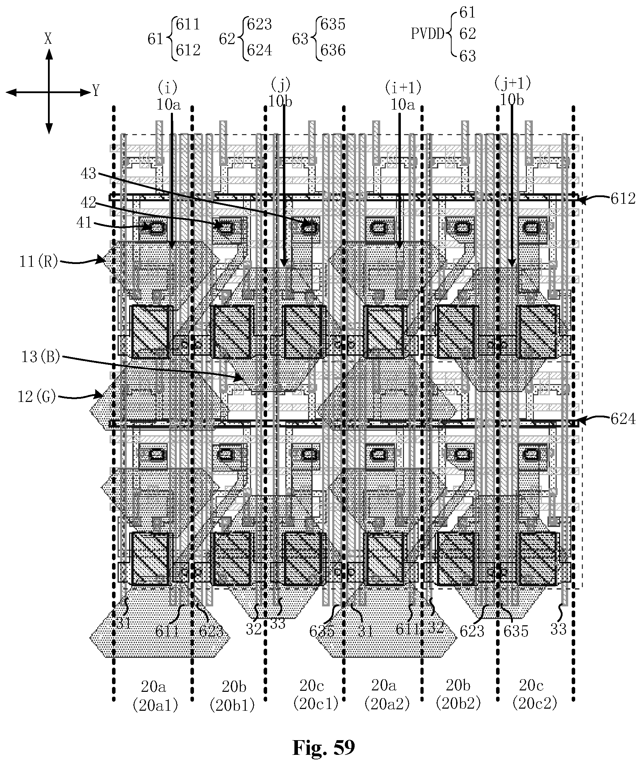

For example, as shown in Fig. 59, in the first direction X, any third via 43 is on an upper side of the third light-emission element 13 connected thereto.

For example, the display panels shown in Figs. 6, 31, 37, 46, 50, and 54 are all LTPO type display panels. The display panels shown in Fig. 20 and Fig. 41 are both LTPS type display panels. The display panel shown in Fig. 59 is an LTPS type display panel. Of course, this is not intended to limit the present application.

It should be noted that in the accompanying drawings of the light-emission elements shown in Figs. 3 to 57, the first light-emission elements 11 are illustrated as red light-emission elements, and the second light-emission elements 12 are illustrated as blue light-emission elements. This is not intended to limit the present application. In other examples, the first light-emission elements 11 are blue light-emission elements, and the second light-emission elements 12 are red light-emission elements.

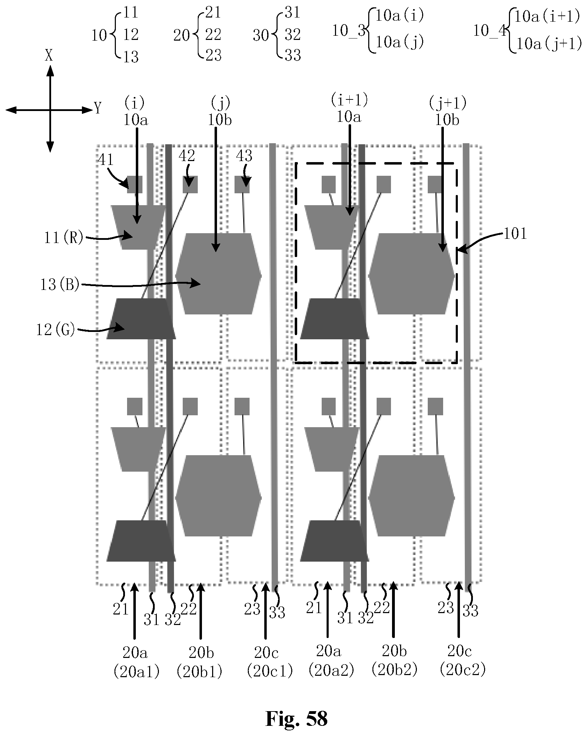

In some embodiments, the design shown in Fig. 58 can implement that the same unit column includes light-emission elements of different colors and the light-emission elements of the same color are connected by data lines.

As shown in Fig. 58, one first light-emission element 11, one second light-emission element 12, and one third light-emission element 13, which are adjacent, constitute one element unit 101, and a plurality of element units 101 are arranged in an array in the first direction X and the second direction Y.

The first light-emission element 11 is electrically connected to the first pixel circuit 21 by the first via 41, the second light-emission element 12 is electrically connected to the second pixel circuit 22 by the second via 42, and the third light-emission element 13 is electrically connected to the third pixel circuit 23 by the third via 43; in the first direction X, the first via 41, the second via 42, and the third via 43 of the element unit 101 are located on the same side of the element unit 101.

For example, in Fig. 58, the first via 41, the second via 42, and the third via 43 are located on an upper side of the element unit 101.

As an example, in Fig. 58, the first light-emission elements 11 are red light-emission elements, the second light-emission elements 12 are green light-emission elements, and the third light-emission elements 13 are blue light-emission elements. Of course, the red light-emission elements and the green light-emission elements in Fig. 58 are interchangeable.

In some embodiments, as shown in Fig. 58, the first unit column 10a and the second unit column 10b that are adjacent constitute a second unit column group, and each second unit column group corresponds to three columns of pixel circuits.

For example, the (i)^{th} first unit column 10a and the (j)^{th} second unit column 10b constitute a second unit column group 10_3. The 1^{st} first circuit column 20a1, the 1^{st} second circuit column 20b1, and the 1^{st} third circuit column 20c1 are configured to drive the (i)^{th} first unit column 10a and the (j)^{th} second unit column 10b. That is, the three columns of pixel circuits corresponding to the second unit column group 10_3 are distributed as follows: the 1^{st} first circuit column 20a1, the 1^{st} second circuit column 20b1, and the 1^{st} third circuit column 20c1.

The (i+1)^{th} first unit column 10a and the (j+1)^{th} second unit column 10b constitute a second unit column group 10_4. The 2^{nd} first circuit column 20a2, the 2^{nd} second circuit column 20b2, and the 2^{nd} third circuit column 20c2 are configured to drive the (i+1)^{th} first unit column 10a and the (j+1)^{th} second unit column 10b. That is, the three columns of pixel circuits corresponding to the second unit column group 10_4 are distributed as follows: the 2^{nd} first circuit column 20a2, the 2^{nd} second circuit column 20b2, and the 2^{nd} third circuit column 20c2.

In this embodiment, if the total number of the first unit columns and the second unit columns is 2n, the total number of columns of the pixel circuits is 3n. As such, in the second direction Y, the total width of the first unit column and the second unit column is approximately equal to the total width of 3 pixel circuit columns, thereby increasing the light-emission area of the light-emission elements.

In some embodiments, with reference to Figs. 58 to 61, the anode of the second light-emission element 12 is electrically connected to the second via 42 by the second connection line 52. In a direction parallel to a light-emission surface of the display panel, the second connection line 52 is located between the first light-emission element 11 and the third light-emission element 13.

For example, the second connection line 52 and the anode of the second light-emission element 12 are located in the same film layer.

For the first light-emission element 11, almost no connection line is required between its anode and the first pixel circuit 21, which can be directly connected by the first via 41.

For the third light-emission element 13, the distance between its anode and the third via 43 is also relatively short, so the line for directly connecting the anode of the third light-emission element 13 and the third via 43 can be relatively short.

Compared to the first light-emission element and the third light-emission element, the anode of the second light-emission element 12 is relatively far from the second via 42, so a relatively long second connection line can be configured to connect the second light-emission element 12 to the second via 42.

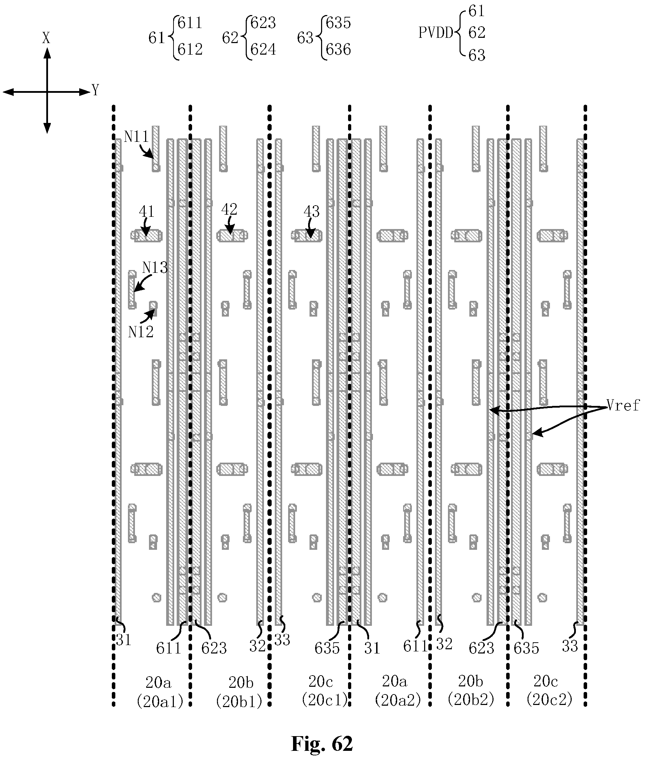

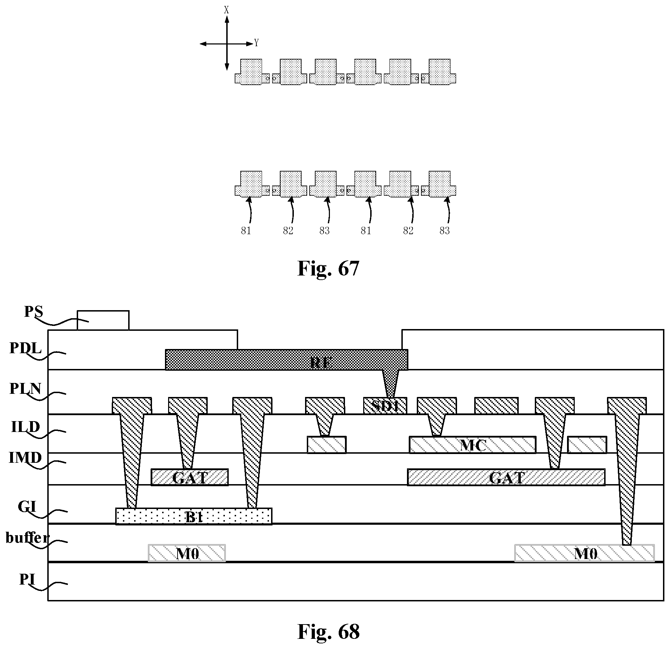

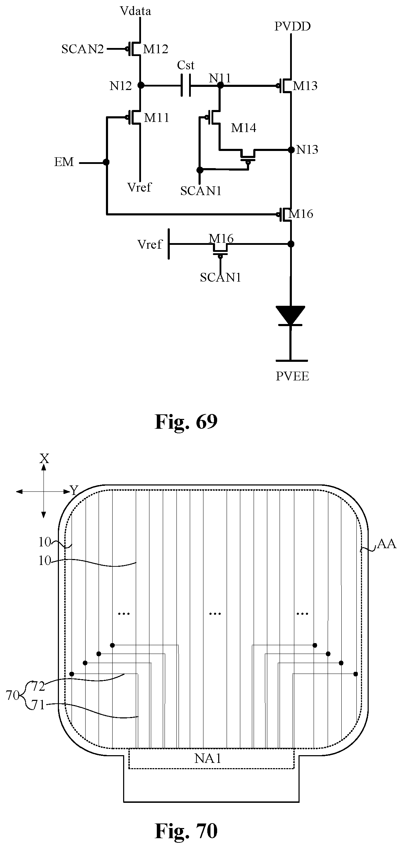

Figs. 62 to 67 show layout structures of some other film layers that implement the design shown in Fig. 58. As shown in Figs. 59 to 69, the display panel includes one semiconductor layer. For example, as shown in Fig. 68, the display panel includes a first semiconductor layer B1. For example, the material of the first semiconductor layer B1 includes LTPS. As shown in Fig. 30, all transistors of the pixel circuit are LTPS type transistors. In this embodiment, the structures of the first pixel circuit, the second pixel circuit, and the third pixel circuit may be as shown in Fig. 69. In the structure shown in Fig. 69, the pixel circuit includes six transistors and one capacitor, where a first electrode of the drive transistor M13 is connected to a power line PVDD.

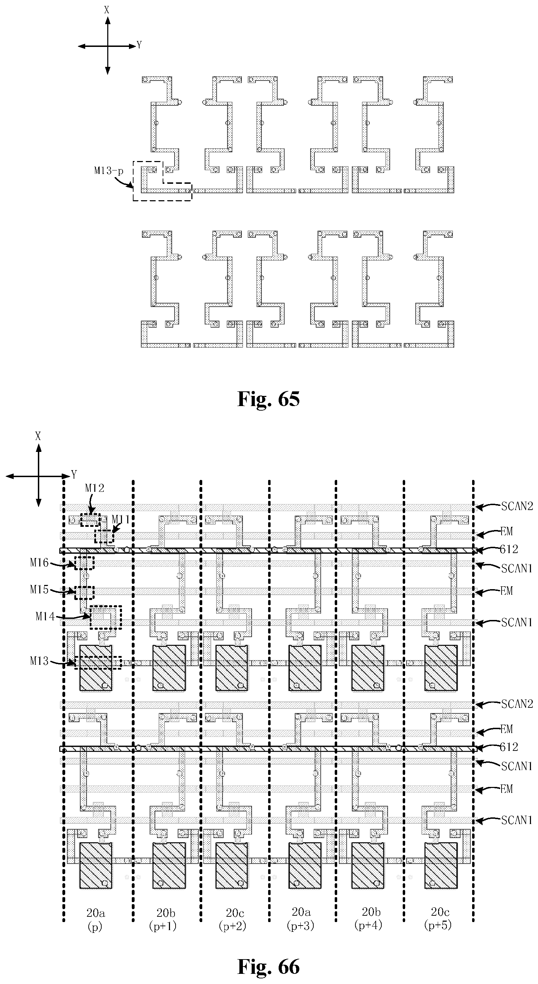

In some embodiments, with reference to Fig. 65 and Fig. 69, the pixel circuit of the display panel includes a drive transistor M13 and a power line PVDD electrically connected to the drive transistor M13, and active layers M13-p of the adjacent drive transistors are not connected. In Fig. 65, the dashed box indicates active layers of drive transistors in one pixel circuit.

It can be understood that this example lays a foundation for realizing power supply of different power lines to light-emission elements of different light-emission colors.

It should be noted that that active layers M13-p of adjacent drive transistors are not connected indicates: no "semiconductor portion" is overlapped between the active layers M13-p of the adjacent drive transistors, where the "semiconductor portion" refers to a structure in the same layer as the active layers of the drive transistors.

For example, as shown in Fig. 65, in the first semiconductor layer, the active layer M13-p of the drive transistor is disconnected from the active layers of other transistors, and the active layers M13-p of different drive transistors are disconnected.

It should be further noted that although the present application indicates only in the examples corresponding to Figs. 58 to 69 that, in the film layer where the active layer of the drive transistor is located, the active layer of the drive transistor is disconnected from the active layers of other transistors, and the active layers of different drive transistors are disconnected, which is not intended to limit the present application. For example, in any of the examples corresponding to Figs. 3 to 57, the setting can also be made in such a way. Of course, in any of the examples corresponding to Figs. 3 to 57, in the film layer where the active layer of the drive transistor is located, the active layer of the drive transistor may be not disconnected from the active layers of other transistors.

With reference to Fig. 62 and Fig. 69, in the same pixel circuit, the drive transistor M13 needs to be connected to other transistors. For example, a gate of the drive transistor M13 is connected to a first connection portion N11, and a second electrode of the drive transistor M13 is connected to a third connection portion N13. The first connection portion N11 and the third connection portion N13 are arranged in the metal layer. For example, the first connection portion N11 and the third connection portion N13 are located in the first metal layer SD1 shown in Fig. 8. In addition, the other end of the capacitor Cst is connected to a second connection portion N12, and the second connection portion N12 is located in the first metal layer SD1 shown in Fig. 8.

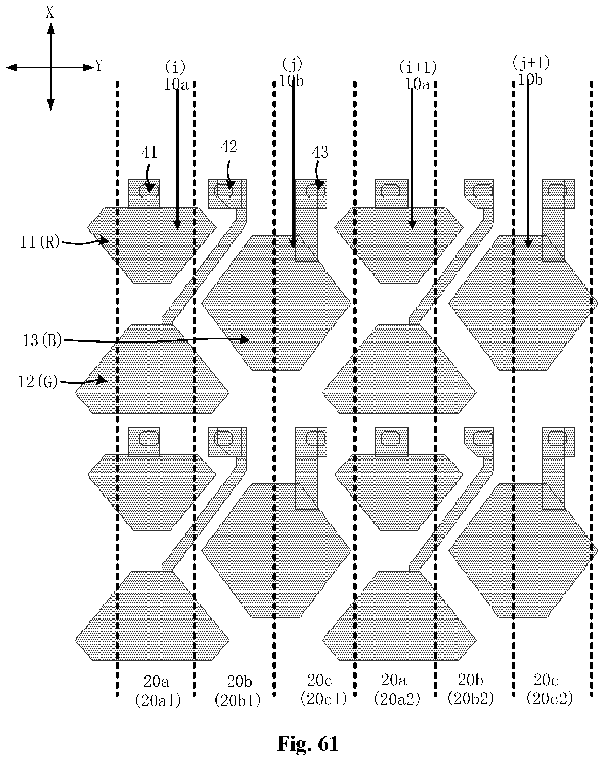

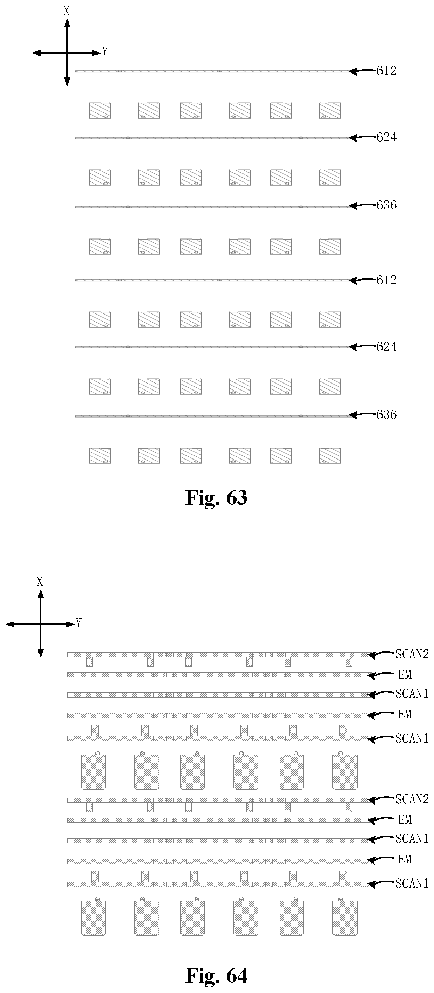

Moreover, the layout structure shown in Fig. 61 is located in the anode layer RE shown in Fig. 68, the layout structure shown in Fig. 62 is located in the first metal layer SD1 shown in Fig. 68, the layout structure shown in Fig. 63 is located in the capacitor metal layer MC shown in Fig. 68, the layout structure shown in Fig. 64 is located in the first gate layer GAT shown in Fig. 68, the layout structure shown in Fig. 65 is located in the first semiconductor layer B1 shown in Fig. 68, and the layout structure shown in Fig. 67 is located in the auxiliary metal layer M0 shown in Fig. 68.

In some embodiments, such as the examples shown in Figs. 37 to 40, or the examples shown in Figs. 46 to 49, or the examples shown in Figs. 50 to 53, for some light-emission elements, a "lead-out line" design is required in the metal layer to achieve the connection between the light-emission element and the pixel circuit.

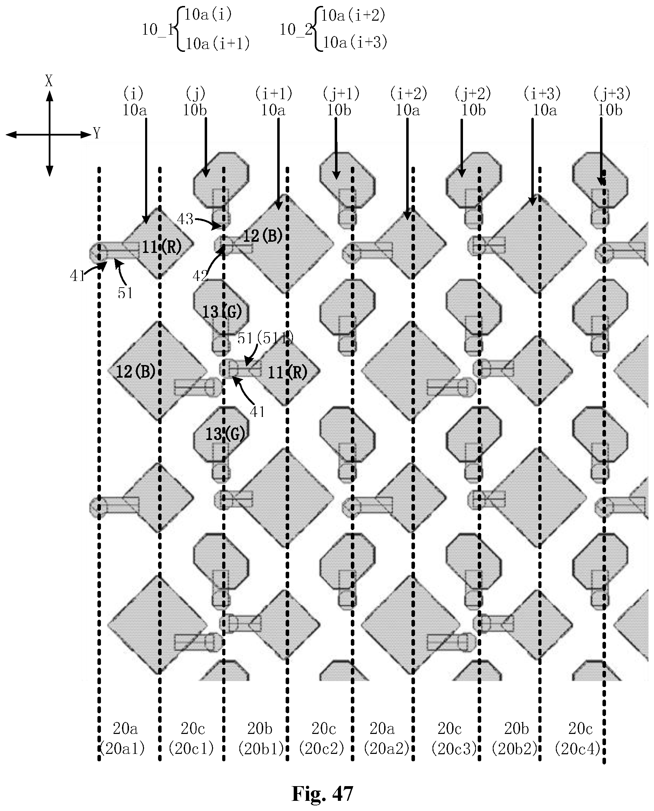

Specifically, as shown in Fig. 47 and Fig. 48, the light-emission element is electrically connected to the pixel circuit by a via. For the first light-emission elements 11 in the (i+1)^{th} and (i+3)^{th} first unit columns 10a, a "lead-out line" design is required. The connection vias between these first light-emission elements 11 and the first pixel circuits are referred to as first sub vias 411, and the first connection line between the first light-emission element 11 and the first pixel circuit includes a second segment 512. In the thickness direction of the display panel, the first sub via 411 does not overlap the first pixel circuit electrically connected thereto. One end of the first sub via 411 extends to the film layer where the anode of the first light-emission element 11 is located, the other end of the first sub via 411 extends to the metal layer where the second segment 512 is located and is connected to one end of the second segment 512, and the other end of the second segment 512 is electrically connected to the first pixel circuit.

In some embodiments, the light-emission element is electrically connected to the pixel circuit by a via, the via includes a first sub via, and the first sub via does not overlap the pixel circuit electrically connected thereto; the display panel further includes a connection line, one end of the connection line is connected to the first sub via, and the other end is connected to the pixel circuit.

Still referring to Fig. 47 and Fig. 48 for illustration, the display panel includes power branch lines extending in the second direction Y, such as second power branch lines 612 and fourth power branch lines 624. Lead-out lines can be provided in the film layer where the second power branch lines 612 and the fourth power branch lines 624 are located. That is, at least some line segments of the connection line between the light-emission element and the pixel circuit are arranged on the same layer as the power branch line extending in the second direction.

In this embodiment, although an additional "lead-out line" design is required, the "lead-out line" is arranged on the same layer as the power branch line, so an additional film layer is not required, which is conducive to balancing the lightweight of the display panel.

In some embodiments, the via includes a second sub via, and the second sub via at least partially overlaps the pixel circuit electrically connected thereto; the display panel further includes a compensation line, and one end of the compensation line is connected to the second sub via.

Still referring to Fig. 47 and Fig. 48 for illustration, for the first light-emission elements 11 in the (i)^{th} and (i+2)^{th} first unit columns 10a, the "lead-out line" design is not required. Here, the "lead-out line" refers to a connection line used for connecting the light-emission element and the pixel circuit. The connection vias between these first light-emission elements 11 and the first pixel circuits are referred to as second sub vias 412. One end of the second sub via 412 extends to the film layer where the anode of the first light-emission element 11 is located, and the other end of the second sub via 412 extends to the film layer where the first pixel circuit is located and is connected to the first pixel circuit.

In the thickness direction of the display panel, the second sub via 412 at least partially overlaps the first pixel circuit electrically connected thereto. In the metal layer where the second segment 512 is located, the other end of the first sub via 411 is connected to one end of the second segment 512, and the other end of the second segment 512 is electrically connected to the first pixel circuit.

For the first light-emission elements 11 in the (i+1)^{th} and (i+3)^{th} first unit columns 10a, a "lead-out line" design is required. For the first light-emission elements 11 in the (i)^{th} and (i+2)^{th} first unit columns 10a, the "lead-out line" design is not required. Here, the "lead-out line" refers to a connection line used for connecting the light-emission element and the pixel circuit. In this case, the lengths of connection lines for different first light-emission elements 11 are different, resulting in different voltage drops (or loading) corresponding to different first light-emission elements 11, which affects display uniformity.

In view of this, for the first light-emission elements 11 in the (i)^{th} and (i+2)^{th} first unit columns 10a, a compensation line 54 may be further provided, and one end of the compensation line 54 is connected to the second sub via 412.

For example, the overall impedance of the compensation line 54 may be approximately equal to the overall impedance of the second segment 512.

In some embodiments, the compensation line is in the same film layer as the connection line in the metal layer.

Still illustrated in Fig. 47 and Fig. 48, for the first light-emission elements 11 in the (i)^{th} and (i+2)^{th} first unit columns 10a, the compensation line 54 and the second segment 512 are located in the same film layer. In this embodiment, although an additional "compensation line" design is required, the "compensation line" is designed in the same film layer as the metal layer in the connection line or the anode of the light-emission element, which does not require an additional film layer and is conducive to balancing the lightweight of the display panel.

In some embodiments, the other end of the compensation line is suspended. As such, crosstalk with other signals or interference with the light-emission element connected to the compensation line can be avoided.

For example, in Fig. 48, one end of the compensation line 54 is connected to the second sub via 412, and the other end is suspended. "Suspended" indicates that the other end of the compensation line is not connected to other structures.

In order to provide a current source required by the light-emission element to emit light, a power line PVDD and a common voltage line PVEE are required. The pixel circuit and the light-emission element are connected in series between the power line PVDD and the common voltage line PVEE. When the pixel circuit is electrically connected to the light-emission element and the power line PVDD, the light-emission element can emit light.

The light-emission element and the pixel circuit electrically connected thereto constitute a sub-pixel. For example, the first light-emission element and the first pixel circuit constitute a first sub-pixel, the second light-emission element and the second pixel circuit constitute a second sub-pixel, and the third light-emission element and the third pixel circuit constitute a third sub-pixel. The sub-pixel is connected between the power line PVDD and the common voltage line PVEE.

In related technologies, the sub-pixels of different colors share the power line PVDD and the common voltage line PVEE. However, the bias voltage between the power line PVDD and the common voltage line PVEE, required by the sub-pixels of different colors, may be different. In the design where the power line PVDD is shared, in order to enable the sub-pixels of each color to operate in a saturation region, the bias voltage between the power line PVDD and the common voltage line PVEE is designed to cover the maximum bias voltage required by the sub-pixels of each color. For sub-pixels with small bias voltage requirements, there is unnecessary power loss.

In the embodiments of the present application, the data lines for the light-emission elements of each color are independent, and the power lines PVDD for the light-emission elements of each color are also designed to be independent, to further save power consumption.

The examples shown in Figs. 6 to 69 all illustrate the design where the power lines PVDD for the light-emission elements of at least two colors are independent. Hereinafter, exemplary descriptions are provided for the independent design of power lines PVDD using some accompanying drawings.

In some embodiments, with reference to Figs. 7, 9, and 10, the display panel further includes a power line PVDD, and the power line PVDD includes at least a first power line 61 and a second power line 62. The first power line 61 is electrically connected to the first light-emission element 11, the first power line 61 includes a first power branch line 611 and a second power branch line 612 that are electrically connected to each other, the first power branch line 611 extends in the first direction X, and the second power branch line 612 extends in the second direction Y. The second power line 62 is electrically connected to the second light-emission element 12, the second power line 62 includes a third power branch line 623 and a fourth power branch line 624 that are electrically connected to each other, the third power branch line 623 extends in the first direction X, and the fourth power branch line 624 extends in the second direction Y.

For example, the first power branch line 611 and the second power branch line 612 may be located in different film layers respectively and connected by the via. The third power branch line 623 and the fourth power branch line 624 may be located in different film layers respectively and connected by the via.

It should be noted that the first power line 61 and the second power line 62 are not connected. When the first light-emission element and the second light-emission element require different bias voltage, the first power line 61 and the second power line 62 each can provide different power voltage, such that a large bias voltage is not required to cover the bias voltage required by the light-emission elements each, which can save the power consumption of the display panel.

In addition, the first power branch line 611 and the second power branch line 612 extend in different directions and are electrically connected to each other. A plurality of first power branch lines 611 and a plurality of second power branch lines 612 can constitute a grid-like first power line 61, thereby reducing the voltage drop of the first power line 61 and improving display uniformity.

Similarly, the third power branch line 623 and the fourth power branch line 624 extend in different directions and are electrically connected to each other. A plurality of third power branch lines 623 and a plurality of fourth power branch lines 624 can constitute a grid-like second power line 62, thereby reducing the voltage drop of the second power line 62 and improving display uniformity.

For example, only for the first power branch line 611 and the third power branch line 623, in the second direction Y, the first power branch line 611 and the third power branch line 623 are alternately distributed. Only for the second power branch line 612 and the fourth power branch line 624, in the first direction X, the second power branch line 612 and the fourth power branch line 624 are alternately distributed. As such, the area covered by the single grid of the first power line 61 may be substantially the same as the area covered by the single grid of the second power line 62, thereby reducing the voltage drop difference between the first power line 61 and the second power line 62.

In some embodiments, with reference to Figs. 7, 9, and 10, or with reference to Fig. 62 and Fig. 63, the display panel further includes a power line PVDD, the power line PVDD further includes a third power line 63, the third power line 63 is electrically connected to the third light-emission element 13, the third power line 63 includes a fifth power branch line 635 and a sixth power branch line 636 that are electrically connected to each other, the fifth power branch line 635 extends in the first direction X, and the sixth power branch line 636 extends in the second direction Y.

One of the second power branch line and the fourth power branch line is electrically connected to the sixth power branch line.

As an example, with reference to Figs. 7, 9, and 10, the second power branch line 612 and the sixth power branch line 636 may be the same trace, that is, the trace serves as both the second power branch line 612 and the sixth power branch line 636. This example can reduce the quantity of power branch lines extending in the second direction and release layout space. Understandably, in this example, the first light-emission element and the third light-emission element share power signals.

It should be noted that although the layouts in Figs. 6 to 57 illustrate that the second power branch line 612 and the sixth power branch line 636 are the same trace, the present application is not limited thereto. For example, in other examples, the fourth power branch line 624 and the sixth power branch line 636 are the same trace, or the second power branch line 612 and the sixth power branch line 636 are two traces and connected to each other, or the fourth power branch line 624 and the sixth power branch line 636 are two traces and connected to each other.

As another example, with reference to Fig. 62 and Fig. 63, the second power branch line 612, the fourth power branch line 624, and the sixth power branch line 636 are independent of each other. That is, the second power branch line 612, the fourth power branch line 624, and the sixth power branch line 636 are not connected to each other, and the power lines for the first light-emission element, the second light-emission element, and the third light-emission element are all independent of each other, such that the bias voltage requirement of each light-emission element can be matched more flexibly.

It should be noted that Fig. 63 shows a layout structure corresponding to 6 rows of pixel circuits, while Figs. 58 to 62 and Figs. 64 to 67 illustrate layout structures corresponding to 2 rows of pixel circuits.

For example, when the second power branch line 612, the fourth power branch line 624, and the sixth power branch line 636 are independent of each other, one second power branch line 612, one fourth power branch line 624, and one sixth power branch line 636 constitute a line group, and a plurality of line groups are arranged in the first direction X.

It should be noted that in the layouts in Figs. 6 to 57, the second power branch line 612, the fourth power branch line 624, and the sixth power branch line 636 can also be designed independently of each other.

In some embodiments, as shown in Figs. 7, 21, 32, 37, 42, 46, 50, and 54, one of the first light-emission elements 11 and the second light-emission elements 12 are red light-emission elements, the others are blue light-emission elements, and the third light-emission elements 13 are green light-emission elements; the first power branch line 611, the fifth power branch line 635, the third power branch line 623, and the fifth power branch line 635 constitute a first line group, and a plurality of the first line groups are arranged in the second direction Y.

That is, in the second direction Y, the arrangement rule of power branch lines is as follows: one first power branch line 611, one fifth power branch line 635, one third power branch line 623, one fifth power branch line 635, followed by one first power branch line 611, one fifth power branch line 635, one third power branch line 623, one fifth power branch line 635, and so on.

In the second direction Y, the arrangement order of circuit columns is as follows: one first circuit column 20a, one third circuit column 20c, one second circuit column 20b, one third circuit column 20c, followed by one first circuit column 20a, one third circuit column 20c, one second circuit column 20b, one third circuit column 20c, and so on.

In the second direction Y, the arrangement rule of power branch lines matches the arrangement order of circuit columns. Each circuit column corresponds to a power branch line extending in the first direction. As such, the power lines PVDD for the light-emission elements of different colors are independent from each other, each circuit column can be proximately connected to the corresponding power line, and an additional trace is not required for the connection between the power line and the pixel circuit.

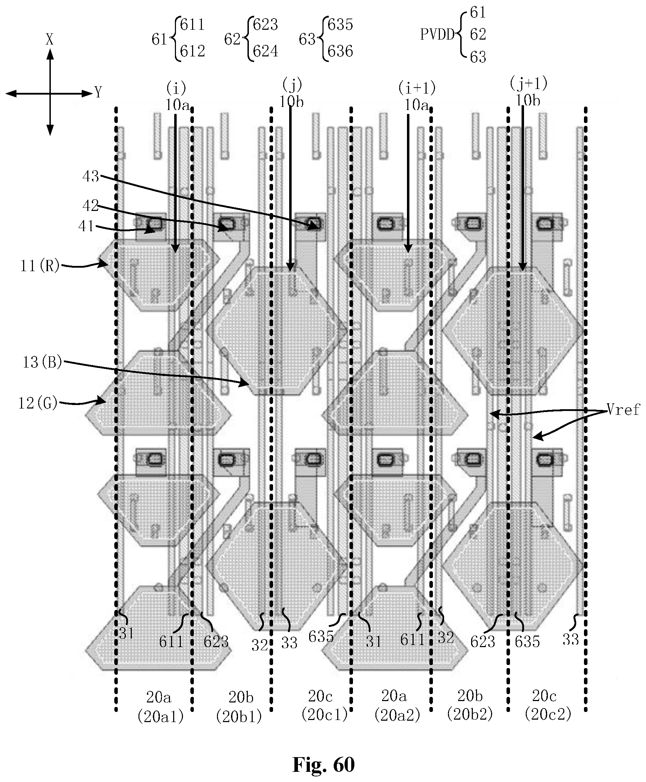

In other embodiments, with reference to Fig. 60 and Fig. 62, one of the first light-emission elements 11 and the third light-emission elements 13 are red light-emission elements, the others are blue light-emission elements, and the second light-emission elements 12 are green light-emission elements; the first power branch line 611, the third power branch line 623, and the fifth power branch line 635 constitute a second line group, and a plurality of the second line groups are arranged in the second direction Y.

That is, in the second direction Y, the arrangement rule of power branch lines is as follows: one first power branch line 611, one third power branch line 623, one fifth power branch line 635, followed by one first power branch line 611, one third power branch line 623, one fifth power branch line 635, and so on.

In the second direction Y, the arrangement order of circuit columns is as follows: one first circuit column 20a, one second circuit column 20b, one third circuit column 20c, followed by one first circuit column 20a, one second circuit column 20b, one third circuit column 20c, and so on.

Similarly, in this example, in the second direction Y, the arrangement rule of power branch lines matches the arrangement order of circuit columns. Each circuit column corresponds to a power branch line extending in the first direction. As such, the power lines PVDD for the light-emission elements of different colors are independent from each other, each circuit column can be proximately connected to the corresponding power line, and no additional trace is required for the connection between the power line and the pixel circuit.

In some embodiments, the plurality of pixel circuits of the display panel are arranged in n1 rows; the total number of the second power branch line, the fourth power branch line, and the sixth power branch line is n2; n1=n2. n1 and n2 each are integers greater than 1.

For example, as shown in Figs. 7, 21, 32, 37, 42, 46, 50, and 54, for every two adjacent pixel circuit rows, one pixel circuit row is correspondingly provided with the second power branch line 612 and the sixth power branch line 636, and the other pixel circuit row is correspondingly provided with the fourth power branch line 624.

In other embodiments, the plurality of pixel circuits of the display panel are arranged in n1 rows; the total number of the second power branch line, the fourth power branch line, and the sixth power branch line is n2; n1=2*n2. n1 and n2 each are integers greater than 1.

For example, two second power branch lines, one fourth power branch line, and one sixth power branch line may be set for every two adjacent pixel circuit rows.

In some embodiments, with reference to Figs. 20, 24, and 25, the first power line 61 further includes a seventh power branch line 617, the seventh power branch line 617 extends in the first direction X, and the seventh power branch line 617 and the first power branch line 611 are electrically connected and located in different film layers.

The second power line 62 further includes an eighth power branch line 628, the eighth power branch line 628 extends in the first direction X, and the eighth power branch line 628 and the third power branch line 623 are electrically connected and located in different film layers.

The third power line 63 further includes a ninth power branch line 639, the ninth power branch line 639 extends in the first direction X, and the ninth power branch line 639 and the fifth power branch line 635 are electrically connected and located in different film layers.

This example equivalently increases respective grid densities of the first power line 61, the second power line 62, and the third power line 63, which can further reduce the voltage drop corresponding to each power line, thereby further improving display uniformity.

For example, the seventh power branch line 617, the eighth power branch line 628, and the ninth power branch line 639 are located in the first metal layer SD1. In this example, the first metal layer SD1 is further provided with reset lines extending in the first direction X, and the reset lines include, for example, first reset lines Vref1 and second reset lines Vref2. For example, every two reset lines are spaced apart by a power branch line.

For example, in the thickness direction of the display panel, the seventh power branch line 617 at least partially overlaps the first power branch line 611, and/or the eighth power branch line 628 at least partially overlaps the third power branch line 623, and/or the ninth power branch line 639 at least partially overlaps the fifth power branch line 635. As such, the corresponding power branch lines can be electrically connected by vias, no additional connection trace is required, dual longitudinal power branch line design can be achieved, and no additional layout area is occupied, that is, a high resolution is not affected.

For example, the first reset line Vrf1 and/or the second reset line Vrf2 may also be gridded. For example, in Fig. 10, at least some second traces 92 may be also served as first reset lines Vref1. As shown in Fig. 14, the capacitor metal layer includes first reset lines Vref1 extending in the second direction Y. The first reset lines Vref1 in Fig. 10 and Fig. 14 are electrically connected to each other, to achieve a grid design of the first reset lines Vref1.

For example, in Fig. 10, at least some second traces 92 may be also served as second reset lines Vref2. As shown in Fig. 14, the capacitor metal layer includes second reset lines Vref2 extending in the second direction Y. The second reset lines Vref2 in Fig. 10 and Fig. 14 are electrically connected to each other, to achieve a grid design of the second reset lines Vref2.

In some embodiments, the first power branch line, the third power branch line, and the fifth power branch line are located on the first film layer of the display panel; the first film layer includes a data line of the display panel; the second power branch line, the fourth power branch line, and the sixth power branch line are located on the second film layer of the display panel; the first film layer and the second film layer are both film layers on the side where the semiconductor layer of the display panel faces the light-emission surface.

That is, the first power branch line, the third power branch line, the fifth power branch line, and the data line are located in the same first film layer; the second power branch line, the fourth power branch line, and the sixth power branch line are located in the same second film layer; the first film layer and the second film layer are different metal layers. The semiconductor layer is provided with an active layer of a transistor, and the active layer undergoes characteristic transfer under the influence of light. In the embodiments of the present application, the traces in the first film layer and the second film layer can block light from irradiating the active layer in the semiconductor layer, thereby avoiding characteristic transfer caused by light irradiation on the active layer and improving the circuit reliability of the display panel.

The display panel may include one or more semiconductor layers, and the first film layer and the second film layer are located on the side of any semiconductor layer facing the light-emission surface.

For example, as shown in Fig. 9 and Fig. 10, in the examples shown in Fig. 23 and Fig. 24, Fig. 39 and Fig. 40, as well as Fig. 44 and Fig. 43, the film layers where the signal lines are located are as follows: The first power branch line 611, the third power branch line 623, the fifth power branch line 635, the first data line 31, the second data line 32, and the third data line 33 are located in the second metal layer SD2. The second power branch line 612, the fourth power branch line 624, and the sixth power branch line 636 are located in the third metal layer SD3.

For another example, as shown in Fig. 34 and Fig. 35, in the examples shown in Fig. 48 and Fig. 49, Fig. 52 and Fig. 53, as well as Fig. 56 and Fig. 57, the film layers where the signal lines are located are as follows: The first power branch line 611, the third power branch line 623, the fifth power branch line 635, the first data line 31, the second data line 32, and the third data line 33 are located in the third metal layer SD3. The second power branch line 612, the fourth power branch line 624, and the sixth power branch line 636 are located in the second metal layer SD2.

For still another example, with reference to Figs. 62, 63, and 68, the second metal layer SD2 and the third metal layer SD3 are not included. The film layers where the signal lines are located are as follows: the first power branch line 611, the third power branch line 623, the fifth power branch line 635, the first data line 31, the second data line 32, and the third data line 33 are located in the first metal layer SD1; and the second power branch line 612, the fourth power branch line 624, and the sixth power branch line 636 are located in the capacitor metal layer MC.

In some examples, as shown in Fig. 17 and Fig. 18, or as shown in Fig. 67 and Fig. 68, the display panel further includes an auxiliary metal layer M0, and the auxiliary metal layer M0 is located on the side of the semiconductor layer near the substrate PI. The display panel may include one or more semiconductor layers, and the auxiliary metal layer M0 is located on the side of any semiconductor layer near the substrate PI.

The auxiliary metal layer M0 includes a first auxiliary line 81, a second auxiliary line 82, and a third auxiliary line 83 disconnected from each other, the first auxiliary line 81 is electrically connected to the first power line 61, the second auxiliary line 82 is electrically connected to the second power line 62, and the third auxiliary line 83 is electrically connected to the third power line 63. This example equivalently increases respective grid densities of the first power line 61, the second power line 62, and the third power line 63, which can further reduce the voltage drop corresponding to each power line, thereby further improving display uniformity.

The traces in the auxiliary metal layer M0 can further be used for blocking light on the bottom surface from irradiating the active layer in the semiconductor layer, thereby avoiding characteristic transfer caused by light irradiation on the active layer and improving the circuit reliability of the display panel.

For example, as shown in Fig. 16 and Fig. 17, the trace pattern in the auxiliary metal layer M0 overlaps the trace pattern in the first semiconductor layer in the thickness direction of the display panel.

For another example, as shown in Fig. 65 and Fig. 67, the trace pattern in the auxiliary metal layer M0 at least overlaps the active layer of the drive transistor.

In some embodiments, as shown in Fig. 70, a crossover line 70 is provided in a display area AA of the display panel, one end of the crossover line 70 is connected to the data line 30, the other end of the crossover line 70 is connected to the trace in a trace area NA1, and the trace in the trace area NA1 is connected to the driver chip. It can be understood that the crossover line 70 is used for transmitting data signals from the driver chip to the data line 30.

Such design can be referred to as "FIAA" design, which can reduce the width of the trace area NA1 and achieve narrow borders.

Further, in the embodiments of the present application, the "FIAA" design is combined with the independence of power lines for light-emission elements of different colors and the independence of data lines for light-emission elements of different colors, which can reduce power consumption and achieve narrow bezels.

For example, the crossover line 70 includes a first line segment 71 and a second line segment 72 that are electrically connected to each other, the first line segment 71 extends in the first direction X, and the second line segment 72 extends in the second direction Y.

As shown in Fig. 10, the first line segment 71 and the first power branch line 611 are located in the same film layer. As shown in Fig. 9 and Fig. 11, the second line segment 72 and the second power branch line 612 are located in different film layers. For example, as shown in Fig. 11 and Fig. 18, the second line segment 72 is located in the first metal layer SD1.

For example, as shown in Fig. 10, the display area of the display panel includes a plurality of first traces 91 extending in the first direction X. For example, the area where the crossover line 70 is located is referred to as an "FIAA area", and the area outside the crossover line 70 is referred to as a "non-FIAA area". The first trace 91 in the "FIAA area" is also served as the first line segment 71, and the first trace 91 in the "non-FIAA area" can be also served as the common voltage line PVEE. Alternatively, the first trace 91 in the "non-FIAA area" can be also served as the reset line Vref1 or Vref2 or other signal lines. It can be understood that the first traces in the "FIAA area" and the "non-FIAA area", when transmitting different signals, are disconnected from each other.

For example, as shown in Fig. 11, the display area of the display panel includes a plurality of third traces 93 extending in the second direction Y. Here, the area where the crossover line 70 is located is still referred to as an "FIAA area", and the area outside the crossover line 70 is referred to as a "non-FIAA area". The third trace 93 in the "FIAA area" is also served as the second line segment 72, and the third trace 93 in the "non-FIAA area" can be also served as the common voltage line PVEE. Alternatively, the third trace 93 in the "non-FIAA area" can be also served as the reset line Vref1 or Vref2 or other signal lines. It can be understood that the third traces in the "FIAA area" and the "non-FIAA area", when transmitting different signals, are disconnected from each other.

For example, as shown in Fig. 10, the display area of the display panel further includes a plurality of second traces 92 extending in the first direction X. The first trace 91 and the second trace 92 are adjacent to each other, and the first trace 91 and the second trace 92 are located between two data lines. For example, the first trace 91 and the second trace 92 are provided between the first data line 31 and the third data line 33, and the first trace 91 and the second trace 92 are provided between the second data line 32 and the third data line 33.

The above embodiments introduce that the data lines for the light-emission elements of each color are independent, and the power lines for the light-emission elements of each color are independent. In other embodiments, besides that the power lines for the light-emission elements of each color are independent, the data lines for the light-emission elements of at least two colors are not independent.

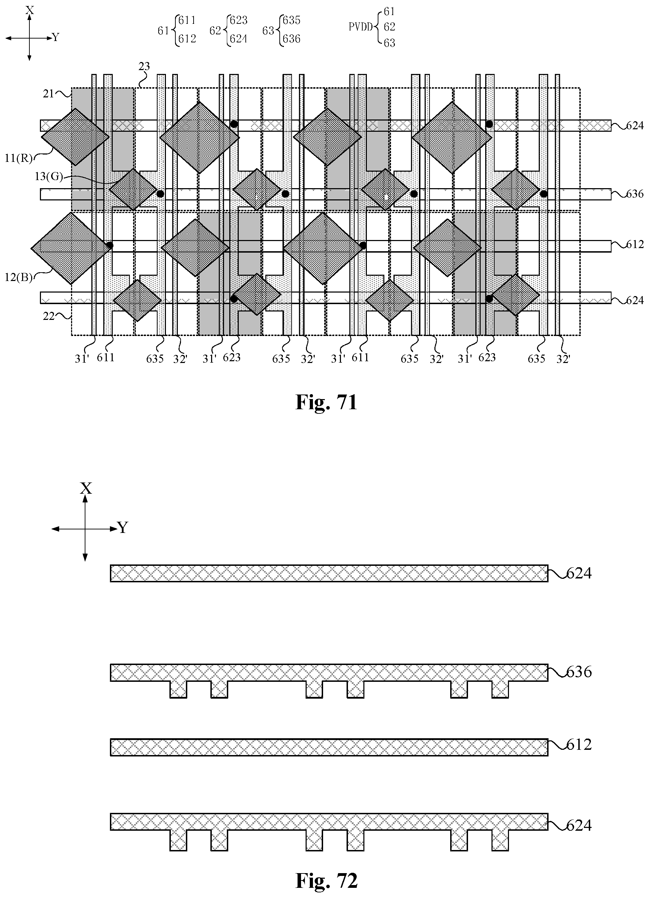

For example, as shown in Fig. 71, the first light-emission element 11 is electrically connected to the first pixel circuit 21, the second light-emission element 12 is electrically connected to the second pixel circuit 22, and the data line 31' is electrically connected to both the first pixel circuit 21 and the second pixel circuit 22 in the same column. That is, the data line 31' is used for providing data signals required by the light-emission elements of two colors, and the first light-emission element 11 and the second light-emission element 12 share the data line. In addition, the third light-emission element 13 is electrically connected to the third pixel circuit 23, and the data line 32' is electrically connected to the plurality of third pixel circuits 23 in the same column.

Dashed boxes in Fig. 71 indicate approximate positions of pixel circuits, and the first pixel circuits 21 are illustrated by gray filled dashed boxes to distinguish between the first pixel circuits 21 and the second pixel circuits 22.

The power line PVDD includes a first power line 61, a second power line 62, and a third power line 63. The first power line 61 is electrically connected to the first pixel circuit 21, and the first power line 61 includes a first power branch line 611 and a second power branch line 612 that are electrically connected to each other. One of the first power branch line 611 and the second power branch line 612 can be electrically connected to the first pixel circuit 21 by a via. The second power line 62 is electrically connected to the second pixel circuit 22, and the second power line 62 includes a third power branch line 623 and a fourth power branch line 624 that are electrically connected to each other. One of the third power branch line 623 and the fourth power branch line 624 can be electrically connected to the second pixel circuit 22 by a via. The third power line 63 is electrically connected to the third pixel circuit 23, and the third power line 63 includes a fifth power branch line 635 and a sixth power branch line 636 that are electrically connected to each other. One of the fifth power branch line 635 and the sixth power branch line 636 can be electrically connected to the third pixel circuit 23 by a via.

Reference may be made to the above embodiments for the characteristics of each power branch line, which will not be repeated here.

It should be noted that Fig. 71 is used to illustrate the electrical connection relationships among data lines, power lines, and pixel circuits, and is not intended to limit the relative positional relationships between data lines and power lines. In Fig. 71, solid black dots represent electrical connection between two power branch lines. However, the solid black dots are not intended to limit the connection positions of two power branch lines, as long as two power branch lines can be connected.

For example, as shown in Fig. 71, the power branch line extending in the first direction X may include a branch. In the thickness direction of the display panel, the branch at least partially overlaps the third light-emission element 13, such that the surface where the third light-emission element 13 is located is as flat as possible, thereby ensuring the light-emission effect of the third light-emission element 13.

For example, as shown in Fig. 72, at least some power branch lines extending in the second direction Y may also include branches, the pixel circuit includes a drive transistor, and the gate of the drive transistor is connected to other transistors by a metal connection portion. In the thickness direction of the display panel, the branch of at least some power branch lines extending in the second direction Y overlaps the metal connection portion. The branch transmits power voltage, and the power voltage is generally fixed voltage. Therefore, the branch can be used for shielding the influence of other signals on the gate potential of the drive transistor.

It should be noted that the above embodiments can be combined with each other if there is no conflict.

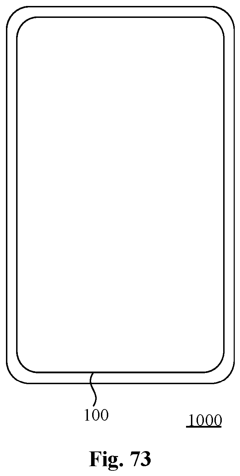

The present application further provides a display apparatus, including the display panel provided in the present application. Referring to Fig. 73, Fig. 73 is a schematic structural view of a display apparatus provided in an embodiment of the present application. The display apparatus 1000 provided in Fig. 73 includes a display panel 100. The display panel 100 includes the display panel provided in any of the above embodiments of the present application. The embodiment shown in Fig. 73 only takes a mobile phone as an example to illustrate the display apparatus 1000. It can be understood that the display apparatus provided in the embodiment of the present application may be other display apparatuses with display functions, such as wearable products, computers, televisions, and vehicle-mounted display apparatuses, which are not limited by the present application. The display apparatus provided in the embodiment of the present application has the beneficial effects of the display panel provided in the embodiments of the present application. For details, reference may be made to the specific description of the display panel in the above embodiments, which will not be repeated here in this embodiment.

According to the embodiments described above in the present application, these embodiments do not provide a detailed description of all the details, nor do they limit the present application to only the described specific embodiments. Apparently, many modifications and changes may be made to the above description. This specification selects and specifically describes these embodiments in order to better explain the principles and practical applications of the present application, such that those skilled in the art can make good use of the present application and modifications based on the present application. The present application is merely limited by the claims and all their scope and equivalents.

## Claims

1. A display panel, comprising:
light-emission elements, comprising first light-emission elements, second light-emission elements, and third light-emission elements, wherein
the first light-emission elements, the second light-emission elements, and the third light-emission elements have different light-emission colors,
a plurality of the first light-emission elements and a plurality of the second light-emission elements are alternately arranged in a first direction to form a first unit column, a plurality of the third light-emission elements are arranged in the first direction to form a second unit column, the first unit column and the second unit column are alternately arranged in a second direction, and the first direction intersects the second direction; and
first circuit columns, second circuit columns, and third circuit columns, wherein
each of the first circuit columns comprises a plurality of first pixel circuits arranged in the first direction and electrically connected to a first data line and the first light-emission elements,
each of the second circuit columns comprises a plurality of second pixel circuits arranged in the first direction and electrically connected to a second data line and the second light-emission elements,
each of the third circuit columns comprises a plurality of third pixel circuits arranged in the first direction and electrically connected to a third data line and the third light-emission elements.

2. The display panel according to claim 1, wherein
a column number of the pixel circuits in the display panel is greater than a column number of the light-emission elements;
a part of the circuit columns comprise dummy pixel circuits, each of the first light-emission elements is electrically connected to the first pixel circuit by a first via, and a plurality of the first vias corresponding to a same column of the first circuit columns constitute a first via column;
for one of the first circuit columns that does not comprise the dummy pixel circuits, in the second direction, the plurality of first light-emission elements electrically connected to the first pixel circuits by the first vias in a same column of the first via columns are located on two sides of the same first via column;
each of the second light-emission elements is electrically connected to the second pixel circuit by a second via, and a plurality of the second vias corresponding to a same column of the second circuit columns constitute a second via column; and
for one of the second circuit columns that does not comprise the dummy pixel circuits, in the second direction, the plurality of second light-emission elements electrically connected to the second pixel circuits by the second vias in a same column of the second via columns are located on two sides of the same second via column.

3. The display panel according to claim 2, wherein for a same first unit column of the first unit columns, in the second direction, the first vias are located on one side of the same first unit column, and the second vias are located on the other side of the same first unit column.

4. The display panel according to claim 2, wherein the first light-emission elements and the second light-emission elements are alternately arranged in the second direction to constitute first unit rows, and
for a same row of the first unit rows, in the second direction, a relative positional relationship between the first vias and the first light-emission elements is the same as the relative positional relationship between the second vias and the second light-emission elements.

5. The display panel according to claim 2, wherein an anode of the first light-emission element is electrically connected to a first end of the first via by a first connection line, a second end of the first via is electrically connected to the first pixel circuit, and the first connection line and the anode of the first light-emission element are located in a same film layer;
an anode of the second light-emission element is electrically connected to a first end of the second via by a second connection line, a second end of the second via is electrically connected to the second pixel circuit, and the second connection line and the anode of the second light-emission element are located in a same film layer; and
the display panel comprises at least two semiconductor layers.

6. The display panel according to claim 5, wherein a length of the first connection line is less than a maximum width of the first light-emission element in the second direction, and a length of the second connection line is less than a maximum width of the second light-emission element in the second direction.

7. The display panel according to claim 6, wherein for a same column of the first unit columns, the second unit columns, or the third unit columns, an extension direction of the first connection line intersects an extension direction of the second connection line.

8. The display panel according to claim 2, wherein
the display panel comprises a first connection line and a second connection line, the first connection line comprises a first segment and a second segment, the first segment is connected between an anode of the first light-emission element and a first end of the first via, the second segment is connected between a second end of the first via and the first pixel circuit, the first segment and the anode of the first light-emission element are located in a same film layer, and the second segment is located in a metal layer on a side of the anode of the first light-emission element facing toward a substrate;
the second connection line comprises a third segment and a fourth segment, the third segment is connected between an anode of the second light-emission element and a first end of the second via, the fourth segment is connected between a second end of the second via and the second pixel circuit, the third segment and the anode of the second light-emission element are located in a same film layer, and the fourth segment is located in a metal layer on a side of the anode of the second light-emission element facing toward the substrate; and
the display panel comprises a semiconductor layer.

9. The display panel according to claim 8, wherein the display panel comprises a data line, and in a thickness direction of the display panel, the film layer where the second segment and the fourth segment are located is located between a film layer where the data line is located and the anode of the light-emission element.

10. The display panel according to claim 2, wherein in a thickness direction of the display panel, the first circuit column overlaps at least a part of the first light-emission elements connected thereto, and the second circuit column overlaps at least a part of the second light-emission elements connected thereto.

11. The display panel according to claim 2, wherein in a thickness direction of the display panel, a part of the first unit columns at least partially overlap with the first data line and the third data line, the other part of the first unit columns at least partially overlap with the second data line and the third data line, and the second unit column does not overlap with the data line.

12. The display panel according to claim 1, wherein
a total number of the first circuit columns, the second circuit columns, and the third circuit columns in the display panel is equal to a total number of the first unit columns and the second unit columns;
adjacent two of the first unit columns constitute a first unit column group, and the display panel comprises a plurality of the first unit column groups; and
the first circuit column is electrically connected to a plurality of the first light-emission elements in a corresponding one of the first unit column groups, and the second circuit column is electrically connected to a plurality of the second light-emission elements in a corresponding one of the first unit column groups.

13. The display panel according to claim 12, wherein the first light-emission element is electrically connected to the first pixel circuit by a first via, and the second light-emission element is electrically connected to the second pixel circuit by a second via; and
in the first unit column group, in the second direction, the first via of one of the first unit columns is on a first side of the one of the first unit columns, the second via thereof is on a second side of the one of the first unit columns, and the first via and the second via of the other of the first unit columns are distributed on a same side of the other of the first unit columns.

14. The display panel according to claim 12, wherein the first light-emission element is electrically connected to the first pixel circuit by a first connection line, and at least a part of line segments of the first connection line are located in a different film layer from the first data line, the second data line, and the third data line of the display panel.

15. The display panel according to claim 14, wherein in a thickness direction of the display panel, at least a part of the line segments of the first connection line overlap with the second light-emission element.

16. The display panel according to claim 14, wherein in a thickness direction of the display panel, at least a part of the second light-emission elements overlap the second pixel circuits electrically connected thereto, and the display panel comprises at least two semiconductor layers.

17. The display panel according to claim 12, wherein
the first light-emission element is electrically connected to the first pixel circuit by a first connection line,
the second light-emission element is electrically connected to the second pixel circuit by a second connection line,
at least a part of line segments of the first connection line and at least a part of line segments of the second connection line are located in different film layers from the first data line, the second data line, and the third data line of the display panel, and
the display panel comprises a semiconductor layer.

18. The display panel according to claim 12, wherein
the first light-emission element is electrically connected to the first pixel circuit by a first via, and the second light-emission element is electrically connected to the second pixel circuit by a second via; and
in the second direction, the first via of the first unit column is on a first side of the first unit column, and the second via thereof is on a second side of the second unit column.

19. The display panel according to claim 18, wherein the first light-emission element is electrically connected to the first pixel circuit by a first connection line, the length of the first connection line connected between the first via and the first pixel circuit in the second direction is L1, a width of the pixel circuit of the display panel in the second direction is L2, and 3*L2 ≤ L1 ≤ 4*L2.

20. The display panel according to claim 12, wherein the first light-emission element is electrically connected to the first pixel circuit by a first via, and the second light-emission element is electrically connected to the second pixel circuit by a second via; and
in the second direction, the first via and the second via of any one of the first unit columns are distributed on a same side of the one of the first unit columns.

21. The display panel according to claim 20, wherein the first light-emission element is electrically connected to the first pixel circuit by a first connection line, the second light-emission element is electrically connected to the second pixel circuit by a second connection line, and the first connection line and the second connection line do not overlap.

22. The display panel according to claim 1, wherein
the third light-emission elements are electrically connected to the third pixel circuits by third vias, and
in the first direction, the third vias are all on a same side of the third light-emission elements connected thereto.

23. The display panel according to claim 1, wherein
an element unit comprises the first light-emission element, the second light-emission element, and the third light-emission element, which are adjacent to each other;
the first light-emission element is electrically connected to the first pixel circuit by a first via, the second light-emission element is electrically connected to the second pixel circuit by a second via, and the third light-emission element is electrically connected to the third pixel circuit by a third via; and
in the first direction, the first via, the second via, and the third via of the element unit are located on a same side of the element unit.

24. The display panel according to claim 23, wherein the first unit column and the second unit column that are adjacent constitute a second unit column group, and the second unit column group is each provided with three columns of pixel circuits.

25. The display panel according to claim 23, wherein
an anode of the second light-emission element is electrically connected to the second via by a second connection line, and
the second connection line is located between the first light-emission element and the third light-emission element in a direction parallel to a light-emission surface of the display panel.

26. The display panel according to claim 1, wherein each of the pixel circuits in the display panel comprises a drive transistor and a power line electrically connected to the drive transistor, and active layers of adjacent two of the drive transistors are not connected.

27. The display panel according to claim 1, wherein
the light-emission elements are electrically connected to the pixel circuits by vias, the vias comprise a first sub via, and the first sub via does not overlap with the pixel circuit electrically connected thereto; and
the display panel further comprises a connection line, one end of the connection line is connected to the first sub via, and the other end of the connection line is connected to the pixel circuit.

28. The display panel according to claim 27, wherein the display panel comprises a power branch line extending in the second direction, and the connection line and the power branch line are located in a same film layer.

29. The display panel according to claim 28, wherein the vias comprise a second sub via, and the second sub via at least partially overlaps with the pixel circuit electrically connected thereto; and
the display panel further comprises a compensation line, and one end of the compensation line is connected to the second sub via.

30. The display panel according to claim 29, wherein the other end of the compensation line is floating.

31. The display panel according to claim 29, wherein the compensation line and the connection line are in the same film layer.

32. The display panel according to claim 1, wherein
the display panel further comprises a power line comprising a first power line and a second power line,
the first power line is electrically connected to the first light-emission element, and the first power line comprises a first power branch line and a second power branch line electrically connected to each other,
the first power branch line extends in the first direction, and the second power branch line extends in the second direction;
the second power line is electrically connected to the second light-emission element, and the second power line comprises a third power branch line and a fourth power branch line electrically connected to each other, and
the third power branch line extends in the first direction, and the fourth power branch line extends in the second direction.

33. The display panel according to claim 32, wherein
the power line further comprises a third power line electrically connected to the third light-emission element,
the third power line comprises a fifth power branch line and a sixth power branch line electrically connected to each other, the fifth power branch line extends in the first direction, and the sixth power branch line extends in the second direction; and
one of the second power branch line and the fourth power branch line is electrically connected to the sixth power branch line, or the second power branch line, the fourth power branch line, and the sixth power branch line are independent of each other.

34. The display panel according to claim 33, wherein
either the first light-emission elements or the second light-emission elements are red light-emission elements, the others are blue light-emission elements, and the third light-emission elements are green light-emission elements;
the first power branch line, the fifth power branch line, the third power branch line, and the fifth power branch line constitute a first line group, and a plurality of the first line groups are arranged in the second direction.

35. The display panel according to claim 33, wherein
either the first light-emission elements or the third light-emission elements are red light-emission elements, the others are blue light-emission elements, and the second light-emission elements are green light-emission elements; and
the first power branch line, the third power branch line, and the fifth power branch line constitute a second line group, and a plurality of the second line groups are arranged in the second direction.

36. The display panel according to claim 33, wherein the pixel circuits of the display panel are arranged in n1 rows;
a total number of the second power branch line, the fourth power branch line, and the sixth power branch line is n2; and
n1=n2, or n1=2*n2, wherein n1 and n2 each are integers greater than 1.

37. The display panel according to claim 33, wherein
the first power line further comprises a seventh power branch line, the seventh power branch line extends in the first direction, and the seventh power branch line and the first power branch line are electrically connected and located in different film layers;
the second power line further comprises an eighth power branch line, the eighth power branch line extends in the first direction, and the eighth power branch line and the third power branch line are electrically connected and located in different film layers; and
the third power line further comprises a ninth power branch line, the ninth power branch line extends in the first direction, and the ninth power branch line and the fifth power branch line are electrically connected and located in different film layers.

38. The display panel according to claim 33, wherein
a first film layer of the display panel comprises the data lines of the display panel; the first power branch line, the third power branch line, and the fifth power branch line are located in the first film layer of the display panel;
the second power branch line, the fourth power branch line, and the sixth power branch line are located in a second film layer of the display panel; and
the first film layer and the second film layer each are a film layer on a side of a semiconductor layer of the display panel facing toward a light-emission surface.

39. The display panel according to claim 38, wherein
the display panel further comprises an auxiliary metal layer, and the auxiliary metal layer is located on a side of the semiconductor layer close to the substrate; and
the auxiliary metal layer comprises a first auxiliary line, a second auxiliary line, and a third auxiliary line disconnected from each other, the first auxiliary line is electrically connected to the first power line, the second auxiliary line is electrically connected to the second power line, and the third auxiliary line is electrically connected to the third power line.

40. The display panel according to claim 38, wherein
the display panel further comprises a crossover line, the crossover line is located in a display area and connected to the data line,
the crossover line comprises a first line segment and a second line segment electrically connected to each other, the first line segment extends in the first direction and is located in a same film layer as the first power branch line, and the second line segment extends in the second direction and is located in a different film layer from the second power branch line.

41. A display apparatus, comprising the display panel according to any one of claims 1-40.
